(19)

Europäisches
Patentamt
European
Patent Office
Office européen
des brevets

(11)  **EP 1 570 232 B1**

(12)  **EUROPEAN PATENT SPECIFICATION**

(45) Date of publication and mention
of the grant of the patent:
**02.11.2016  Bulletin 2016/44**

(21) Application number: **03796723.9**

(22) Date of filing: **05.12.2003**

(51) Int Cl.:
*G03F 7/20* ^(2006.01)   *G03F 9/00* ^(2006.01)

(86) International application number:
**PCT/US2003/038784**

(87) International publication number:
**WO 2004/053426 (24.06.2004 Gazette 2004/26)**

(54) **APPARATUS AND METHODS FOR DETECTING OVERLAY ERRORS USING SCATTEROMETRY**

VORRICHTUNGEN UND VERFAHREN ZUM ERKENNEN VON OVERLAY-FEHLERN DURCH
VERWENDUNG VON STREUMESSUNGEN

APPAREIL ET PROCEDES POUR DETECTER LES ERREURS DE SUPERPOSITION PAR
DIFFUSIOMETRIE

(84) Designated Contracting States:
**AT BE BG CH CY CZ DE DK EE ES FI FR GB GR
HU IE IT LI LU MC NL PT RO SE SI SK TR**

(30) Priority: **05.12.2002  US 431314 P
17.01.2003  US 440970 P
22.02.2003  US 449496 P
27.08.2003  US 498524 P
19.09.2003  US 504093 P**

(43) Date of publication of application:
**07.09.2005  Bulletin 2005/36**

(73) Proprietor: **KLA-Tencor Technologies
Corporation
Milpitas, CA 95035 (US)**

(72) Inventors:
  • **MIEHER, Walter, D.
Los Gatos, CA 95033 (US)**
  • **LEVY, Ady
Sunnyvale, CA 94087 (US)**
  • **GOLOVANEVSKY, Boris
Haifa (IL)**
  • **FRIEDMANN, Michael
Mountain View, CA 94041 (US)**
  • **SMITH, Ian
Los Gatos, CA 95030 (US)**
  • **ADEL, Michael
30900 Zichron Ya'akov (IL)**
  • **FABRIKANT, Anatoly
Fremont, CA 94539 (US)**
  • **BEVIS, Christopher, F.
Los Gatos, CA 95030 (US)**

  • **FIELDEN, John
Los Altos, CA 94024 (US)**
  • **BAREKET, Noah
Saratoga, CA 95070 (US)**
  • **GROSS, Ken
San Carlos, CA 94070 (US)**
  • **ZALICKI, Piotr
Sunnyvale, CA 94087 (US)**
  • **WACK, Dan
Los Altos, CA 92024 (US)**
  • **DECECCO, Paola
Foster City, California 96606 (US)**
  • **DZIURA, Thaddeus, G.
San Jose, CA 95132 (US)**

(74) Representative: **Keane, Paul Fachtna et al
FRKelly
27 Clyde Road
Dublin D04 F838 (IE)**

(56) References cited:
  WO-A-02/25723          WO-A2-02/08413
  WO-A2-02/065545        WO-A2-02/069390
  US-A- 4 757 207        US-A- 5 712 707
  US-A1- 2003 156 276    US-A1- 2003 223 630
  US-B1- 6 350 548

  • "PHASE-SENSITIVE OVERLAY ANALYSIS
SPECTROMETRY" IBM TECHNICAL
DISCLOSURE BULLETIN, IBM CORP. NEW
YORK, US, vol. 32, no. 10A, 1 March 1990
(1990-03-01), pages 170-174, XP002003938 ISSN:
0018-8689

**Description**

The present invention relates to determination of overlay between structures formed in single or multiple layers. More particularly, it relates to determining overlay based on diffraction of radiation interacting with such structures.

In various manufacturing and production environments, there is a need to control alignment between various layers of samples, or within particular layers of such samples. For example, in the semiconductor manufacturing industry, electronic devices may be produced by fabricating a series of layers on a substrate, some or all of the layers including various structures. The relative position of such structures both within particular layers and with respect to structures in other layers is relevant or even critical to the performance of completed electronic devices.

The relative position of structures within such a sample is sometimes called overlay. Various technology and processes for measuring overlay have been developed and employed with varying degrees of success. More recently, various efforts have been focused on utilizing radiation scatterometry as a basis for overlay metrology.

Certain existing approaches to determining overlay from scatterometry measurements concentrate on comparison of the measured spectra to calculated theoretical spectra based on model shape profiles, overlay, and film stack, and material optical properties (n, k dispersion curves), or comparison to a reference signal from a calibration wafer.

IBM Technical Disclosure Bulletin Vol. 32 No. 10A March 1990 , pages 170 - 174 discloses a method of measuring overlay between structures by spectrometrically analysing sets of superimposed gratings.

WO 02/25723-A2 describes a method for measuring the overlay in a multi-layer sample. The method involves detecting a diffraction efficiency from various diffraction gratings and comparing the resulting spectra to either simulated results or a set of reference gratings with graduated offsets to obtain a closest match and corresponding offset value.

Existing approaches have several associated disadvantages. For example, a relatively large number of parameters must be included in the profile, overlay, and film modelling to accurately determine the overlay. For example, in some approaches using simple trapezoidal models for both the upper and lower layer profiles, the minimum number of pattern parameters that must be included is seven, including overlay. If film thicknesses variation is included in the model, the number of parameters increases correspondingly. A large number of parameters could require increased processing resources, may introduce corresponding errors, and may delay the results, thereby possibly decreasing throughput and increasing inefficiencies and costs. For example, comparison of a measured spectrum to calculated reference spectra takes longer with more parameters, whether a library-based approach is used or a regression approach is used.

Another disadvantage of certain existing approaches to determination of overlay based on scatterometry is the detailed knowledge of the film stack, film materials, and pattern element profiles that may be required to determine accurate theoretical spectra to compare to the measured spectra.

Yet another disadvantage of certain existing approaches to determination of overlay based on scatterometry is the accurate knowledge of the scatterometry optical system that may be required to determine accurate theoretical spectra to compare to the measured spectra.

Therefore, in light of the deficiencies of existing approaches to determination of overlay based on scatterometry, there is a need for improved systems and methods for determination of overlay based on scatterometry.

Accordingly, mechanisms are provided for determining overlay error between two layers of a sample.

In a first aspect, the present invention provides a method for determining overlay between a plurality of first structures in a first layer of a sample and a plurality of second structures in a second layer of the sample, the method comprising: providing a plurality of targets A, B, C and D that each includes a portion of the first and second structures, wherein the portion of the second structure of target A has a predetermined offset Xa with respect to the portion of the first structure of target A, wherein the portion of the second structure of target B has a predetermined offset Xb with respect to the portion of the first structure of target B, wherein the portion of the second structure of target C has a predetermined offset Xc with respect to the portion of the first structure of target C, wherein the portion of the second structure of target D has a predetermined offset Xd with respect to the portion of the first structure of target D, wherein each of the predetermined offsets Xa, Xb, Xc and Xd is different from zero, Xa is in the opposite direction and differs from Xb, and Xc is in the opposite direction and differs from Xd; illuminating the targets A, B, C and D with electromagnetic radiation to obtain spectra $S_A$, $S_B$, $S_C$, and $S_D$ from targets A, B, C, and D, respectively; and determining any overlay error between the first structures and the second structures using only the obtained spectra $S_A$, $S_B$, $S_C$, and $S_D$ and the predetermined offsets Xa, Xb, Xc and Xd in a linear approximation technique.

In general, an error offset E may be determined by analyzing at least the measured spectra from four or more targets A, B, C, and D each having offsets between two patterned layers, such as offsets Xa through Xd. This analysis can be performed without comparing any of the spectra to a known or reference spectra. In other words, the error determination techniques of the present invention do not require a calibration operation.

Determining any overlay error can be accomplished by (i) determining a difference spectrum D1 from the spectra $S_A$ and $S_B$ (ii) determining a difference spectrum D2 from the spectra $S_c$ and $S_D$ (iii) and determining any overlay error by performing a linear approximation based on the difference spectra D1 and D2. In a further aspect, the linear approximation is based on a property P1 of the difference spectrum D1 and a property P2 of the difference spectrum D2.

Each of the targets A, B, C, and D can comprise a grating structure Gal having periodic structures with a period Tal disposed at least partially within the first layer and a grating structure Ga2 having periodic structures with a period Ta2 disposed at least partially within the second layer. The first period Tal and the second period Ta2 are substantially identical, and the offsets Xa, Xb, Xc, and Xd are each produced by offsetting the structures with the period Tal of the grating structure Gal with respect to the structures with the period Ta2 of the grating structure Ga2 by the sum of a first distance F and a second distance f0, wherein the second distance f0 has a smaller absolute value than the first distance F.

In a second aspect, the present invention provides a system for determining overlay between a plurality of first structures (204a-c) in a first layer of a sample and a plurality of second structures (202a-c) in a second layer of the sample, comprising: a scatterometry module; a processor; and a target arrangement comprising: a plurality of targets A, B, C and D that each include a portion of the first and second structures (202a-c); wherein the portion of the second structure of target A has a predetermined offset Xa with respect to the portion of the first structure of target A; wherein the portion of the second structure of target B has a predetermined offset Xb with respect to the portion of the first structure of target B; wherein the portion of the second structure of target C has a predetermined offset Xc with respect to the portion of the first structure of target C; wherein the portion of the second structure of target D has a predetermined offset Xd with respect to the portion of the first structure of target D; wherein each of the offsets Xa, Xb, Xc and Xd is different from zero, Xa is in the opposite direction and differs from Xb, and Xc is in the opposite direction and differs from Xd; wherein the scatterometry module is adapted to illuminate the plurality of targets A, B, C and D with electromagnetic radiation to obtain spectra $S_A$, $S_B$, $S_C$, and $S_D$ from targets A, B, C, and D, respectively; and wherein the processor is adapted to determine any overlay error between the first structures (204a-c) and the second structures (202a-c) using only the obtained spectra $S_A$, $S_B$, $S_C$, and $S_D$ and the predetermined offsets Xa, Xb, Xc and Xd in a linear approximation technique.

These and other features and advantages of the present invention will be presented in more detail in the following specification of the invention and the accompanying figures which illustrate by way of example the principles of the invention.

Fig.1 illustrates the relative distribution of designed overlay offsets Xa, Xb, Xc, and Xd for corresponding interlayer patterns (overlay targets) A, B, C, and D according to an embodiment of the present invention.

Fig. 2(a) is a side view illustration of a patterned top layer L2 being offset by an amount +F from a patterned bottom layer L1 in accordance with one embodiment of the present invention.

Fig. 2(b) is a side view illustration of a patterned top layer L2 being offset by an amount -F from a patterned bottom layer L1 in accordance with one embodiment of the present invention.

Fig. 2(c) is a side view illustration of a patterned top layer L2 being offset by an amount +F+f0 from a patterned bottom layer L1 in accordance with one embodiment of the present invention.

Fig. 2(d) is a side view illustration of a patterned top layer L2 being offset by an amount -F+f0 from a patterned bottom layer L1 in accordance with one embodiment of the present invention.

Fig. 2(e) is a side view illustration of a patterned top layer L2 being offset by an amount +F+f0+E from a patterned bottom layer L1 in accordance with one embodiment of the present invention.

Fig. 2(f) is a side view illustration of a patterned top layer L2 being offset by an amount -F+f0+E from a patterned bottom layer L1 in accordance with one embodiment of the present invention.

Fig. 3(a) is a flow diagram illustrating a procedure for determining overlay in accordance with one embodiment of the present invention.

Fig. 3(b) shows a graphical representation of an approach to determination of overlay according to an embodiment of the present invention.

Fig. 4 is a diagrammatic representation of a conventional microscopic imaging system.

Fig. 5(a) is diagrammatic representation of a microscopic imaging system having a numerical aperture (NA) optimized for scattering characteristics in accordance with a first embodiment of the present invention.

Fig. 5(b) is diagrammatic representation of a microscopic imaging system having a numerical aperture (NA) optimized for scattering characteristics in accordance with a second embodiment of the present invention.

Fig. 5(c) is diagrammatic representation of a microscopic imaging system having a numerical aperture (NA) optimized for scattering characteristics in accordance with a third embodiment of the present invention.

Fig. 5(d) is diagrammatic representation of a microscopic imaging system having a numerical aperture (NA) optimized for scattering characteristics in accordance with a fourth embodiment of the present invention.

Fig. 5(e) is a top view representation of an imaging spectrometer, multiple site field-of-view example in accordance with one embodiment of the present invention.

Figure 6 is a diagrammatic representation of a system for selecting one or more wavelength ranges in accordance with one embodiment of the present invention.

Figure 7 is a diagrammatic representation of a simultaneous, multiple angle of incidence ellipsometer.

Figure 8 is a schematic view of a spectroscopic scatterometer system in accordance with one embodiment of the present invention.

Figure 9(a) shows a plurality of targets placed substantially-collinearly along either an X-direction or a Y-direction in accordance with a first embodiment of the present invention.

Figure 9(b) shows four targets disposed collinearly along the X-dimension, and four targets disposed collinearly along the Y-dimension in accordance with a second embodiment of the present invention.

Figure 10 shows an example incidence line and field of view for use in a technique for scatterometric overlay determination using an incidence line in accordance with one embodiment of the present invention.

Figure 11a is a top view representation of a first combination imaging and scatterometry target embodiment.

Figure 11b is a top view representation of a second combination imaging and scatterometry target embodiment.

Figure 11c is a top view representation of a third combination imaging and scatterometry target embodiment.

Fig. 12 is a diagram of a combined mark, in accordance with one embodiment of the present invention.

Figs. 13A - 13D show variations of a combined metrology tool, in accordance with several embodiments of the present invention.

Fig. 14 is a flow diagram using a combined metrology tool, in accordance with one embodiment of the present invention.

Reference will now be made in detail to a specific embodiment of the invention. An example of this embodiment is illustrated in the accompanying drawings. While the invention will be described in conjunction with this specific embodiment, it will be understood that it is not intended to limit the invention to one embodiment. On the contrary, it is intended to cover alternatives, modifications, and equivalents as may be included within the scope of the invention as defined by the appended claims. In the following description, numerous specific details are set forth in order to provide a thorough understanding of the present invention. The present invention may be practiced without some or all of these specific details. In other instances, well known process operations have not been described in detail in order not to unnecessarily obscure the present invention.

An aspect of the present invention provides a set of four or more scatterometry overlay targets which have been formed on a sample, such as a semiconductor device. A pattern could also be described as a "pattern or interlayer pattern", with the two terms being synonymous under most circumstances. In a particular implementation, the sample has two or more layers of a semiconductor device, and the targets are utilized to provide a measure of the placement accuracy of various structures comprised in the device. In general, placement accuracy is characterized by measurement of an overlay error between two different layers of the semiconductor device.

In a specific embodiment, a set of four targets are provided, and each target includes two sets of structures on two different layers which are offset from each other. In a specific implementation, an offset may be defined as the sum or the difference of two separate distances: a first distance F and a second distance f0, with F being greater than f0. Denoting the four targets as "target A", "target B", "target C" and "target D", the corresponding predetermined offsets for each of these targets may be defined as follows for a specific target design:

$$Xa = +F+f0 \text{ (for target A)},$$

$$Xb = -F+f0 \text{ (for target B)},$$

$$Xc = +F-f0 \text{ (for target C)},$$

and

$$Xd = -F-f0 \text{ (for target D)}.$$

The offsets for Xa through Xd may be any suitable value for practicing the techniques of the present invention so as to determine overlay. For example, Xa and Xb may have different values of f0 than Xc and Xd.

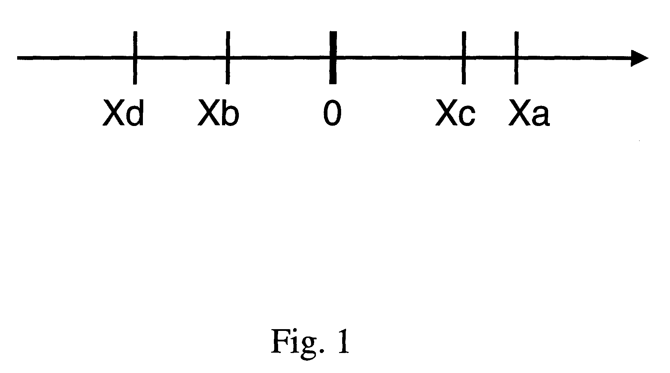

Fig. 1 illustrates the distribution of offsets Xa, Xb, Xc and Xd along the x axis in a particular implementation of the invention. As shown, offsets Xa and Xc are both positive with Xa being larger than Xc. In contrast, offsets Xb and Xd are both negative with Xd being more negative than Xb.

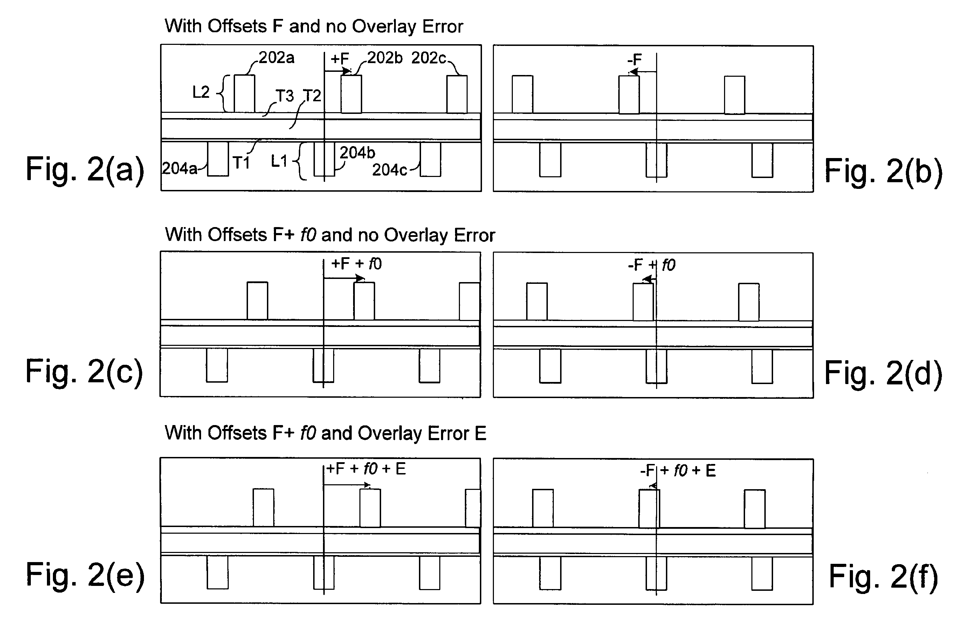

The number of targets and the magnitude and sense of their corresponding offsets may be chosen in any suitable manner so that the techniques of the present invention may be practiced to determine overlay error. A specific set of targets and their corresponding offsets are described below in relation to Figures 2(a) through 2(f). It should be readily apparent that there are numerous combinations of targets and offset values which may be utilized to practice the techniques and utilize the systems of the present invention.

Fig. 2(a) is a side view illustration of a patterned top layer L2 being offset by an amount F from a patterned bottom layer LI in accordance with one embodiment of the present invention. Each layer L1 and L2 is patterned into a set of structures. A structure may include any suitable feature, such as a line, trench or a contact. A structure may be designed to be similar to a semiconductor device feature. A structure may also be formed from a combination of different features. Further, a structure may be located on any layer of the sample, e. g., either above the top layer of the sample, within any layer of the sample, or partially or completely within a layer of the sample. In the illustrated embodiment of Fig. 2 (a), layer LI includes the complete structures 204a-c, while layer L2 includes the complete structures 202a-c. Construction of scatterometry overlay targets structures and methods for producing them are described in U. S. patent application, having application no. 09/833,084, filed 10 April 2001, entitled "PERIODIC PATTERNS AND TECHNIQUE TO CONTROL MISALIGNMENT", by Abdulhalim, et al.

As shown, the structures of the top layer L2 are offset by an amount F from the structures of the bottom layer L1. The structures of the two offset layers may be located within adjacent layers or have any suitable number and types of layers disposed in between the two offset layers. Fig. 2 (a) also shows three films T1, T2, and T3 between patterned layers L1 and L2 and their corresponding structures. To the extent that any other layers exist between the two layers having the structures, these other layers exhibit at least a minimum degree of transmission for electromagnetic radiation to permit propagation of the radiation between the layers having the structures.

Fig. 2(b) is a side view illustration of a patterned top layer L2 being offset by an amount -F from a patterned bottom layer L1 in accordance with one embodiment of the present invention. Fig. 2(c) is a side view illustration of a patterned top layer L2 being offset by an amount +F+f0 from a patterned bottom layer L1 in accordance with one embodiment of the present invention. Fig. 2(d) is a side view illustration of a patterned top layer L2 being offset by an amount -F+f0 from a patterned bottom layer L1 in accordance with one embodiment of the present invention. Fig. 2(e) is a side view illustration of a patterned top layer L2 being offset by an amount +F+f0+E from a patterned bottom layer L1 in accordance with one embodiment of the present invention. Fig. 2(f) is a side view illustration of a patterned top layer L2 being offset by an amount -F+f0+E from a patterned bottom layer L1 in accordance with one embodiment of the present invention.

In general, an error offset E may be determined by analyzing at least the measured spectra from four or more targets A, B, C, and D each having offsets between two patterned layers, such as offsets Xa through Xd. This analysis is performed without comparing any of the spectra to a known or reference spectra. In other words, the error determination techniques of the present invention do not require a calibration operation.

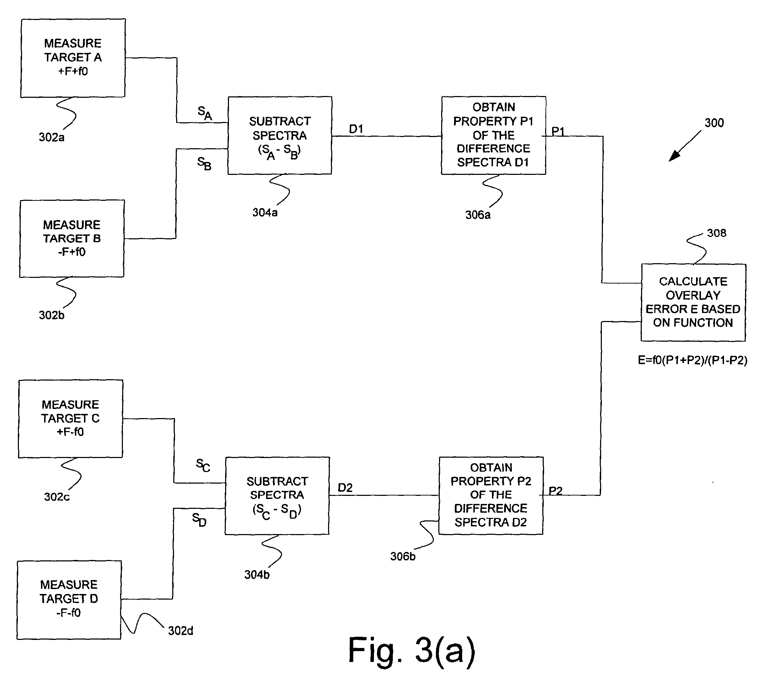

Fig. 3(a) is a flow diagram illustrating a procedure 300 for determining overlay in accordance with one embodiment of the present invention. In this example, four targets A, B, C, and D are used which are designed to have offsets Xa through Xd as described above. That is, target A is designed with offset +F+f0; target B with offset -F+f0; target C with offset +F-f0; and target D with offset -F-f0.

Initially, an incident radiation beam is directed towards each of the four targets A, B, C, and D to measure four spectra $S_A$, $S_B$, $S_C$, and $S_D$ from the four targets in operations 302a through 302d. Operations 302a through 302d may be carried out sequentially or simultaneously depending on the measurement system's capabilities. The incident beam may be any suitable form of electromagnetic radiation, such as laser or broadband radiation. Examples of optical systems and methods for measuring scatterometry signals to determine overlay may be found in (1) U. S. patent application, having Patent No. 09/849,622, filed 04 May 2001, entitled "METHOD AND SYSTEMS FOR LITHOGRAPHY PROCESS CONTROL", by Lakkapragada, Suresh, et al. and (2) U. S. patent application, having application no. 09/833,084, filed 10 April 2001, entitled "PERIODIC PATTERNS AND TECHNIQUE TO CONTROL MISALIGNMENT", by Abdulhalim, et al.

Further embodiments of suitable measurement systems and their use for determining overlay error are further described below. In various embodiments of the present invention, the spectra SA, SB, Sc, and So (and any additional spectra that may be present) could include any type of spectroscopic ellipsometry or reflectometry signals, including: tan $(\Psi)$, cos $(\Delta)$, Rs, Rp, R, $\alpha$ (spectroscopic ellipsometry "alpha" signal, $\beta$ (spectroscopic ellipsometry "beta" signal), ((Rs-Rp)/ (Rs+Rp)), etc.

Spectrum $S_B$ (-F+f0) is then subtracted from spectrum $S_A$ (+F+f0), and spectrum $S_D$ (-F-f0) is subtracted from spectrum $S_C$ (+F-f0) to form two difference spectra D1 and D2 in operations 304a and 304b, respectively. Next, a difference spectrum property PI is obtained from the difference spectra D1 and a difference spectrum property P2 is obtained from the difference spectrum D2 in operations 306a and 306b, respectively. The difference spectra properties PI and P2 are generally obtained from any suitable characteristic of the obtained difference spectra D1 and D2. The difference spectra properties P1 and P2 may also each simply be a point on the each difference spectra D1 or D2 at a particular wavelength. By way of other examples, difference spectra properties PI and P2 may be the result of an integration of averaging of the difference signal, equal the an average of the SE alpha signal, equal a weighted average which accounts for instrument sensitivity, noise or signal sensitivity to overlay.

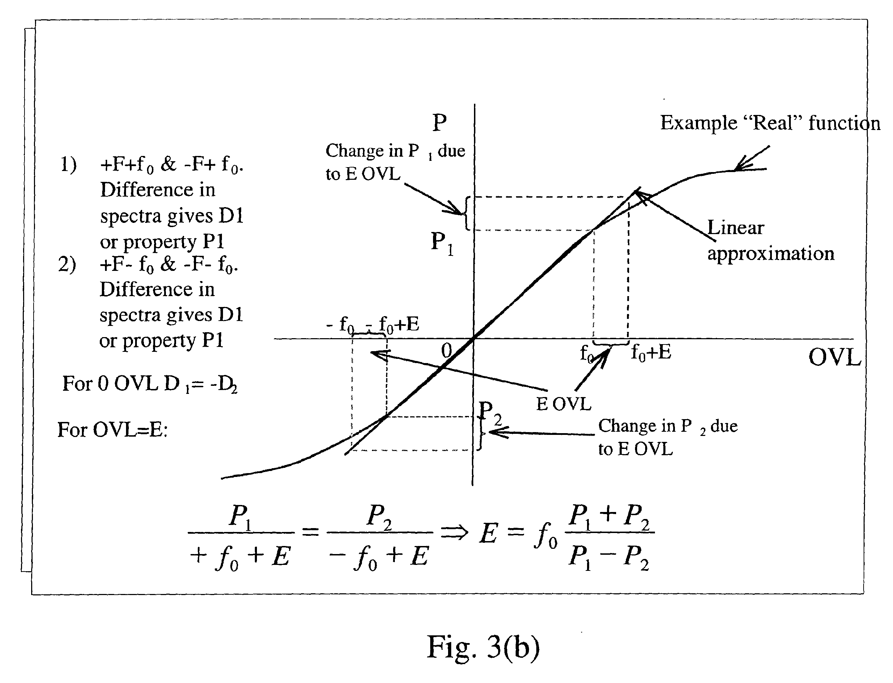

After difference spectra properties PI and P2 are obtained, the overlay error E may then be calculated directly from the difference spectra properties PI and P2 in operation 308. In one embodiment, a linear approximation is performed based on the difference spectra properties PI and P2 to determine the overlay error E, while in another technique not forming part of the invention the difference spectra properties PI and P2 are used to approximate a sine wave function or other periodic function which is then used to determine the overlay error E. One linear regression technique is illustrated below with respect to Fig. 3(b). In one example, the overlay result may be obtained by a statistical calculation (e.g. averaging or weighted averaging) of overlay results obtained from properties of multiple wavelengths or multiple wavelength ranges.

In a variation of this implementation, if all four targets have the same characteristics, such as pitch P, thin film characteristics, structure size and composition, except for the offsets, and assuming that Xa and Xb are opposite in sign and have the same order of magnitude (0.1<Xa/Xb<10), and if 0.05<|Xa/P|<0.45 and 0.05<|Xb/P|<0.45, and if Xa is the same sign as Xc and Xb is the same sign as Xd, an estimate of the overlay error E present between structures within the interlayer targets can be calculated as follows using a linear approximation based on the difference spectra properties P1 and P2:

$$E' = ((S_C - S_D)*(Xa + Xb)/2 + (S_A - S_B)*(Xc + Xd)/2)/((S_A - S_B) - (S_C - S_D))$$

or

$$E' = (P2*(Xa + Xb)/2 + P1(Xc + Xd)/2) / (P1 - P2)$$

where the difference spectra properties P1 and P2 are generally opposite in sign for overlay errors E<f0. If(Xa-Xb) = (Xc-Xd) and E=0, then P1= -1*P2.

Alternatively, if the same values for F and f0 are used for designing each target offset Xa, Xb, Xc, and Xd, then

$$E' = (f0*P2 + f0*P1)/(P1 - P2).$$

The targets may be used to determine overlay of structures located at least partially in more than one layer, but could also be used to determine overlay of structures located substantially in a single layer.

Fig. 3(b) shows a graphical representation of the linear approach for determining the overlay error E in accordance with one embodiment of the present invention. As shown, the positive portion of the y axis shows a change in the difference spectra property P1 as a function of f0+E and the negative portion of the y axis shows a change in the difference spectra as a function of -f0+E. As described above, the difference spectra properties P1 and P2 are obtained from the difference spectra D1 and D2.

The overlay error E may be obtained by analyzing the two points (+f0+E, P1) and (-f0+E, P2). The overlay error E may be determined in one approach by performing a linear approximation with the two obtained difference spectra properties P1 and P2. Note that there are two points on the graph where E is zero, while other portions of the graph are a function of the overlay error E and f0. If the offsets are chosen carefully so as to be in the linear region, then the slope of the positive portion of the graph (P1/(+f0+E)) should equal the slope of the negative portion of the graph (P2/(-f0+E)). Thus, the overlay error is given by E=fD*(P1+P2)/(P1-P2).

According to an implementation of the invention, if there are two targets with offsets +F and -F that are equal in magnitude but opposite in sign and no other overlay errors, then the 0th diffraction order scatterometry SE or reflectometry spectra are substantially identical from these two targets (to a good approximation) and the difference signal between the spectra corresponding to +F and -F is zero. Of course, any property of the difference signal is also zero. If one deliberately breaks the symmetry (artificially induces an overlay error) by designing an additional offset +f0, then the difference signal D1 is no longer zero and any suitable difference spectra property follows the same relationship as for an overlay error E. Similarly one can design another set of overlay targets with an additional offset -f0. Thus, the overlay error may be determined using a property of the difference signals D1 (+F+f0, -F+f0) and D2 (+F-f0, -F-f0), and accordingly no separate calibration step is required.

It should be understood that when the overlay error E is calculated from the spectra signals, it may be an estimate of actual overlay error. The calculated overlay error E may be denoted as the overlay error (E), or an estimate of the overlay error (E').

If the pitch between structures is relatively large then the above described linear approximation techniques generally work well. However, when the pitch is relatively small then additional targets may be produced on the sample to improve the accuracy of the overlay measurements. The number of targets and corresponding scatterometry techniques which are used depend on the particular materials of the target and the scatterometry signal type implemented, among other factors. Whether to use four or more targets can be determined experimentally or by well known modeling methods. In one embodiment, two additional interlayer targets (denoted targets "H" and "J") are produced on the sample, with corresponding offsets Xh and Xj. Upon being illuminated by incident radiation, the targets H and J produce corresponding diffracted components, which can serve as a basis for determination of an additional difference signal D3 and difference spectra property P3. This property P3 may be analyzed in connection with the difference spectra properties P1 and P2 to refine the determination of the overlay E to include non-linear corrections or measurements of the errors introduced by using a linear approximation.

One alternative embodiment to the linear approximation methods discussed above is to treat the scatterometry overlay signal as a periodic function and use phase detection methods to determine the overlay error. This embodiment may be preferred in some circumstances, depending on variables that may include scatterometry overlay target pitch, scatterometry overlay target design, scatterometry overlay (SCOL) target materials, the measured scatterometry signal, and the like.

The overlay error may be extracted from measuring multiple SCOL targets with pre-programmed additional built-in overlay offsets. (One example of the preprogrammed offsets could be Xa, Xb, Xc, and Xd as discussed above and in Figure 1). The number of targets measured may be two, three, four, or more than four, or may vary between different overlay measurement locations. A scatterometry signal (as a function of the wavelength or incident angle, for example) is acquired from the required SCOL targets. For every arbitrary overlay, this signal is a periodic and even function of overlay error. A phase detection (or phase retrieval, phase extraction, or phase determination) algorithm utilizes these properties of the signals. The measured signal is represented by a set of even periodic functions with a corresponding number of free parameters (one of these free parameters is the overlay error itself). Different sets of such functions may be used, depending, for example, on the number of targets measured, scatterometry signal properties, target properties, and information required. The number of targets measured is to be greater or equal to the cumulative number of free unknown parameters. When several (two or more) scatterometry overlay (SCOL) targets (with different pre-programmed offsets) are placed in the immediate vicinity of each other (within 250 microns, for example), the overlay error may be assumed to be the same for all these targets. Each of the other free parameters can either vary or not vary from one SCOL target location to the other one (within the field and/or across the wafer). (Overlay is assumed to vary between different overlay measurement locations). Alternatively, these free parameters (or some of them) may either vary or not vary between X- and Y- SCOL target orientations. Based on the information required, the measurement accuracy required and on whether some free parameters are not varying location-to-location and/or between X- and Y-orientations, the total number of SCOL targets per overlay measurement location and total number of SCOL targets to be measured per field and/or per wafer is determined.

An example of a phase algorithm approach to determining overlay error from scatterometry signals from multiple targets is to treat the dependence of the scatterometry signals on overlay error as a periodic function. In this case the programmed offsets of the multiple targets are treated as initial phase offsets and the overlay error is treated as an additional phase. The overlay error can then be determined using well-known phase determination or phase retrieval methods. Well known phase retrieval methods that may include quadrature, 3-bucket, and 4-bucket phase retrieval algorithms can be used to determine overlay error. These phase retrieval methods are listed as examples only and are not meant to limit the scope of the invention. Phase detection methods are well known and are commonly used in diverse areas such as communications, interferometry, nuclear magnetic resonance, electronic circuits, to list a few examples. In another embodiment, a combination of linear, non-linear, and phase retrieval algorithms may be employed to determine the overlay error.

Certain conditions are preferably met with implementation of the above described techniques. The measurement areas are substantially identical in all aspects except for the offsets, *e.g.,* +F+f0, -F+f0, +F-f0, and -F-f0. This is likely accomplished by placing the targets within about 100 microns or less of each other and by choosing targets which are relatively-robust to the process (i.e. they have similar or less sensitivity to process variation as the device features). In practice, on production wafers, the profiles may deviate from identical for different offsets if the topography from the lower pattern layer(s) and the upper layer changes in response to interacting with this topography. A difference or error signal between the two targets with different offsets is relatively independent of profile variation of the overlay target segments and to film variation as long as the profiles are common to the different targets. This is the substantial equivalent of common mode rejection of the parts of the signal that are determined by the profile and the films and the optics. The technique is also preferably robust to the range of process variation encountered in a typical manufacturing process. The signal differences due to the overlay error are also preferably larger than the signal differences due to other sources of process variation between the nearby scatterometry overlay targets (including mask errors).

If in a particular implementation the targets include structures grouped to exhibit the characteristics of lines, then a separate set of targets may be required for X and Y overlay measurements. If the overlay targets are composed of 2-dimensional structures (as seen from a top down view), then it may be possible to use one set of targets to get both X and Y overlay information. For oblique scatterometry, according to a specific implementation, it may be advantageous to rotate the orientation of the wafer with respect to the optical scattering plane to measure the different X and Y overlay errors. For true normal incidence, it may be possible to get both X and Y overlay information from the different polarizations without rotating the wafer or the optics.

Cartesian coordinates provide a convenient frame of reference for measuring overlay within a sample, with the x-y plane being located within, or substantially parallel with, a layer of the sample, and with the z axis being substantially perpendicular to the layers of the sample. The Cartesian coordinate system could be fixed with respect to the sample or could be rotated to reduce the complexity of the measurements. For example, overlay occurring diagonally across the sample but within a single layer could be described as two-dimensional x-y overlay in a Cartesian system with the x-y axes substantially parallel with the sides of a rectangular sample. That same diagonal overlay could be measured along a single axis, however, by rotating the x-y axes such that the x axis is parallel with the direction of the diagonal overlay. Three dimensional overlay could be reduced to two-dimensional overlay by restricting measurements within an x-y plane substantially parallel with a layer and ignoring any interlayer overlay occurring in the z direction.

In one embodiment, targets include more than one predefined offset, possibly between different sets of structures located in two layers, or possibly between different sets of structures located in more than two layers. In a general case, a target may include an indefinite number of layers, with all or some of these layers having structures producing predefined offsets. In a particular implementation, the structures in one or more underlying patterned layers of a target cause changes in the shape or topography of one or more upper layers (disposed above the underlying patterned layer(s)). In this implementation, the one or more upper layers may be substantially or partially opaque or absorbing, and at least part of the diffraction signal may arise from the topography of an upper layer, the topography arising at least in part from the underlying patterned layer.

According to one embodiment, structures included in a target may be organized in various configurations and shapes, including, for example, lines, grids, rectangles, squares, curved lines, curved shapes, or combinations of the foregoing. Such configurations of structures may be disposed at various locations within the target, and may describe various angles with respect to the electromagnetic radiation incident on the target. For example, the sets of structures could be organized as a set of parallel lines perpendicular to the direction of propagation of a collimated set of radiation rays or of a beam incident on the target. In another case, the structures organized as a set of parallel lines could be disposed at an acute angle with respect to the incident radiation, possibly at an angle of 45 degrees. Such a configuration could be advantageous by facilitating determination of overlay in both x and y directions, thereby reducing the need for additional overlay patterns or measurements.

1. Scatterometry System Embodiments and Use of Same

Several of the techniques of the present invention may be implemented using any suitable combination of software and/or hardware system. For example, the techniques may be implemented within an overlay metrology tool. Preferably, such metrology tool is integrated with a computer system which implements many of the operations of this invention. Such composite system preferably includes at least a scatterometry module for obtaining scatterometry signals of the overlay targets, and a processor configured to analyze the obtained scatterometry signals to thereby determine overlay error within such targets. At a minimum, the scatterometry module will usually include (i) a source of illumination oriented to direct radiation onto a specified location of the sample; and (ii) one or more detectors oriented to detect a scatterometry signal which has been scattered by the sample.

At least a portion of the techniques of the present invention may also be implemented in an overlay metrology system as an additional overlay measurement capability which complements an overlay measurement system or sub-system based on image analysis such as one used for conventional box-in-box or frame-in-frame overlay targets or other imaging type overlay measurement structures. Examples of apparatus which combine imaging-based overlay metrology and scatterometry-based overlay are described in the above referenced Provisional Application No. 60/498,524. Overlay data from imaging overlay measurements and scatterometry overlay measurements may be combined for various uses including: calculating the overlay correctables, calculating other overlay corrections, calculating overlay errors at other locations on the wafer. More use cases for combinations of imaging overlay metrology and scatterometry overlay metrology are also described in above referenced Provisional Application No. 60/498,524.

Regardless of the system's configuration, it may employ one or more memories or memory modules configured to store data, program instructions for the general-purpose inspection operations and/or the inventive techniques described herein. The program instructions may control the operation of an operating system and/or one or more applications. The memory or memories may also be configured to store scatterometry data obtained from the targets and overlay error results and optionally other overlay measurement data.

Because such information and program instructions may be employed to implement the systems/methods described herein, embodiments of the present invention relates to machine readable media that include program instructions, state information, etc. for performing various operations described herein. Examples of machine-readable media include, but are not limited to, magnetic media such as hard disks, floppy disks, and magnetic tape; optical media such as CD-ROM disks; magneto-optical media such as floptical disks; and hardware devices that are specially configured to store and perform program instructions, such as read-only memory devices (ROM) and random access memory (RAM). The invention may also be embodied in a carrier wave traveling over an appropriate medium such as airwaves, optical lines, electric lines, etc. Examples of program instructions include both machine code, such as produced by a compiler, and files containing higher level code that may be executed by the computer using an interpreter.

Several of the system embodiments described below are mainly described and illustrated with respect to a scatterometry module or components for obtaining spectra from four or more targets, while the processor and memory are not shown.

Imaging Metrolog Systems in Which the Numerical Aperture is Optimized for Measurement of Scattering Structures

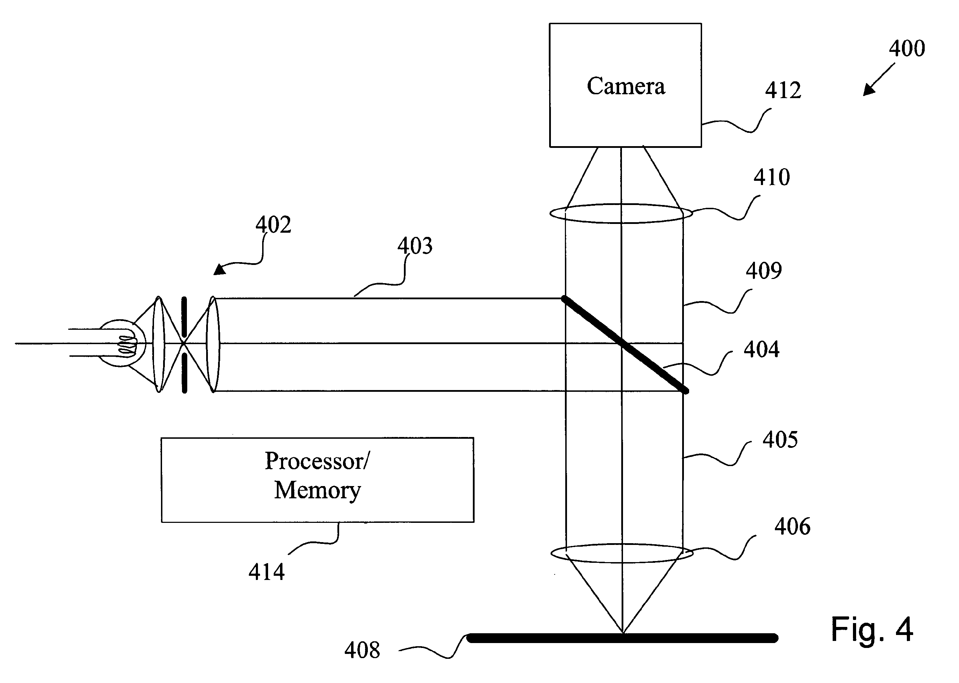

Fig. 4 is a diagrammatic representation of a microscopic imaging system. As shown, the imaging system 400 includes a beam generator 402 for producing an incident beam 403 of electromagnetic radiation, a beam splitter 404 for directing the incident beam 405 towards the sample 408. Typically, the incident beam is focused onto the sample by an objective lens 406. An output beam 409 is then emitted from the sample in response to the incident beam and passed through the beam splitter 404 through relay lens 410 onto imager or camera 412. The camera 412 generates an image of the sample based on the output beam 409.

The system 400 also includes a processor and one or more memory 414 which are configured to control the various components, such as the beam generator 402, objective lens 406, and cameral 412. The processor and memory are also configured to analyze the detected output beam or image implementing the various scatterometry techniques described above.

Traditionally, such imaging systems (such as those used for overlay) have selected numerical apertures (NA's) *(e.g.,* via objective lens 406) to optimize image resolution and to minimize optical aberrations. Selection of NA is typically performed in order to derive the overlay information from the variation in intensity over a single target (such as a box-in-box target) from the geometrical properties of the image.

Conventional imaging systems have relied upon high numerical apertures (NA's), such as 0.7 to 0.9, but doing so results in an expensive optical system which is sensitive to vibration, depth of focus, and optical aberrations. These issues reduce the achievable precision and cause a measurement error referred to as "tool induced shift" or TIS.

Scatterometry systems may take measurements at multiple sites sequentially in order to measure both x and y overlay and to eliminate effects due to variations in other sample parameters, such as film thickness. This type of measurement process results in significantly slower operation of the scatterometry tool relative to conventional overlay techniques.

In one embodiment of the present invention, the illumination and imaging NA's of an imaging optical system are chosen to optimize the performance of the instrument on scattering structures by ensuring that only the zero'th diffraction order is collected. One may take advantage of the fact that there exist performance advantages for certain metrology or inspection tasks pertaining to periodic structures when only the zero order diffraction is collected by the detection system. Under this condition, only the specular reflection is collected. Since the output which is scattered out of the specular is not collected and the nonspecular output may be more sensitive to aberrations, collection of only the specular output tends to minimize effects caused by optics aberrations. This condition also will result in a tool which will be optimized for relative photometric measurements of multiple sites in the field of view as described further below. Very low TIS may also be achieved, as compared to conventional imaging systems. Much higher throughput may also be achieved than with conventional scatterometry systems.

Choosing the illumination and imaging NA's for a particular imaging system is based on the particular configuration of such system. If we now consider the simplest imaging system in which the numerical aperture NA of illumination and collection are the same and the incident beam in normal to the sample surface, then the condition of "zero order diffraction only" can be met if:

$$n\lambda > 2d\text{NA} \text{, where } n = 1.$$

where n =1. where d is the pitch of the structures of the targets being imaged. This can be restated in terms of the numerical apertures of illumination $NA_i$ and collection $NA_c$ of the imaging system as:

$$n\lambda = d(NA_i + NA_c)$$

This equation indicates that if we are able to constrain the numerical aperture of the illumination system, we can relax the constraint on the numerical aperture of the collection optics, which may be advantageous under certain conditions. Thus, the spectral range may be restricted to wavelengths greater than twice the product of the pitch and the NA. Under realistic conditions the scattered radiation beam will be wider (more divergent) than the illumination beam. Under realistic circumstances however, infinitely periodic gratings are not imaged and so the above equations become approximations and the diffracted plane waves become somewhat divergent. So it may be preferable to include a margin of safety in the constraint and require that:

$$n\lambda \geq 2dNA(1 + \varepsilon)\,, \text{ where } n = 1 \text{ and } \varepsilon \text{ is small, typically less than } 0.5.$$

where $n = 1$ and $\varepsilon$ is small, typically less than 0.5.

As an example, for an NA 0.4 imaging system, wavelengths may be restricted to values greater than 0.8 times the largest pitch, which does not seem to be an unreasonable constraint. For periodic structures having features of design rule 70 nm and below, the densest structures with pitches as low as 200 nm does not constrain the spectral range of imaging systems with operating wavelengths equal to about 200 nm or longer, while more isolated features with pitches as large as 500 nm are preferably measured with wavelengths longer than 400 nm.

It is preferable to account for these constraints when designing an imaging spectrometer for metrology and inspection applications. A limit on the spatial resolution of the imaging system is the numerical aperture of the system. It is advantageous to achieve the highest spatial resolution so as to be able to shrink to a minimum the size of metrology structures and conserve valuable wafer real estate. Restated, this allows minimization of proximity effects or "crosstalk" between adjacent features in the field of view of the imaging spectrometer. Therefore, the highest possible NA is achieved while meeting the constraint that the zero order diffraction is collected by the detection system.

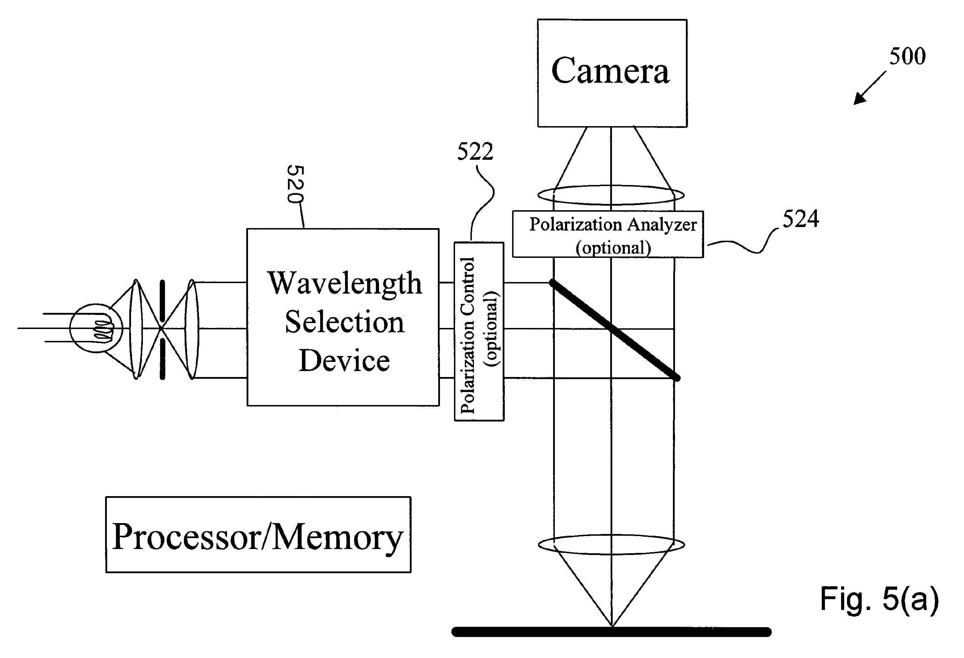

Another interesting outcome of this constraint is that the highest possible overlay spatial resolution may be achieved without ever resolving the features under test. This may have further advantages as it should ensure that problematic aliasing phenomena are avoided in the imaging system. In a preferred embodiment, an architecture is provided in which the spectral band pass can be easily modified or selected by the measurement system or algorithm based on the largest pitch in the feature under test (e.g., as the systems in Figures 5A through 5D described further below). Alternatively, the NA of either illumination or collection could be easily modified, depending on the largest pitch in the feature under test. Alternatively, all of these embodiments may be implemented within a single system.

Figs. 5A through 5E illustrate four embodiments of microscopic imaging systems having a numerical aperture (NA) optimized for scattering characteristics. As shown in Figure 5A, the system 500 may have components which operate like the same named components of the system in Figure 4. The system 500 further includes a wavelength selection device 520 for selecting a particular wavelength. The wavelength selection device 520 allows modification of the spectral band by selectively transmitting or selectively reflecting part or portions of the illuminating radiation. A wide variety of well known spectroscopic filtering techniques may be employed to modify the spectra band, including selecting from a set of band pass interference filters, continuously varying bandpass interference filters, grating based spectrometers, Fourier transform interferometers, acousto-optic tunable filters, to name a few. The wavelength selection device 520 is positioned within the incident beam path between the beam. The system 500 may also include a polarizer control device 522 for causing the incident beam to be in a particular polarization state and a polarization analyzer 524 for analyzing or separating out the polar components of the collected beam.

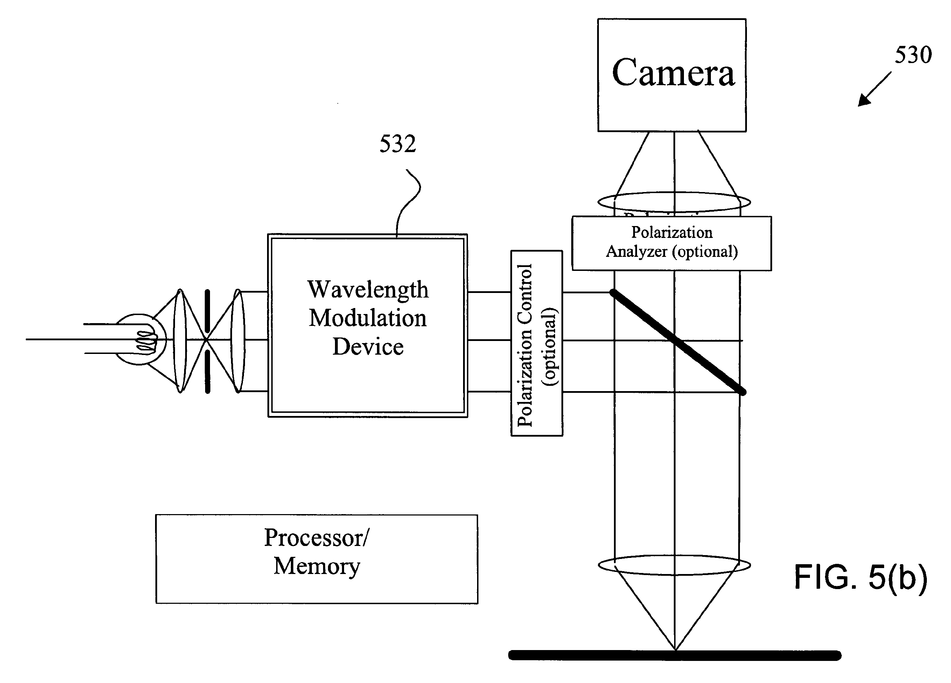

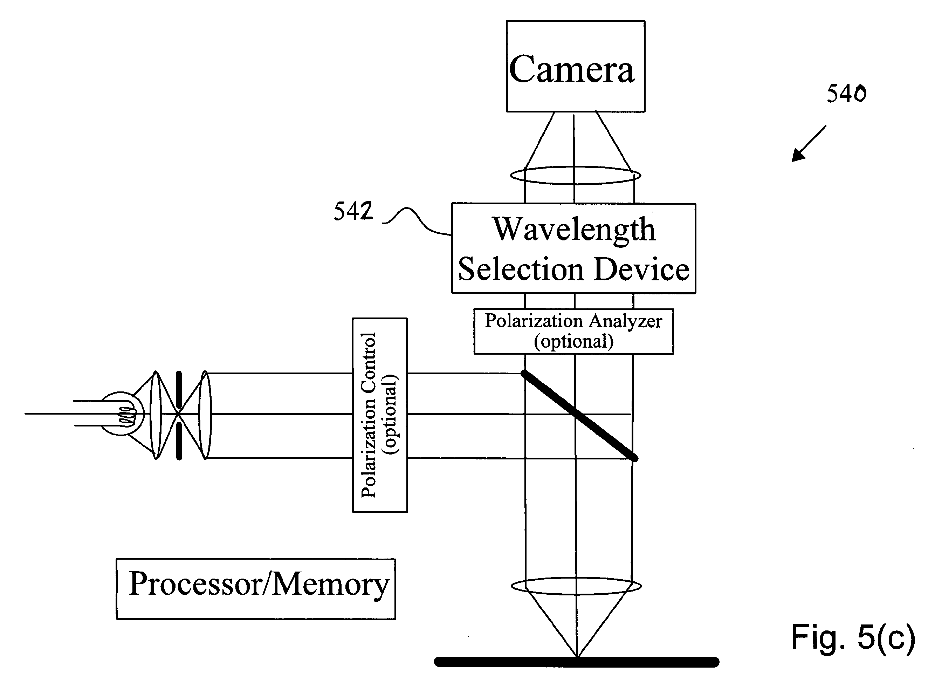

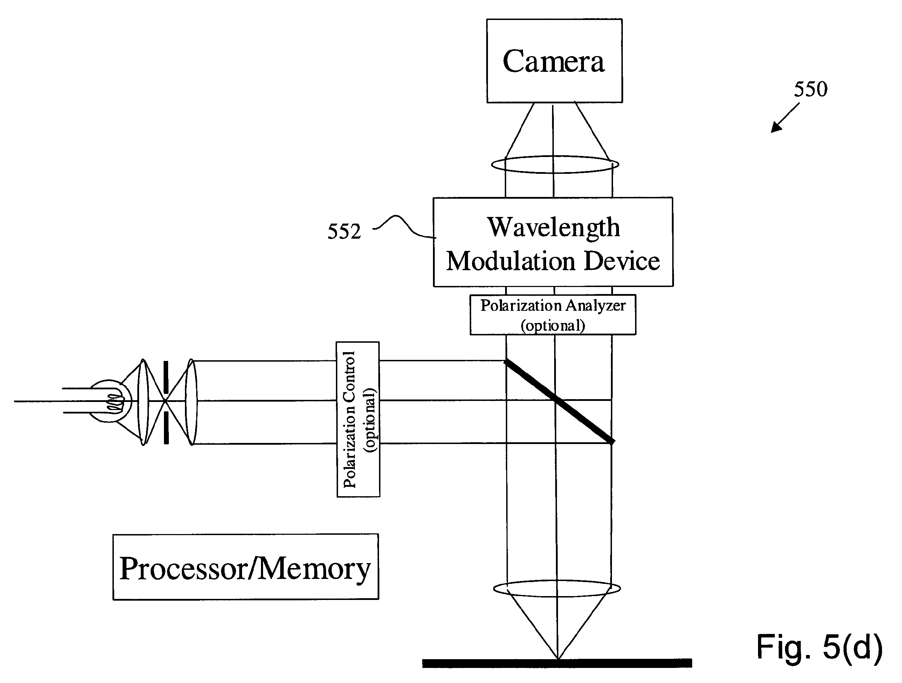

The system 530 of Figure 5B is similar to the system 500 of Figure 5A, except a wavelength modulation device 532 is used in place of a wavelength selection device. The system 540 of Figure 5C is similar to the system 500 of Figure 5A, except the wavelength selection device 542 is positioned in the output beam path. The system 550 of Figure 5D is similar to the system 500 of Figure 5C, except a wavelength modulation device 532 is used in place of a wavelength selection device. The wavelength modulation device 532 can be controlled by changing one or more optical path lengths in the wavelength modulation device 532 itself (e.g., an interferometric system, such as in a Michelson, Fabry-Perot, or Sagnac interferometers). The spectral information may be derived from the resulting signal with a transform analysis like a Fourier transform or Hadamard transform, for example.

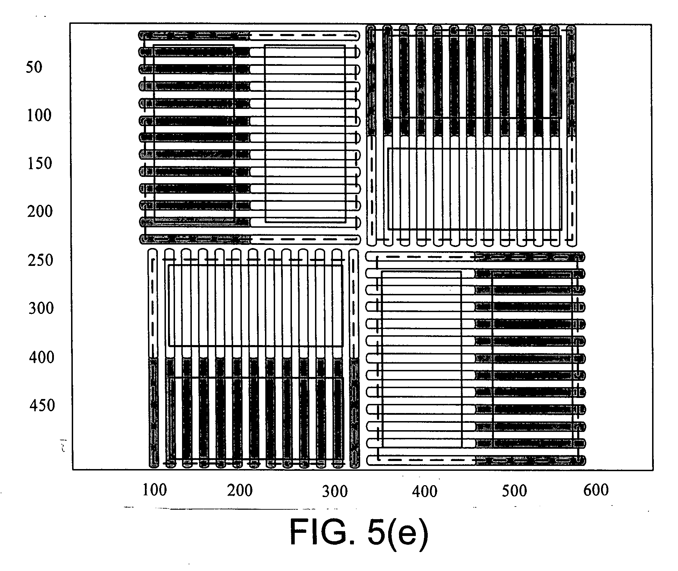

Figure 5E is a top view representation of an imaging spectrometer, multiple site field-of-view example in accordance with one embodiment of the present invention. In one implementation, spectra from pixels in each dotted box are averaged to create a spectrum for each of the four measurement targets. Alternatively, spectra from pixels located only in a central region of each dotted box are averaged together. Size and spacing of lines in the illustrated targets are exaggerated for emphasis.

The NA may be selected to ensure that only the zero'th diffraction order is collected in any suitable manner. In one proposed operational embodiment:

1. Two or more sites of differing characteristics are located in the field of view of the imaging system.
2. Images are captured over one or more spectral ranges.
3. For each measurement site in the field of view, all or some of the pixels determined to be within that site are summed or otherwise combined to characterize the photometric properties of that site in that spectral range.
4. Step 3 is repeated for each spectral range.
5. The results for each site over each spectral range are processed to determine the properties of the sample. For example, the above described spectral analysis techniques (*i.e.,* F+f0) are used on the obtained spectra for each target.
6. Steps 1 though 5 are repeated for the plurality of measurement sites desired across the wafer.

While this example technique describes sequentially capturing images over different spectral regions, this could be accomplished simultaneously using a system of wavelength dependent beam splitters, filters, and/or mirrors. Alternatively, the same could be affected by using a device such as a Sagnac interferometer which captures multiple images at different optical path differences, these being used to derive information equivalent to images taken over different spectral ranges.

Scatterometric Overlay Using Filters

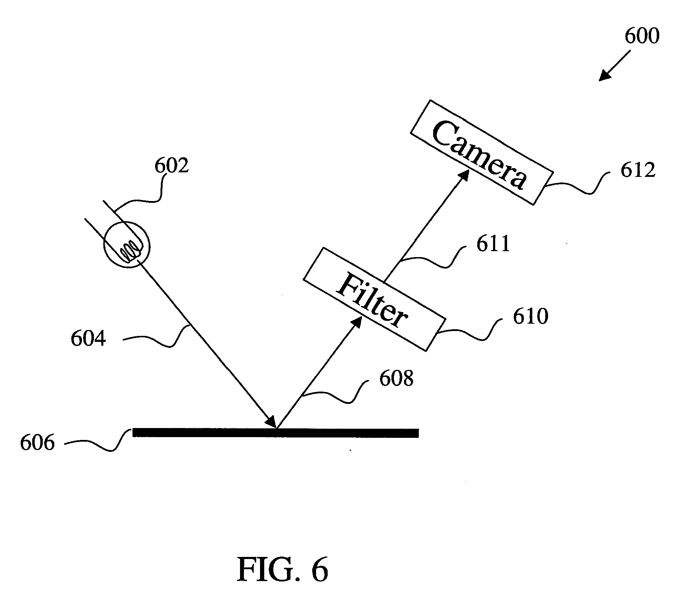

Conventional imaging overlay tools have a high magnification and small field of view. Inspection for gross patterning defects is either done manually on a microscope or automatically on a separate macro inspection tool. A low magnification overlay tool unfortunately requires multiple steps or tools, some of which are manual.
In one embodiment, a low magnification microscope with a mechanism for selecting one or more wavelength ranges is provided. This tool also preferably uses one or more broadband sources with filters, with multiple sources covering different wavelength ranges, variable filters, etc. Figure 6 is a diagrammatic representation of a system 600 for selecting one or more wavelength ranges in accordance with one embodiment of the present invention. As shown, the system 600 includes a broadband source 602 for generating a multiple wavelength incident light beam 604 towards sample 606. A multiple wavelength output beam 608 is scattered from the sample 606 in response to the incident beam 604. The system 600 also includes a filter 610 for selectively passing a portion of the output beam 611 based on wavelength to camera 612. In one implementation, the filter is configurable to pass particular colors, such as red, green, blue, or yellow. The camera is operable to generate an image based on the filtered output beam 611.
Measurements of overlay are taken by moving to a location on the sample where one or more of the targets in a target set are in the field of view of the microscope. An image is acquired and the intensity from some or all of the pixels in the image, which includes each individual target, are averaged or summed to give an intensity value for the target at a particular setting of the filter. In one embodiment, the filter is adjusted so as to give a maximum difference between targets. This may subsequently be normalized with respect to a reference surface, to the number of pixels summed, or corrected by a map of the illumination uniformity within the field of view. The sample or optics may then be moved until all of the necessary targets in a target set are measured. The overlay value is then determined using the intensity values thus determined, as described above, *e.g.*, by:

$$P1 = (\ Ia - Ib\ ) \quad \text{and } P2 = (\ Ic - Id\ )$$

And:

$$\text{Overlay} = f0 * (\ P2 + P1\ ) / (\ P2 - P1\ )$$

This process could be repeated over multiple wavelength ranges to improve accuracy, precision, and robustness, wherein the wavelengths which result in the best contrast are used for the scatterometry analysis.
Because the magnification is low and the field of view is large compared to a typical imaging overlay tool and because an image of the area of the sample is colleted, unlike a conventional reflectometer or ellipsometer, analysis of the image may be used to detect other types of processing problems by analyzing the image. For example, if the wrong reticle has been used for one or more processing steps, the image would be materially different. If the resist thickness were incorrect, the brightness or contrast of the image may be effected. If resist streaking were present, variation of brightness or contrast over the image may be detected. In CMP (chemical mechanical polishing) processes, processing errors such as over-polish, under-polish, etc. could be similarly detected.
In this embodiment, multiple scatterometry targets can be measured simultaneously, increasing the measurement speed. Additionally, processing errors or changes in processing conditions other than overlay can be detected without the need for a separate inspection tool.

Multi-Angle, Simultaneous Scatterometry

Techniques of obtaining scatterometric measurements may include the 2-theta approach, in which scattering intensity from a grating or other repeating structure is measured at a plurality of angles by making multiple, sequential measurements. Another technique of making scatterometric measurements is spectroscopic scatterometry. Use of the 2-theta approach is very slow, since multiple measurements are typically made. Use of spectroscopic scatterometry requires sophisticated expensive optics.

In a specific embodiment of the present invention, techniques and apparatus for simultaneous, multi-angle scatterometry are provided. Unlike the 2-theta approach, measurements are made with an apparatus which permits scattering intensity to be simultaneously determined for many angles. This technique is far faster than the 2-theta approach.

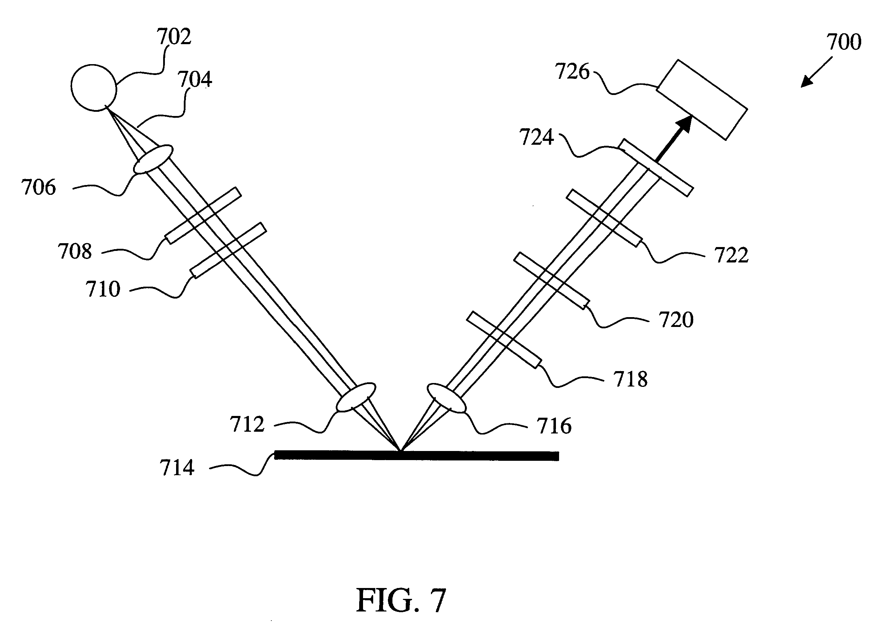

In order to implement this approach, an optical apparatus such as that shown in US Patent 5,166,752 by Spanier et al could be used. This patent is herein incorporated by reference in its entirety. In this patent, a multi-angle ellipsometer is shown in, for example, Figures 3 and 4 of the Spanier et al. patent. Figure 7 is a diagrammatic representation of a simultaneous, multiple angle of incidence ellipsometer 700. As shown, the ellipsometer includes a source generator (e.g., components 702, 706, 708, 710, and 712) for directing polarized light onto the surface of sample 714, detection optics (e.g., components 718 through 724) for handling and detecting the output beam emitted from the sample, and an analyzer 726 for analyzing the polarization state of the light reflected from the sample. The source generator includes a light source 702, a polarizer 708, a compensator 710 with a variable aperture, and a focusing lens system 712 simultaneously directing polarized light from a single beam of light from the light source onto the sample's surface at different angles of incidence. The source generator may also include an optional optical narrow band filter.

The lens system 712 has an effective aperture to focal length ratio for focusing the light on the sample 714 with angles of incidence which vary over a range of angles of at least one or two degrees. In a particular embodiment, the range of angles of incidence is 30 degrees. Larger angles could be employed for directing rays at the sample 714.

The focusing lens system 712 focuses the polarized light which may be from a He-Ne laser for example, down to a single small spot or point on the sample 714. The different incident rays may have widely varying angles of incidence which are focused on a single, small spot on the sample 714. Thus, the light directed on the small spot on sample 714 contains rays at many angles of incidence above and below the angle of incidence of the central ray through the focusing lens. Each one of the incoming rays is reflected at an angle equal to its angle of incidence with the polarization state of each of the rays being altered by that reflection. A detector array 722 is employed to detect a plurality of rays reflected from the sample 714 individually over different, narrow ranges of angles of incidence to simply and quickly obtain data at a plurality of angles of incidence.

The output beam emitted from the sample 714 is directed through output lens 716, interchangeable aperture 718, polarization analyzer 720, and an optional alternate filter 722 onto detector array 722. The diameter d of the lenses 712 and 716 corresponds to their effective diameter. In the illustrated embodiment the lenses 712 and 716 each have a diameter d of 18 mm and a focal length 1 of 34 mm. Other effective lens diameters and focal lengths could be employed so long as a range of angles of incidence, preferably at least 30 degrees, is provided. The lens diameter and focal length are chosen with a view toward maximizing the number of angles of incidence of the light beams which strike the sample 714. In an alternative embodiment, light is transmitted through the sample rather than reflected from a surface of the sample.

The refocusing lens or lenses 712 directs the reflected (transmitted) light toward the detector array 722. However, a refocusing lens need not be employed as the reflected (transmitted) light could be made to directly impinge upon an array of detectors. It is preferable that the lenses 712 and 716 do not themselves alter the polarization state of the light.

The detector array 722 may be a linear, multiple element detector wherein each of the detector elements can detect a narrow range of angles of incidence of the rays that illuminate the sample. In the disclosed embodiment, the array 722 is a solid-state photosensitive detector array wherein the separate detector elements are all integrated on one circuit chip. Particularly, the detector elements comprise a linear array of photodiodes. While integrated on a single circuit chip, the individual photodiodes can function as separate detectors. The linear array of the disclosed embodiment comprises 128 detector elements arranged in a row to provide data for 128 different angles of incidence where the full array is illuminated by the reflected (transmitted) light. The number of individual detector elements could be more or less than that in the disclosed embodiment and the detector elements need not be integrated on a single chip but could be discrete detectors. By using a plurality of detector elements, it is possible to simultaneously detect the light reflected from the surface (or transmitted through the sample) for each of a plurality of different angles of incidence. It is also possible with the invention to employ a smaller number of detector elements which could be sequentially moved to mechanically scan the reflected (transmitted) rays for detection but this technique would require more time and could be less accurate, depending upon positioning accuracy.

The physical size of each of the detector elements is preferably less than the expanse of the reflected rays so that each element detects only a certain narrow range of angles of incidence on the illuminating side. The output of each of the detectors is used in a conventional manner as with real time computer techniques (e. g., via analyzer 724) to generate data in terms of A and T for each of those narrow ranges of angles of incidence. The data is then interpreted in a conventional manner. It matters in general which direction the linear array runs; the linear array preferably runs in the plane of the optical system. In the disclosed embodiment, the long axis of the linear detector array 722 lies in the plane of incidence of the central ray and perpendicular to the central ray for detecting the maximum number of incidence angles.

Such an ellipsometer could be used to illuminate a scatterometry target simultaneously over a range of angles, and an intensity of the scattered light is measured over a range of angles simultaneously with an array detector or the like. By collecting data from the intensities measured at those angles, the parameters of the grating or other target can be determined. For example, the data can be compared against theoretical models of data derived from techniques such as those mentioned by U. S. Patent No. 6,590, 656, issued July 8,2003, entitled "SPECTROSCOPIC SCATTEROMETER SYSTEM" by Xu et al. The data can be compared to theoretical models derived from techniques such as those mentioned by U. S. patent application, having application no. 09/833,084, filed 10 April 2001, entitled "PERIODIC PATTERNS AND TECHNIQUE TO CONTROL MISALIGNMENT", by Abdulhalim, et al.

The data can be pre-generated and stored in libraries, or generated in real time during analysis. It is also possible, for techniques like scatterometric overlay, to directly compare measured spectra associated with various targets. Such differential measurements can then be used to determine overlay misregistration.

It would also be possible to perform this technique with a beam profile reflectometer such as that described in US Patent No. 4,999, 014, issued 12 March 1991, entitled "METHOD AND APPARATUS FOR MEASURING THICKNESS OF THIN FILMS" by Gold et al.

Simultaneous Ellipsometry and Reflectometry

A system for employing a combination of ellipsometers and reflectometers may be employed to improve the accuracy of scatterometric measurements of overlay. In one embodiment, two or more ellipsometers are utilized as scatterometers to measure overlay. One of more of these ellipsometers could be spectroscopic ellipsometers. In another embodiment, two or more reflectometers are utilized as scatterometers to measure overlay. One of more of these reflectometers could be polarized reflectometers. Alternatively, a combination of one or more ellipsometers and one or more reflectometers are utilized as scatterometers to measure overlay.

Measurements can be performed serially (with each tool performing measurements at different times), in parallel (with all tools performing measurements substantially-simultaneously, or in any other arrangement (e. g., at least two but less than all of the tools performing measurements substantially-simultaneously).

In any of the implementations described herein, various tools may perform measurements at different angles of incidence, including normally and obliquely. In a specific implementation, at least two tools perform scatterometric measurements at substantially the same angle of incidence but from different directions. For instance, a first tool would be used for scatterometric measurements in the x direction, and a second tool would be used for scatterometric measurements in the y direction. Such a system could eliminate certain common scattered signals, with a corresponding increase in accuracy of measurements, and provide a symmetric configuration.

An advantage of employing a combination of such tools in scatterometric determination of overlay is that the accuracy of the measurements could be increased. Another advantage in using more than one tool and performing measurements at more than one angle (or point) of incidence is to help separate effects affecting the medium of interest (e. g. , film effects) from overlay. A further advantage is that combinations of ellipsometers and reflectometers already exist in current inspection tools. Another advantage of employing a combination of scatterometers configured to perform scatterometry measurements substantially in parallel on different targets or different target sections could be to reduce the total time required for measurement. Another advantage of a parallel measurement system could be to increase the signal acquisition time for each scatterometry overlay target and improve the measurement precision.

Scatterometric Overlay Determination Using FT processing

A system for scatterometric measurement of overlay using fourier transform (FT) processing may also be utilized. In one embodiment, an interferometer is employed to modulate substantially all wavelengths of a broadband source, and the scattered radiation is detected with a CCD camera. Substantially all wavelengths of the modulation band are recorded for each pixel, or for groups of pixels. As the interferometer steps through the modulation band, a spectroscopic image of the scattered signal is produced.

The resulting spectroscopic image may have a relatively large field of view. For example, the image may include several multiple targets. The spectroscopic image could be processed on a pixel-by-pixel basis to accurately determine overlay while eliminating extraneous effects (e.g., film effects). Alternatively, processing could be performed using groups of pixels to improve speed and decrease processing resources. For example, a group of pixels from each target may be analyzed in accordance with the above described scatterometry process. In one implementation, the images for each corresponding pair of targets is subtracted to obtain difference images D1 and D2. A characteristic, such as average intensity, of each difference signal is then obtained to result in P1 and P2, which are then used to determine the overlay error.

In a specific implementation, a Michelson interferometer is used to step through a wavelength modulation band. Alternatively, a Linnik interferometer, or any other interferometer, could be employed. For each position of the mirror, a CCD camera records the scattered signal intercepted in the field of view of the camera. The detected signals may then be digitized and stored on a pixel-by-pixel basis, or as groups of pixels. The magnitude of the steps is generally proportional with the accuracy of the overlay measurement. The speed of the camera (e.g., the number of fields per second that the camera can capture) is typically proportional with the speed of the measurement. Once the modulation band is spanned, the signal recorded for each pixel (or group of pixels) may be used as a basis for a discrete fourier transformation (or DFT). The DFT provides a spectral profile for each pixel (or group of pixels). This spectral profile for each target may then be used in the scatterometry overlay techniques described in the previous paragraph. Overlay determination can then be performed with increased accuracy.

Multiple Tunable Lasers

A system which has a combination of tunable lasers may be utilized to improve the accuracy of scatterometric measurements of overlay in combination with measurements performed by various configurations of ellipsometers and reflectometers. The tunable lasers provide radiation incident on the surface of interest. In one embodiment, scatterometric overlay measurements are performed using targets disposed in at least one layer of the design under consideration, and the tunable lasers provide radiation beams incident on the targets.

The measured signals may then be averaged together before or after processing. In one embodiment, measured radiation beams are obtained from targets A, B, C, and D. Two difference signals D1 an D2 from each pair of targets may then be obtained at multiple tunable laser settings. The signals measured from each target for each tunable laser setting may be averaged together prior to obtaining the difference signals D1 and D2. Alternatively, each set of differences signals for D1 and D2 may be averaged together to obtain a single average difference signal D1 and D2. Properties P1 and P2 of the difference signals D1 and D2 (e.g., integration) may then be obtained. In an alternative embodiment, multiple properties P1 and P2 are obtained for the different configurations of the tunable laser (without averaging the measured signals or the difference signals D1 and D2) and the results are averaged for each signal P1 and P2. The overlay error may then be obtained based on the signals P1 and P2 as described above.

Scatterometric Overlay Determination Using Spatial Filtering

One embodiment expands on the above described embodiment for *Scatterometric Overlay Determination using FT Processing.*

A system for scatterometric measurement of overlay using FT processing in connection with spatial filtering is provided. More particularly, the signal reflected by at least one scatterometry target is selectively filtered spatially to only process particular signal components.

In the above described embodiment for *Scatterometric Overlay Determination using FT Processing,* an interferometer is employed to modulate substantially all wavelengths of a broadband source, and the scattered radiation is detected with a detector, such as a CCD camera. Substantially all wavelengths may then be recorded for each pixel, or for groups of pixels. As the interferometer steps through the modulation band, a spectroscopic image of the scattered signal is produced. In the present example, where the scattered signal corresponding to a complete image (or a portion of an image) is collected, only a portion of the signal corresponding to a single line of pixels is retained. Alternatively, a portion of the signal corresponding to a plurality of pixel lines, but less than the whole image, is collected. Such a selective collection of the scattered signal can be achieved by spatially filtering the signal to only retain horizontal, vertical or oblique stripes of the signal corresponding to rows of pixels in the detector or CCD camera. Alternatively, a larger, more complete portion of the scattered signal could be collected at the CCD camera, but the information corresponding to undesirable rows of pixels (e.g., an edge of a target or a border between two targets) may be discarded subsequent to the collection.

The spectroscopic image corresponding to the retained signal may then be processed on a pixel-by-pixel basis to accurately determine overlay while eliminating extraneous effects (e.g., film effects). Alternatively, processing could be performed using groups of pixels to improve speed and decrease processing resources. This embodiment provides higher SNR over conventional processing methods.

In one implementation of the invention, the above described techniques to determine overlay in reference to the *Scatterometric Overlay Determination using FT Processing* embodiment may be used.

Compared to the embodiment for *Scatterometric Overlay Determination using FT Processing,* aspects of the embodiment for *Scatterometric Overlay Determination Using Spatial Filtering* may improve the processing speed and the throughput, while decreasing processing resources.

Examples of Spectroscopic Ellipsometers and Spectroscopic Reflectometers

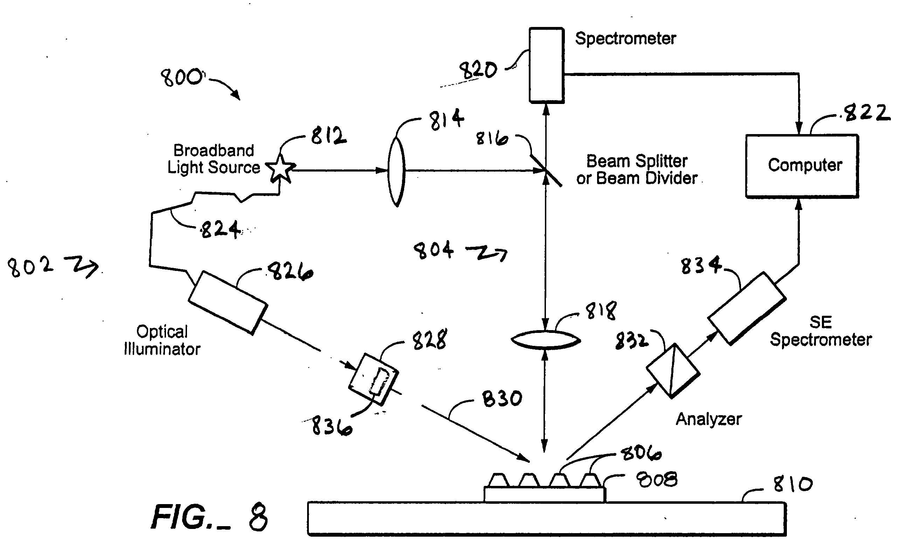

Figure 8 is a schematic view of a spectroscopic scatterometer system 800, in accordance with one embodiment of the present invention. The system 800 combines the features of a spectroscopic ellipsometer 802 and spectroscopic reflectometer 804, each of which may be used for measuring overlay of a grating structure 806 disposed on a substrate or wafer 808. The grating structure 806, which is shown in a somewhat simplified format in the Figure, may be widely varied. The grating structure 806 may, for example, correspond to any of those grating structures described herein. Both the spectroscopic ellipsometer 802 and spectroscopic reflectometer 804 may utilize a stage 810, which is used for moving the substrate 808 in the horizontal xy directions as well as the vertical z direction. The stage may also rotate or tilt the substrate. In operation, the stage 810 moves the substrate 808 so that the grating structure 806 can be measured by the spectroscopic ellipsometer 802 and/or the spectroscopic reflectometer 804.

The spectroscopic ellipsometer 802 and spectroscopic reflectometer 804 also utilize one or more broadband radiation sources 812. By way of example, the light source 812 may supply electromagnetic radiation having wavelengths in the range of at least 230 to 800 nm. Examples of broadband light sources include deuterium discharge lamps, xenon arc lamps, tungsten filament lamps, quartz halogen lamps. Alternatively, one or more laser radiation sources may be used instead of or in combination with the broadband light source.

In the spectroscopic reflectometer 804, a lens 814 collects and directs radiation from source 812 to a beam splitter 816, which reflects part of the incoming beam towards the focus lens 818, which focuses the radiation onto the substrate 808 in the vicinity of the grating structure 806. The light reflected by the substrate 808 is collected by the lens 818, passes through the beam splitter 816 to a spectrometer 820.

The spectral components are detected and signals representing such components are supplied to the computer 822, which computes the overlay in a manner described above.

In the spectroscopic ellipsometer 802, the light source 812 supplies light through a fiber optic cable 824, which randomizes the polarization and creates a uniform light source for illuminating the substrate 808. Upon emerging from the fiber 824, the radiation passes through an optical illuminator 826 that may include a slit aperture and a focus lens (not shown). The light emerging from the illuminator 826 is polarized by a polarizer 828 to produce a polarized sampling beam 830 illuminating the substrate 808. The radiation emerging from the sampling beam 830 reflects off of the substrate 808. and passes through an analyzer 832 to a spectrometer 834. The spectral components of the reflected radiation are detected and signals representing such components are supplied to the computer 822, which computes the overlay in a manner described above.

In the spectroscopic ellipsometer 802, either the polarizer 828 or the analyzer 832 or both may include a waveplate, also known as compensator or retarder (not shown). The waveplate changes the relative phase between two polarizations so as to change linearly polarized light to elliptically polarized light or vice versa.

In order to collect more information about the interaction of the incident polarized light 830 with the sample, it is desirable to modulate the polarization state of the light or modulate the polarization sensitivity of the analyzer or both. Typically this is done by rotating an optical element within the polarizer and/or analyzer. A polarizing element within the polarizer or analyzer may be rotated, or, if at least one of those assemblies contains a waveplate, the waveplate may be rotated. The rotation may be controlled by the computer 822 in a manner known to those skilled in the art. Although the use of a rotating element may work well, it may limit the system 802. As should be appreciated, the use of rotating elements may be slow, and because there are moving parts they tend to be less reliable.

In accordance with one embodiment, therefore, the polarizer 828 is configured to include a polarization modulator 836, such as photoelastic modulator (PEM), in order to produce a fast and reliable spectroscopic ellipsometer. The polarization modulator replaces the rotating waveplate. The polarization modulator 836 is an optical element that performs the same function as a rotating waveplate, but without the costly speed and reliability problems. The polarization modulator 836 allows electrical modulation of the phase of the light without mechanically rotating any optical components. Modulation frequencies as high as 100kHz are readily attainable.

In an alternative embodiment, the analyzer 832 is configured to include a polarization modulator such as a PEM (Photoelastic Modulator) that can be modulated electrically. In yet another embodiment, both the polarizer and analyzer contain polarization modulators, such as PEMs, that are modulated at different frequencies.

Because the polarization modulator 836 can modulate at such a high frequency, the polarization modulator 836 may be used to perform various techniques, which would otherwise be too slow. For example, the difference between the polarized reflectivity of two structures may be obtained. To do this, a PEM may be combined with an acoustic optical modulator (AOM), where the AOM rapidly moves between the two structures while modulating the polarization state at a different (but related, such as multiple or submultiple) frequency. Signals at the sum and the difference of the PEM and AOM modulation frequencies contain useful information and can be detected with high signal-to-noise by synchronous detection. Alternatively the AOM on the incident beam could be used in combination with a PEM in the analyzer.

Although not shown, the rotating waveplate may also be replaced by a polarization modulator in other types of scatterometric systems as for example a polarization sensitive reflectometer.

Scatterometric Overlay Database

One aspect of the present invention provides a database of scatterometric overlay information that may be utilized for scatterometic overlay determination.

In one implementation, one or more database are provided which include one or more libraries of overlay information. The database information is then used in overlay measurements.

In one implementation, the libraries are compiled using predetermined test patterns with artificially-induced overlay. Alternatively, the libraries are produced using layer misregistrations programmed into the stepper. In another embodiment, the overlay that is induced or programmed has a progressive characteristic, varying within a particular range.

The information stored into the database may include overlay data regarding the actual overlay printed on the wafer, as induced via the test pattern or by the stepper. Alternatively, this information is obtained from overlay actually measured on samples. The database may further store scatterometry measurement records associated with the overlay data. Such scatterometry measurement records may be obtained by performing actual scatterometric measurements of the overlay data. The database may also include information regarding materials, process conditions, optical parameters, and other relevant data. The database information may be further enhanced by interpolation and other preprocessing.

The scatterometry database information may be utilized to improve the accuracy and speed of overlay measurements by retrieving scatterometry data associated with particular scatterometric measurements and process conditions recorded during actual measurements. Dynamic selection of a measurement algorithm or methods may also be provided based on database lookups. A further implementation utilizes the database to calibrate scatterometric overlay measurement tools before or during production line measurements.

Alternative Systems for Performing Scatterometry

According to an embodiment of the invention, acquisition of the spectra A through D (and of additional spectra if present) is performed using an optical apparatus that may comprise any of the following or any combination of the following apparatus: an imaging reflectometer, an imaging spectroscopic reflectometer, a polarized spectroscopic imaging reflectometer, a scanning reflectometer system, a system with two or more reflectometers capable of parallel data acquisition, a system with two or more spectroscopic reflectometers capable of parallel data acquisition, a system with two or more polarized spectroscopic reflectometers capable of parallel data acquisition, a system with two or more polarized spectroscopic reflectometers capable of serial data acquisition without moving the wafer stage or moving any optical elements or the reflectometer stage, imaging spectrometers, imaging system with wavelength filter, imaging system with long-pass wavelength filter, imaging system with short-pass wavelength filter, imaging system without wavelength filter, interferometric imaging system (e.g. Linnik microscope, e.g. Linnik microscope as implemented in the KLA-Tencor overlay measurements tools models 5100, 5200, 5300, Archer10, etc. available from KLA-Tencor of San Jose, CA), imaging ellipsometer, imaging spectroscopic ellipsometer, a scanning ellipsometer system, a system with two or more ellipsometers capable of parallel data acquisition, a system with two or more ellipsometers capable of serial data acquisition without moving the wafer stage or moving any optical elements or the ellipsometer stage, a Michelson interfereometer, a Mach-Zehnder interferometer, or a Sagnac interferometer.

Several embodiments of an interferometer based imaging spectrometer, as well as other types of imaging spectrometers such as filter based or the "push broom" approach, are described in U.S. Patent, having Patent No. 5,835,214, issued 10 November 1998, entitled "METHOD AND APPARATUS FOR SPECTRAL ANALYSIS OF IMAGES", by Cabib et al. System and Method embodiments for film thickness mapping with spectral imaging are described in U. S. Patent, having Patent No. 5,856, 871, issued 5 January 1999, entitled "FILM THICKNESS MAPPING USING INTERFEROMETRIC SPECTRAL IMAGING", by Cabib et al. An alternative architecture for spectral imaging based on LED illumination is described in U. S. Patent, having Patent No. 6,142, 629, issued 7 November 2000, entitled "SPECTRAL IMAGING USING ILLUMINATION OF PRESELECTED SPECTRAL CONTENT", by Adel et al.

The imaging spectrometer or reflectometer used for acquisition of the spectra A through D from the four targets (and of additional spectra if present) according to an embodiment of the invention may be of the Fourier transform imaging spectrometer type as is well understood by those skilled in the art. The imaging system of the Fourier transform imaging spectrometer should be capable of separating (resolving) the reflected or scattered light signals from the different targets (or sections of a compound scatterometry overlay target). Alternatively the imaging spectrometer or reflectometer used for acquisition of scatterometry overlay signals may use a two-dimension detector where one axis contains the spatial information from the different scatterometry overlay targets (or sections of a compound scatterometry overlay target) and the other detector axis contains spectrally resolved information from light spectroscopically separated with a prism system or diffraction grating system, for example or a system that is a combination of a prism and a grating. The illumination radiation may be wavelength selected prior to incidence on the target.

The spectra A through D obtained from the four targets (and additional spectra if present) detected in the imaging spectrometers, imaging reflectometers, or any of the other optical systems identified above in connection with various embodiments of the present invention may be unpolarized or selectively polarized. One or more of the unpolarized light or one or more of the polarization components of the reflected or scattered light from the targets may be detected with the imaging spectrometer or the imaging reflectometer.

In various implementations, separate detection systems may be used to separately or simultaneously record one or more of the following light signals: unpolarized reflected light, polarized light with the electric field substantially parallel to one major symmetry axis of one layer of the scatterometry overlay targets, polarized light with the electric field substantially perpendicular to one major symmetry axis of one layer of the scatterometry overlay targets, polarized light with the electric field at an angle to one major symmetry axis of one layer of the scatterometry overlay targets, right-hand circularly polarized radiation, left-hand circularly polarized radiation, and/or a combination of two or more of the previously listed polarization states. A separate detector system may be used to simultaneously record the signal from part of the light source for the purposes of light noise monitoring, and/or light level control, and/or light noise subtraction or normalization.

Various possible implementations of various embodiments of the present invention are illustrated in co-pending U. S. Provisional Application No. 60/449,496, filed 22 February 2003, entitled "METHOD AND SYSTEM FOR DETERMINING OVERLAY ERROR BASED ON SCATTEROMETRY SIGNALS ACQUIRED FROM MULTIPLE OVERLAY MEASUREMENT PATTERNS", by Walter D. Mieher et al.

In one embodiment, each of the four targets is illuminated by radiation produced by an optical system. The optical system may take the form of, among others, an optical source, a lensing system, a focusing system, a beam shaping system, and/or a directing system. In one embodiment, the radiation illuminating at least one of the targets is shaped as a radiation beam, with a relatively narrow beam cross section. In a particular implementation, the beam is a laser beam. The radiation illuminating the targets interacts with structures comprised within the targets and produces diffracted radiation components corresponding to each target and denoted as $S_A$, $S_B$, $S_C$, and $S_D$. In one embodiment, the illuminating beam is a broadband polarized beam comprising a broad spectral range as is commonly used in spectroscopic ellipsometry.

2. Scatterometry Overlay Technique Alternatives:

Several related techniques are described in the above related co-pending U. S. Provisional Applications. These related techniques may be easily integrated with the techniques described herein.

In one embodiment of the invention, the targets (or compound scatterometry target sections) with different programmed offsets +/-F and +/-f0 as described above, or +/-F or other similar target combinations, are grouped together to enable simultaneous signal acquisition. In one implementation targets are arranged in a line to enable data acquisition while scanning the wafer or some or all of the optics in one direction along the array of scatterometry overlay targets. Arranging the targets in a linear array may also enable use of an imaging spectrometer or reflectometer, where one detector axis separates the signals from the different targets (or target sections) and the other detector axis detects the spectral information. In this case the imaging system images a linear or cylindrical image of the linear target array into the prism or grating system. The imaging spectrometer or imaging reflectometer may contain an array of two or more lenses (known to those skilled in the art as a lenslet array) to separate and direct the reflected or scattered light from different targets or target sections.

In one embodiment, the primary offset F is optimized to provide larger or maximum sensitivity to overlay errors. For instance, an offset F equal to $^1/_4$ of the pitch of the target provides high overlay sensitivity since it is half-way in-between the two symmetry points where overlay error sensitivity is minimum. The secondary offset f0 may be chosen such that the f0 is outside the region of interest for overlay measurements, such as equal to or beyond the specification limits, but it should not cause the uncertainty of the overlay measurement to allow the error that an out-of-spec measurement can be interpreted as within specifications. Nevertheless, this is not a limitation on the range of f0. A large f0 may decrease the accuracy of the overlay measurements for overlay errors E between -f0 and +f0. For overlay errors E larger than |F0|, the accuracy of the overlay measurement may be reduced due to extrapolation beyond the region -f0 to +f0 and the accuracy of the linear approximation may also be reduced.

Overlay measurements are most commonly done at or near the four corners of the stepper field (sometimes with an additional measurement near the center of the field) in 5 to 25 fields per wafer in semiconductor manufacturing processes. For a system of four targets used to determine overlay in the x direction and four targets used to determine overlay in the y direction, according to an embodiment of the present invention, a total of 8*4*5=160 measurements of scatterometry overlay targets may be used to determine the two dimensional overlay for a common overlay measurement sampling plan. More measurements may be conducted for more detailed sampling plans.

According to another embodiment of the invention, a total of six targets (three for x and three for y, for example) can be used to determine two dimensional overlay for the sample. This may facilitate further simplification of the overlay metrology process, reduction in processing resources, and decrease of the time used in the metrology process. In yet other implementations, additional targets or additional pairs of targets may be produced on the sample and used in a substantially similar manner with that described herein for determination of overlay based on scatterometry, but adjusted for the increased number of targets and corresponding number of diffracted radiation components. The mathematical methods for determination of the overlay error E can be similarly adjusted to exploit the availability of increased information provided by such additional targets or additional pairs, including by possibly accounting for higher order approximation terms in the formula for the overlay error E.

Scatterometric Overlay Determination With Limited Refocusing

To improve the accuracy of scatterometry overlay determination, more than one measurement is preferably carried out. One implementation utilizes a plurality of scatterometry overlay targets, and for each target, the system makes one scatterometric measurement of overlay. Another implementation utilizes a single scatterometric target, or a single scatterometric target area that comprises multiple target sub-regions, and more than one scatterometric overlay measurement is performed for that target or target area. In yet another embodiment, a plurality of targets or target regions are used, and more than one measurement is performed for some or all of the targets or target regions.

Conventionally, the optical system is refocused for each individual measurement. This, however, can consume a lot of time thus decreasing the processing speed of the system. For example, each focus sequence may take between 0.1 and 1 seconds, and each wafer may include between 30 to 70 sites with each site consisting of 8 targets. Using these numbers, refocusing may take up to as much as 560 seconds for each wafer. Considering there are typically 100s and 1000s of wafers to be inspected this number may be further increased to a completely unacceptable level.

In accordance with one embodiment of the present invention, therefore, multiple scatterometry overlay measurements are performed with limited optical refocusing in order to increase the processing speed and throughput of the system. By limited optical refocusing, it is generally meant that at least some new measurements are performed without refocusing the optical system, i.e., multiple measurements are made with the same focus setting. For instance, the optical system may be initialized with a focus setting that is optimized for a plurality of scatterometric measurements that will be performed, and no further refocusing takes place during these individual scatterometric measurements. The optimized focus setting may be found once for the entire wafer, or it may be found periodically. When periodic, the focus setting may be established at preset increments of time during inspection (e.g., every 30 seconds), for a particular location on the wafer (e.g., every 2 x2 cm2 of wafer), for a particular characteristic of the target (e.g., similar line widths and spacing) and the like.

In one embodiment, the wafer includes a plurality of focus zones. Each of the focus zones is initialized with a focus setting that is optimized for all of scatterometric measurements that will be performed within the focus zone. Refocusing does not occur between individual scatterometric measurements inside the focus zone. As such, each target within the focus zone is measured with the same optimized focus setting. Any number of focus zones may be used.

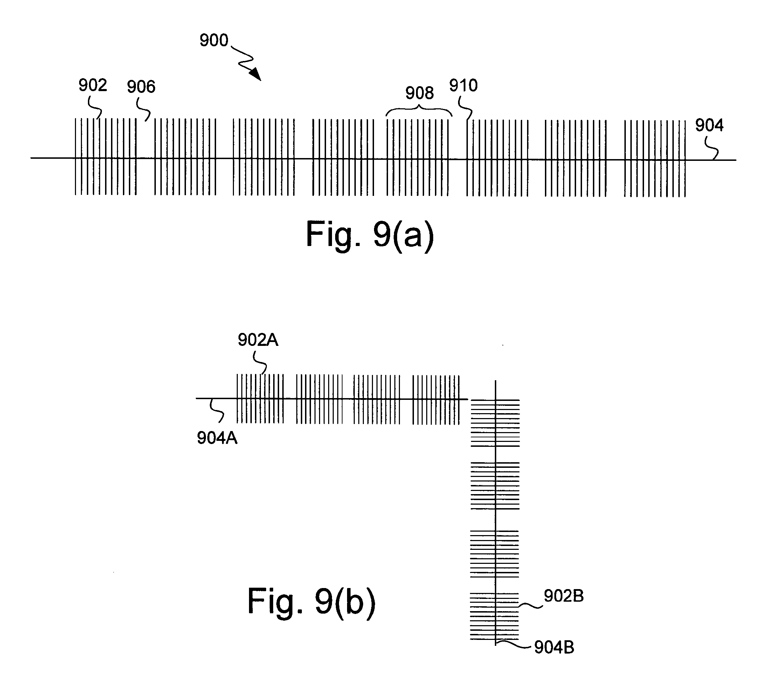

The configuration of the focus zones may be widely varied. In one implementation, the focus zones correspond to a portion of the wafer. By way of example, the wafer may be broken up into plurality of radial focus zones emanating at the center of the wafer and working outwards, or into a plurality of angular focus zones, which separate the wafer into multiple quadrants. In another implementation, the focus zones correspond to a particular set of targets as for example, the targets at the corners of each semiconductor device. In another implementation, the focus zone corresponds to a particular target area that includes a plurality of targets (see for example Fig. 9A). In another implementation, the focus zones correspond to a particular target sub-region within the target areas (as for example the x or y directed group of targets shown in Fig. 9B). In yet another implementation, the focus zone corresponds to a particular sub region within the target itself.

A method of determining overlay will now be described. The method generally includes optimizing the focus setting of a first zone. The method also includes performing a first set of measurements on a plurality of targets within the first zone. Each of the targets within the first zone is measured using the optimized focus setting of the first zone. That is, a first target is measured, and thereafter a second target is measured without refocusing the optical system. Any number of targets can be measured in this manner. The method further includes optimizing the focus setting of a second zone. The method additionally includes performing a second set of measurements on a plurality of targets within the second zone. Each of the targets within the second zone is measured using the optimized focus setting of the second zone. That is, a first target is measured, and thereafter a second target is measured without refocusing the optical system.

Any number of targets can be measured in this manner.

In one example of this method, the first and second zones may represent different target areas that include a plurality of targets (See Fig. 9A). In this example, each of the targets are located in close proximity to one another and therefore it can be assumed that variations in focus from one target to the next are minimal. The method generally includes optimizing the focus setting in the target area, and thereafter measuring each of the targets in the target area with the optimized focus setting. For example, the first target is measured, thereafter the adjacent target is measured, and so on without ever refocusing the optical system. When a first target area is measured, the system may repeat these steps on a second target area, as for example, a target area located at a different corner of the device.

In another example of this method, the first and second zones may represent sub regions with a target area that includes a plurality of targets. The sub regions may for example represent different target orientations (See Fig. 9B). The method generally includes optimizing the focus setting in the first sub regions (e.g., targets along the x axis), and thereafter measuring each of the targets in the sub region with the optimized focus setting. For example, the first target is measured, thereafter the adjacent target is measured, and so on without ever refocusing the optical system. When the first sub region is measured, the method continues by optimizing the focus setting in the second sub regions (e.g., targets along the y axis), and thereafter measuring each of the targets in the sub region with the optimized focus setting. For example, the first target is measured, thereafter the adjacent target is measured, and so on without ever refocusing the optical system. In another example the system is refocused prior to the measurement on the first scatterometry overlay target in an xy scatterometry overlay target group. After the scatterometry signal is measured for the first target in the xy overlay target group, the rest of the targets may be measured without refocusing. For example, an xy overlay target group comprises four scatterometry overlay targets for an overlay error determination in the x direction and four scatterometry overlay targets for an overlay error determination in the y direction.

Scatterometric Overlay Determination Using a Line Image

A system for scatterometric measurement of overlay using a line image may also be implemented.

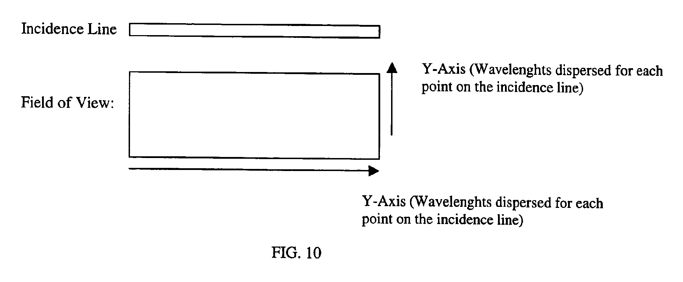

In one embodiment, a scatterometric target is illuminated along a single incidence line. The scattered radiation is intercepted by a dispersive system, such as a prism or diffraction grating. The scattered radiation is thereby dispersed as a function of wavelength. The dispersed radiation is then captured by a detector, such as a CCD camera. If the camera is properly aligned, the radiation entering the field of view has a two dimensional profile with points along the incidence line distributed along the X-axis of the field of view, and various wavelengths dispersed along the Y-axis. An example incidence line and field of view are illustrated in Fig. 10.

The image captured by the camera can then be processed at pixel level to determine overlay, possibly using the FT approach disclosed herein. Once overlay is measured along a particular incidence line, the wafer could be rotated by 90 degrees (or by any arbitrary angle) to measure overlay in a different direction. An advantage of the present invention is that overlay may be measured in more than one direction using a single optical system.

An alternative to illuminating a single incident line is illuminating a larger area but only capturing scattered radiation along a detection line. The description provided above also applies to this embodiment, with appropriate modifications.

Algorithms

Various algorithms and methods may be employed for more efficiently and accurately measuring overlay based on scatterometry.

Old methods of performing such calculations use a model- based method, or a differential method for calculating overlay. These conventional methods lack the accuracy that may be achieved by combining multiple algorithms for refining and cross checking results. Also, these methods do not make good use of pre-existing information (like CD or profile data).

In one general algorithm implementation, overlay is determined using data from a plurality of separate calculations of different product parameters.

In a first embodiment, a first calculation of overlay is performed according to a first technique (such as the differential method). A second calculation of overlay is then performed according to a second technique (such as a model-based regression). The results are then combined from the two calculations. The results may be combined in various ways. For example, one calculation may be used to cross check another. Or one calculation may be used to provide initial values to speed up the other calculation. Other combinations may also be used.

In a second embodiment, the speed and/or accuracy of an overlay measurement are enhanced by making use of other measured data. For example, film thickness data from the layers making up the target may be fed into the algorithm. Such film thickness data could be measured using an appropriate tool, such as an ellipsometer or reflectometer. Alternatively (or additionally), CD data could be provided from an SCD measurement (scatterometry critical dimension or scatterometry profile measurement) and used to speed up or improve the accuracy of the scatterometry calculations. Other data from a scatterometry profile measurement could be similarly used, such as height or three dimensional profile information. Other sources of CD data, like a CD SEM, could be used.

Combined Scatterometry and Imaging Targets

In an alternative implementation, the targets are designed for an imaging based overlay metrology application, as well as for the above described scatterometry analysis. In other words, the scatterometry and imaging target structures are tightly integrated so that scatterometry may be performed in conjunction with an image based overlay measurement. Preferably, the scatterometry target pairs are symmetrically positioned about the center of the field of view. If symmetry is preserved in the illumination and collection channels of the imaging system, tool induced shift and will be minimized. By example, Xa and Xa' are twin (have similar magnitude but opposite sign offset) targets in the x direction. (Here Xa and Xa' may correspond to the targets Xa and Xd in Figure 1). Likewise, Xb and Xb' are opposites. (Here Xb and Xb' may correspond to the targets Xb and Xc in Figure 1). In the y direction, targets Ya and Ya' are opposites, while Yb and Yb' are opposites.

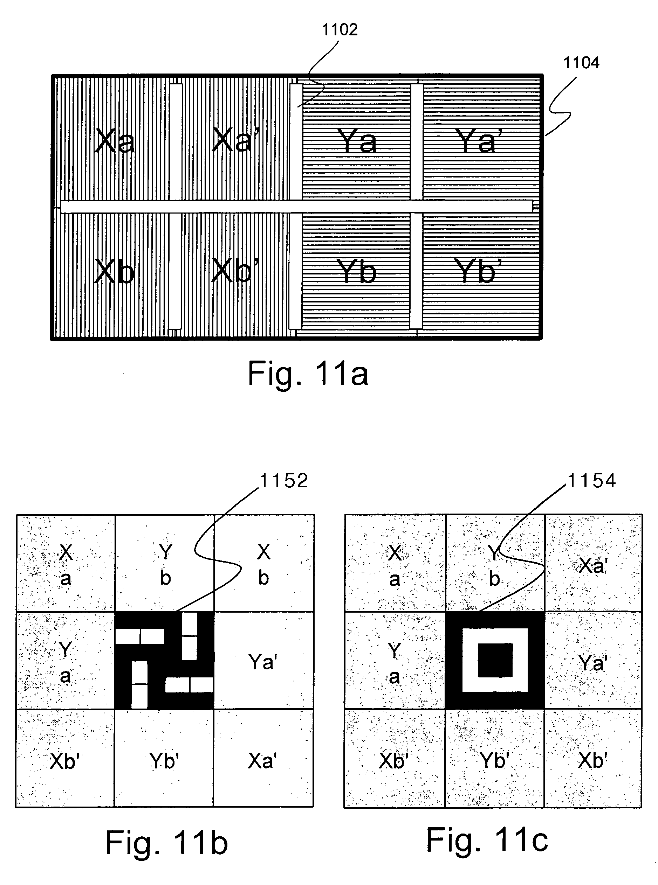

Figure 11a is a top view representation of a first combination imaging and scatterometry target embodiment. In this example, the target arrangement includes a set of four x direction targets for determining overlay using scatterometry and a set of four y direction targets for determining overlay using scatterometry. The targets are laid out so that adjacent targets (with respect to the overlay measurement direction) have an opposite offset. In the illustrated example, target Xa has an opposite offset than target Xa', and target Xb has an opposite offset than target Xb'. Likewise, targets Ya and Ya' have opposite offsets, and targets Yb and Yb' have opposite offsets. In this example, the targets also include structures which can be used for imaged based overlay determination.

In the illustrated example, the target arrangement includes a black border structure 1104 on a first layer and a gray cross-shaped structure 1102 on a second layer. Using image analysis methods, the center of the black structure 1104 may then be compared with the center of the gray structure 1102 to determine an overlay error (if any).

Although this set of targets have an overall rectangular shape which extends longer in the x direction than the y direction, of course, the targets could have other shapes (e.g., square or any symmetrical polygon) and/or extend longer in a direction other than x.

In other combinational target arrangements, the imaging structures are laid out in the center of a symmetrically arranged set of scatterometry targets. Figure 11b is a top view representation of a second combination imaging and scatterometry target embodiment. As shown, scatterometry targets are symmetrically arranged around a central image type target 152. In this example, the image type target 1152 is formed from quadrants of line segments, where each quadrant is either in the x or y direction. Suitable image type targets and techniques for determining overlay with same are described in the following U.S. patents and applications: (1) Patent No. 6,462,818, issued 8 October 2002, entitled "OVERLAY ALIGNMENT MARK DESIGN", by Bareket, (2) Patent No. 6,023,338, issued 8 February 2000, entitled "OVERLAY ALIGNMENT MEASUREMENT OF WAFER", by Bareket, (3) Application No. 09/894,987, filed 27 June 2001, entitled "OVERLAY MARKS, METHODS OF OVERLAY MARK DESIGN AND METHODS OF OVERLAY MEASUREMENTS", by Ghinovker et al. , and (4) Patent No. 6,486, 954, issued 26 November 2002, entitled "OVERLAY ALIGNMENT MEASUREMENT MARK" by Levy et al.

Figure 11c is a top view representation of a third combination imaging and scatterometry target embodiment. This target arrangement has scatterometry target symmetrically arranged around a box-in-box type target 1154. A box-in-box target generally includes a first inner box formed from a first layer surrounded by a second outer box structure formed in a second layer. The centers of the inner box structures may be compared to the center of the outer box structures to determine overlay error (if present).

The above targets may be imaged in any suitable manner (e. g. , as described in the above referenced patents and applications by Bareket, Ghinovker et al. , and Levy et al.) to determine overlay. The target arrangements may also simultaneously or sequentially measured with any desirable optical tool as described herein to determine overlay using scatterometry techniques. In an alternative embodiment, the scatterometry targets may be simultaneously imaged along with the imaging type target structures. The resulting image may be subdivided into the separate scatterometry targets and then the scatterometry techniques applied to the image signals for each target (e. g. , intensity). The image may be obtained at the same time as, or before or after the scatterometry overlay measurements. The imaging system may be a high-resolution microscope such as the system in the KLA-Tencor 5300 or Archer overlay measurement systems available from KLA-Tencor of San Jose, CA. Alternatively, the imaging system may be a lower resolution imaging system used for other purposes that may include wafer alignment or pattern recognition.

Mask Alignment During Imprint Lithography

Because the mask and sample are typically in close proximity (separated by the fluid to be polymerized) during nano-imprint lithography, the patterned surface of the mask, the fluid, and the patterned sample to be aligned to can be considered to be functionally equivalent to a scatterometry overlay target. All of the methods, techniques and targets defined for scatterometry overly would then be applicable to alignment procedures.

In one embodiment, the measurement instrument would project radiation (preferably light) through the mask and onto an area of the mask and wafer which contains one or more scatterometry overlay targets. The change in properties of the reflected light due to scattering or diffraction may then be used to determine the offset between the pattern on the mask and the pattern on the wafer. The wafer is then moved relative to the mask (or vice versa) to achieve the desired offset. A more accurate alignment may the be achieved, rather than with conventional alignment techniques such as direct imaging or moire techniques. The instrument could be a reflectometer, polarized reflectometer, spectrometer, imaging reflectometer, imaging interferometer, or other such instrument as described herein or in the above referenced provisional applications.

Disposition of Scatterometry Overlay Targets

The accuracy of scatterometry overlay systems can be improved by taking measurements at multiple targets located across the surface of interest. In one implementation, the scatterometry overlay system may utilize a plurality of scatterometry targets at various locations across the surface of interest and for each target the system may make one scatterometric measurement of overlay. In another implementation, the scatterometry overlay system may utilize a plurality of scatterometry target areas at various locations across the surface of interest. The scatterometry target areas comprise multiple targets, each of which can be measured by the scatterometry overlay system. By way of example, the scatterometry targets or scatterometric target areas may be located at the corners of one or more devices being formed on a wafer. In addition, the scatterometry targets may generally include a grating structure, which is measurable by the scatterometry overlay system.

The number of targets generally depends on the available space on the surface of interest. In most cases, the targets are placed in the scribe line between devices on a wafer. The scribe line is the place on the wafer where the wafer is separated into dies via sawing or dicing and thus the circuit itself is not patterned there. In cases such as this, the number of targets may be limited, at least in part, by the narrowness of the scribeline. As should be appreciated, the scribe lines tend to be narrow so as to maximize the amount of devices on the wafer.

In accordance with one embodiment of the present invention, the targets are strategically placed on the surface of interest in order to overcome any space constraints while increasing the number of targets. In one implementation, at least two targets are placed substantially collinearly in a first direction. For example, they may be placed collinearly in the x-direction or the y-direction. This arrangement may be useful when confronted with narrow spaces as for example scribe lines. In another implementation, multiple targets are disposed collinearly in multiple directions. For example, multiple targets may be disposed collinearly in both the x direction and the y-direction. This arrangement may be useful at the corner of a device as for example at the intersection of two scribe lines.

Although the examples given are directed at a Cartesian coordinate system as defined on the surface of interest, it should be noted that the coordinate system may be oriented arbitrarily on the surface or interest with the x and y axis being rotated or possibly interchanged. Alternatively or in combination with the Cartesian coordinate system, any other coordinate system may be used such as for example, a polar coordinate system.

Fig. 9A is a top view diagram of a scatterometric target area 900 having one or more targets 902, in accordance with one embodiment of the present invention. The scatterometric targets 902 are generally provided to determine the relative shift between two or more successive layers of a substrate or between two or more separately generated patterns on a single layer of a substrate. By way of example, the scatterometric targets may be used to determine how accurately a first layer aligns with respect to a second layer disposed above or below it or how accurately a first pattern aligns relative to a preceding or succeeding second pattern disposed on the same layer.

As shown in Fig. 9A, the scatterometric target area 900 includes at least two substantially collinear targets 902. By collinear, it is generally meant that the centers of symmetry for each of the targets 902 lie on the same axis 904. By way of example, the axis 904 may be aligned with a conventional coordinate system (Cartesian, polar, etc.) or some variation thereof. By placing the targets 902 collinearly, the scatterometric target area 900 does not take up as much width W and therefore may be placed in constrained places as for example in the scribeline of the wafer.

The targets 902 are generally juxtaposed relative to one another along the axis 904. In most cases, the juxtaposed targets 902 are spatially separated from one another so that they do not overlap portions of an adjacent target 902. Each of the targets 902 is therefore distinct, i.e., represents a different area on the substrate. This is typically done to ensure that each of the targets 902 is properly measured. The space 906 between targets 902 produces distortions in the optical signal and therefore it is excluded from the overlay calculation. The size of the space 906 is typically balanced with the size of the targets 902 so as to provide as much information as possible for the measurement of overlay. That is, it is generally desired to have larger targets 902 and smaller spaces 906 there between. The space 906 between targets 902 may be referred to as an exclusion zone.

The targets 902 may be widely varied, and may generally correspond to any of those overlay targets that can be measured via scatterometry. By way of example, the targets 902 may generally include one or more grating structures 908 having parallel segmented lines 910. Although not a requirement, the segmented lines 910 for the collinear targets 902 are generally positioned in the same direction, which may be parallel or transverse to the axis 904. In most cases, some of the segmented lines 910 are perpendicular to the axis 904 and some are parallel to the axis 904 to enable overlay measurements in x and y. Furthermore, the targets 902 may have an identical configuration or they may have a different configuration. Configuration may for example include the overall shape and size of the target 902 or perhaps the line width and spacing of the segmented lines 910 associated with the grating structure 908 contained within the target 902. Preferably the targets used for the overlay measurement in a particular direction, for example x direction, are designed to have the same configuration except for the programmed or designed overlay offsets.

The number of targets may also be widely varied. As should be appreciated, increasing the number of targets, increases the number of data collection points and therefore the accuracy of the measurement. The number of targets 902 generally depends on the overall size of the targets 902 and the space constraints in the direction of the axis 904. In the illustrated embodiment, eight side by side targets 902 are positioned within the scatterometric target area 900. A scatterometric target area may be equivalent to an xy scatterometry overlay target group as discussed above.

Using the above mentioned targets 902, scatterometric overlay measurements may be made sequentially, one target at a time, to measure overlay while eliminating effects due to variations in other sample parameters, such as film thickness. This can be accomplished via continuously scanning of the scatterometric target area (including for example the targets and the spaces there between) or by stepping to each of the targets. Alternatively, measurements may take place substantially simultaneously using two or more scatterometry signal beams for two, more than two, or all targets to increase throughput. The multiple scatterometry signal beams may come from more than one substantially independent scatterometry optical systems, or they may share much of the optical system, for example they may share the same light source, the same beam directing optics, or the same detector system.

Although the method described above includes placing the centers of symmetry for each of the targets substantially collinear, it should be noted that the centers of symmetry may be offset from the axis so long as a measurable portion of the targets still falls on the same axis.

Furthermore, although the method described above includes placing targets of similar orientation along the same axis, it should be noted that some of the targets may be positioned with a different orientation. For example, a first group of the targets 902 may have segmented lines positioned in the x dimension while a second group of the targets 902 may have segmented lines position in the y dimension.

Moreover, although the targets 902 are only shown positioned along a single axis 904, it should be noted that the targets may be positioned on multiple axis. For example, as shown in Fig. 9B, a first group of targets 902A may be disposed collinearly along a first axis 904A and a second group of targets 902B may be disposed collinearly along a second axis 904B. This implementation permits independent measurement of overlay in at least two directions. The first and second axis are typically transverse to one another and more particularly perpendicular one another. In the illustrated embodiment, the first axis 904A corresponds to the X-dimension while the second axis 904B corresponds the Y-dimension. Furthermore, each group consists of four targets 902. This implementation permits independent measurement of overlay in the X and Y directions.

Further still, although the targets have been described as having features (e.g., segmented lines) in substantially one direction, it should be noted that the targets may include features in more than one direction. In one implementation, for example, one or more of the collinearly positioned targets include features that permit scatterometric overlay measurement in first and second directions. By way of example, the features such as the segmented lines may be positioned in both the X and Y dimensions. In this case, the need for disposing targets along more than one axis as shown in Fig. 9B is reduced or eliminated. That is, if each target has features that permit two-dimensional scatterometric measurements, overlay may be determined along both the X- and Y-axes using a single set of targets disposed substantially-collinearly along a single axis. Alternatively, one or more targets may include one or more sub-targets. If the sub-targets have features that permit two-dimensional scatterometric measurements, the number of targets desirable for a particular degree of measurement accuracy may be reduced, and the targets may be disposed along a single line.

Additionally, targets disposed along one or more axis may be used for measurement of more then one parameter. For example, a first set of targets may be used for scatterometric measurement of wavelength along the X-axis and a second set of targets may be used for scatterometric measurement of spatial resolution along the Y-axis. In an alternative implementation, scatterometric measurement of spatial resolution may be performed along the X-axis while spectral measurements are performed along the Y-axis.

Combined CD and Overlay Marks

Scatterometry measurement targets consume a significant area of the wafer for both metrology of CD and overlay. This wafer area becomes very valuable as design rule shrinks. Currently, scatterometry overlay marks may consume >35x70um space for each xy scatterometry overlay target group or mark on the wafer. These are used only for overlay measurements and therefore the manufacturers consider the loss of wafer space as undesirable. Therefore, it is desirable to reduce the total wafer area required for measurement targets or measurement features. Changes to optical system design to enable measurements on smaller targets may result in greater complexity of the optical system and potentially compromise measurement performance. In scatterometry overlay measurement as describe herein, the target area typically consists of four gratings for each axis (X and Y). Each of these gratings is typically larger than 15x15um with a limited opportunity to shrink it further using conventional techniques. Each grating is composed of a first layer grating (e.g. STI) and a top layer grating (e.g. gate.). Each of the two layers has a programmed offset, which is typically smaller than the pitch of the top grating. In many cases the top layer is photoresist. An overlay measurement is achieved by analyzing the spectra of a reflected light from each of these gratings.

In scatterometry critical dimension (CD) measurement, the target area typically consists of a single grating, which may be positioned along either axis (X or Y). In some cases, the target area may include multiple gratings for each axis (X and Y). Each of these gratings is typically about 50x50um. The measurement is typically performed on a single process layer target with no pattern underneath. This measurement is typically done on a photoresist pattern following a resist development step in a lithographic patterning process or following an etch or CMP process in other modules of the fabrication. A CD measurement is achieved by analyzing the spectra of a reflected light from the grating(s) as described in the above referenced U.S. Patent No. 6,590,656 by Xu, et al.

In accordance with one embodiment of the present invention, the scatterometry CD marks and the scatterometry overlay marks are combined to enable the fab to save wafer space and to print larger scatterometry overlay marks with no impact on the wafer scribe-line. The combined mark is constructed with a scatterometry CD target as the first layer and scatterometry overlay target patterns as the top layer. This results in zero or minimal additional scribe line space allocated to scatterometry overlay.

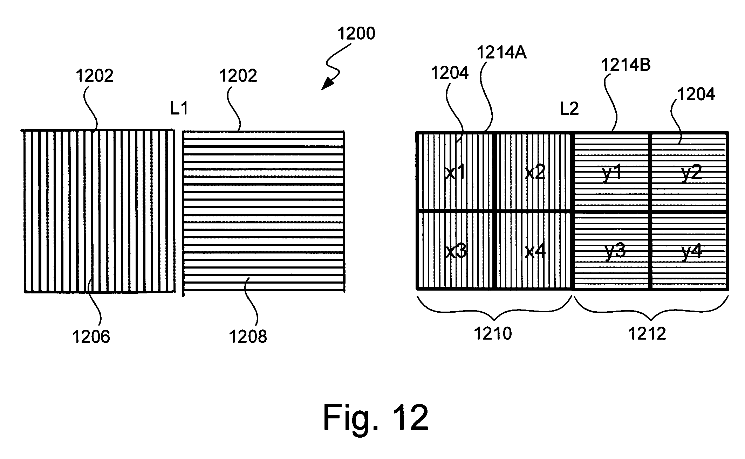

Fig. 12 is a diagram of a combined mark 1200, in accordance with one embodiment of the present invention. The combined mark 1200 provides for both scatterometry CD measurement and scatterometry overlay measurement at different steps in the wafer manufacturing process. The combined mark 1200 is formed on at least two layers of the wafer, particularly a first layer L1 and a top layer L2. The first layer L1 includes scatterometry CD/profile targets 1202 and the top layer L2 includes scatterometry overlay targets 1204. Although shown as separate layers in the diagram, it should be noted that the scatterometry overlay targets 1204 are built on (over) the scatterometry CD profile targets 1202. The scatterometry CD/profile targets 1202 form an L1 scatterometry CD mark, which can be measured to determine CD after formation or processing of the L1 pattern. The scatterometry overlay targets 1204 cooperate with the scatterometry CD/profile targets 1202 to form an L2-L1 scatterometry overlay mark, which can be measured to determine overlay between the layers after formation of the L2 pattern (which comes after L1 pattern formation). As should be readily apparent, this method may be repeated to produce a layer 2 L2 scatterometry CD/profile target(s) followed by a Layer 3 L3 pattern to create an L3-L2 scatterometry overlay mark or target area.

The configuration of the scatterometry CD/profile targets 1202 and scatterometry overlay targets 1204 may be widely varied. In the illustrated embodiment, the scatterometry CD/profile targets 1202 disposed on L1 include a first grating 1206 oriented in a first direction and a second grating 1208 oriented in a second direction. The first direction may be orthogonal to the second direction. By way of example, the first grating 1206 may include vertical lines while the second grating 1208 may include horizontal lines. In addition, the scatterometry overlay targets 1204 disposed on L2 include a first group of gratings 1210 and a second group of gratings 1212. Both the first and second groups of gratings 1210, 1212 include one or more gratings 1214. The number of gratings 1214 may be widely varied. In one implementation, both the first and second groups 1210 and 1212 include four gratings 1214. The gratings 1214A in the first group 1210 are oriented in the first direction, and the gratings 1214B in the second group 1212 are oriented in the second direction. By way of example, the gratings 1214A in the first group 1210 may include vertical lines while the gratings1214B in the second group 1212 may include horizontal lines.

In order to produce an L2-L1 overlay mark, the first group of gratings 1210 is positioned over the first grating 1206 of the CD/profile targets 1202, and the second group of gratings 1212 is positioned over the second grating 1208 of the CD/Profile targets 1202. This places gratings with similarly directed lines together, i.e., vertical lines with vertical lines and horizontal lines with horizontal lines. The first group of gratings 1210 cooperates with the first grating 1206 of the CD/profile targets 1202 and the second group of gratings 1212 cooperates with the second grating 1208 of the CD/profile targets 1202. The alignment between layers is determined by the shift produced between the corresponding lines of these cooperating structures. The vertical lines, for example, may be used to determine X overlay and the horizontal lines, for example, may be used to determine Y overlay.

Although the first and second gratings 1206 and 1208 of the CD mark are shown together, it should be noted that they may be placed apart. When implemented apart, the first group of gratings 1210 and the second group of gratings 1212 would also be placed apart, i.e., the first group of gratings 1210 goes with the first grating 1206 and the second group of gratings 1212 goes with the second grating 1208.

The advantages of combining overlay and CD marks are numerous. Different embodiments or implementations may have one or more of the following advantages. One advantage of combining marks is in the ability to reduce the need for additional wafer space for scatterometry overlay targets. Another advantage is that larger scatterometry overlay targets may be allowed if they do not require as much additional scribe line space. Larger scatterometry overlay targets may make optical design or optics manufacturing easier and may provide better scatterometry overlay metrology performance than on smaller scatterometry overlay targets.

Combination of Scatterometry Overlay and CDSEM

The purpose of this embodiment is to enable measurement of critical dimensions on a semiconductor wafer with an electronic microscope (CD-SEM) and measurement of overlay using scatterometry on the same measurement system or using linked measurement systems sharing at least part of a robotic wafer handling system. The established methods of measuring critical dimensions and overlay commonly require scheduling and operating separate measurement systems. One disadvantage of the established methods of measuring critical dimensions and overlay on separate measurement systems is the additional time required to schedule and run separate operations on separate metrology tools. Another disadvantage is the redundancy of common parts and the costs associated therewith.

In order to overcome these disadvantages, a metrology system that combines Scatterometry Overlay and CDSEM may be provided. In one embodiment, a scatterometry overlay measurement (SCOL) system is integrated with a CDSEM system such that the CDSEM and SCOL systems share at least part of the robotic wafer handling system and/or data systems. Alternatively, the CDSEM and the scatterometry overlay systems may be separate systems capable of independent operation, but linked in such a way that they share at least part of a robotic wafer handling system.

In operation, a wafer, a group of wafers, or batch of multiple wafers may be introduced to the combined metrology system by loading the wafer container onto the robotic wafer handling system dedicated to this combined metrology system. Measurement recipes may be selected specifying CDSEM measurements on some or all of the wafers and scatterometry overlay measurements on some or all of the wafers. The CDSEM measurements and the SCOL measurements may be specified together in one or more recipes, or may be specified in separate recipes. The CDSEM and SCOL measurements may be done on the same wafers or on different wafers or on some of the same wafer and some different wafers. The CDSEM and SCOL systems may operate in parallel, or in series.

One example of the combined metrology system would be integration of a scatterometry system capable of scatterometry overlay measurements (such as a spectroscopic ellipsometer, spectroscopic polarized reflectometer, or +/-1 order diffraction scatterometer) inside a CD-SEM such as any of those manufactured by KLA-Tencor of San Jose, CA. Another example of a combined metrology system would be a linked system comprising a scatterometry overlay system, a CDSEM such as any of those manufactured by KLA-Tencor of San Jose, CA, a robotic handler, and a wafer scheduling system. Communication to factory automation and/or factory information, and/or factory process control systems may be through separate communication or automation systems or may be at least partially or completed shared.

One advantage of the combined CDSEM and SCOL metrology system is the reduction in overall time required to complete scheduling and/or performing the CDSEM and scatterometry overlay measurements. At least one queue delay time may be eliminated. Performing CDSEM and overlay measurements in parallel can save at least part of the time required for separate measurement operations.

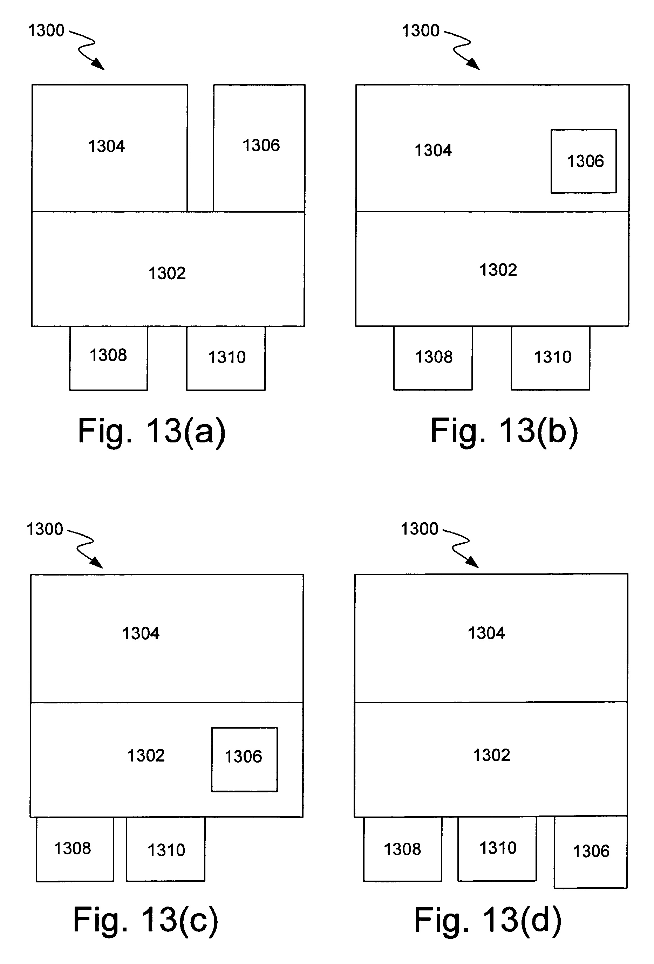

Figs. 13A - 13D show variations of a combined metrology tool 1300, in accordance with several embodiment of the present invention. In all the figures, the combined metrology tool 1300 includes a robotic wafer handling system 1302, a critical dimensioning scanning electron microscope (CD-SEM) 1304, a scatterometry overlay (SCOL) measurement instrument 1306, a wafer load position A 1308 and a wafer load position B and 1310, respectively. The robotic wafer handling system 1302 is configured to transfer wafers to and from the CD-SEM 1304 and SCOL measurement instrument 1306 as well as to and from the wafer load positions A and B 1308 and 1310. The critical dimensioning scanning microscope 1304 is configured to measure the critical dimensions that may include, for example, linewidth, top linewidth, via diameter, sidewall angle and profile. The scatterometry overlay measurement instrument 1306 is configured to measure the overlay as for example between two layers disposed on the wafer. The wafer load position A and wafer load position B are configured to hold one or more wafers. In most cases, they hold a plurality of wafers. The wafers may be from the same lot of from a different lot.

In Figs. 13A and D, the CD-SEM 1304 and the SCOL measurement instrument 1306 are separate systems that are integrated via the robotic wafer handling system 1302. In Fig. 13B, the SCOL measurement instrument 1306 is integrated into the CDSEM 1304. In Fig. 13C, the SCOL measurement instrument 1306 is integrated into the robotic wafer handling system 1302.

In one operation, some of the wafers from wafer load position A and/or B have critical dimensions measured at the CD-SEM and thereafter have overlay measured at the scatterometry overlay measurement instrument. The wafer can be measured by both processes without being removed from the system, i.e., the wafer handling as well as the throughput issues associated therewith are reduced. In another operation, some wafers from wafer load position A and/or B have critical dimensions measured at the CDSEM and some other wafers from wafer load position A and/or B have overlay measured on SCOL measurement instrument. In any of these operations, the CDSEM and SCOL measurement instrument can proceed independently and simultaneously.

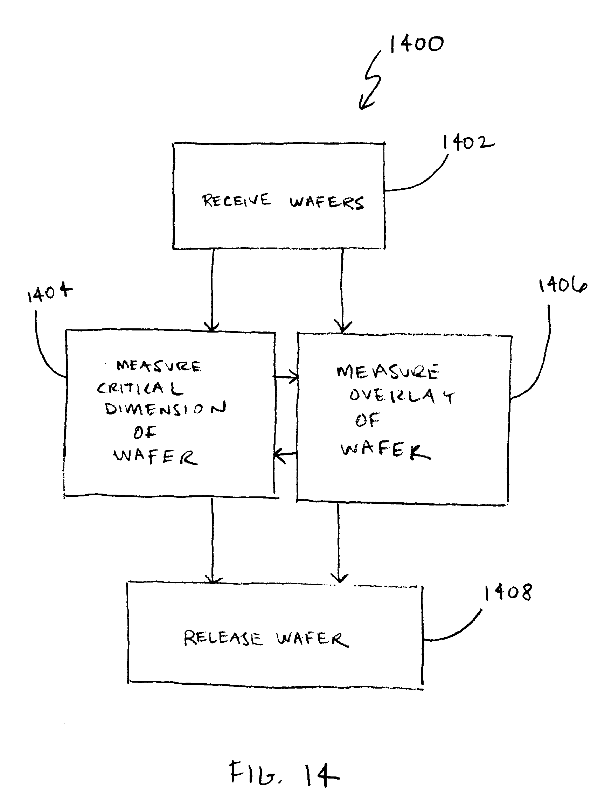

Fig. 14 is a flow diagram 1400 using a combined metrology tool, in accordance with one embodiment of the present invention. The method generally includes step 1402 where a group of wafers are received by the metrology tool. By way of example, the wafers may be a wafer lot that is loaded at position A in Fig. 13. Following step 1402, the process flow 1400 proceeds to step 1404 where the critical dimensions of a wafer from the group of wafers is measured. By way of example, the critical dimension measurements may be performed by a CDSEM as for example the CDSEM shown in Fig. 13. The process flow 1400 also proceeds to step 1406 where the overlay of a wafer from the group of wafers is performed by a SCOL measurement instrument as for example the instrument shown in Fig. 13. Steps 1404 and 1406 may be performed at the same time on different wafers. Steps 1404 and 1406 may be performed on the same wafer in a sequence of operations, as for example, from CD to overlay or from overlay to CD. The transferring of the wafer may for example be performed by the robotic system shown in Fig. 13. When all the measurements are performed, the process flow proceeds to step 1408 where the group of wafers are released from the metrology tool.

Combination of Scatterometry Overlay and Other Metrology or Inspection Methods

Scatterometry overlay may be combined with scatterometry profile or scatterometry critical dimension systems, or other semiconductor metrology or inspections systems. Scatterometry overlay may be integrated with a semiconductor process tool, for example a lithography resist process tool (also known as a resist track). Integration of metrology systems with process systems and combinations of metrology systems are described in (1) U. S. patent application, having Patent No. 09/849,622, filed 04 May 2001, entitled "METHOD AND SYSTEMS FOR LITHOGRAPHY PROCESS CONTROL", by Lakkapragada, Suresh, et al. and (2) U. S. patent, having Patent No. 6,633, 831, issued 14 October 2003, entitled "METHODS AND SYSTEMS FOR DETERMINING CRITICAL DIMENSION AND A THIN FILM CHARACTERISTIC OF A SPECIMAN", by Nikoonahad et al.

Although the foregoing invention has been described in some detail for purposes of clarity of understanding, it will be apparent that certain changes and modifications may be practiced within the scope of the appended claims. Therefore, the described embodiments should be taken as illustrative and not restrictive, and the invention should not be limited to the details given herein but should be defined by the following claims.

**Claims**

1. A method for determining overlay between a plurality of first structures (204a-c) in a first layer of a sample and a plurality of second structures (202a-c) in a second layer of the sample, the method comprising:

   providing a plurality of targets A, B, C and D that each includes a portion of the first (204a-c) and second (202a-c) structures,
   wherein the portion of the second structure of target A has a predetermined offset Xa with respect to the portion of the first structure of target A,
   wherein the portion of the second structure of target B has a predetermined offset Xb with respect to the portion of the first structure of target B,
   wherein the portion of the second structure of target C has a predetermined offset Xc with respect to the portion of the first structure of target C,
   wherein the portion of the second structure of target D has a predetermined offset Xd with respect to the portion of the first structure of target D,
   wherein each of the predetermined offsets Xa, Xb, Xc and Xd is different from zero, Xa is in the opposite direction and differs from Xb, and Xc is in the opposite direction and differs from Xd;
   illuminating the targets A, B, C and D with electromagnetic radiation to obtain spectra $S_A$, $S_B$, $S_C$, and $S_D$ from targets A, B, C, and D, respectively; and
   determining any overlay error between the first structures (204a-c) and the second structures (202a-c) using only the obtained spectra $S_A$, $S_B$, $S_C$, and $S_D$ and the predetermined offsets Xa, Xb, Xc and Xd in a linear approximation technique.

2. The method of claim 1, wherein determining any overlay error comprises:

   determining a difference spectrum D1 from the spectra $S_A$ and $S_B$;
   determining a difference spectrum D2 from the spectra $S_C$ and $S_D$;
   determining any overlay error by performing a linear approximation technique based on the difference spectra D1 and D2.

**3.** The method as recited in claim 2, wherein the linear approximation technique is based on a property P1 of the difference spectrum D1 and a property P2 of the difference spectrum D2.

**4.** The method of any of claims 1-3, wherein each of the targets A, B, C, and D comprises a grating structure Ga1 having periodic structures with a period Ta1 disposed at least partially within the first layer and a grating structure Ga2 having periodic structures with a period Ta2 disposed at least partially within the second layer, wherein the first period Ta1 and the second period Ta2 are substantially identical, and wherein (i) the predetermined offset Xa offsets the structures with the period Ta1 of the grating Ga1 with respect to the structures with the period Ta2 of the grating structure Ga2 by a sum of a positive first distance, +F, and second positive distance $F0_{AB}$, (ii) the offset Xb is designed to offset the structures with the period Ta1 of the grating Ga1 with respect to the structures with the period Ta2 of the grating structure Ga2 by a sum of negative first distance, -F, and a second positive distance $f0_{AB}$, (iii) the offset Xc is designed to offset the structures with the period Ta1 of the grating Ga1 with respect to the structures with the period Ta2 of the grating structure Ga2 by a sum of the positive first distance, +F, and a negative second distance, $-F0_{CD}$, and (iv) the offset Xd is designed to offset the structures with the period Ta1 of the grating Ga1 with respect to the structures with the period Ta2 of the grating structure Ga2 by a sum of the negative first distance, -F, and the second negative distance, $-F0_{CD}$ wherein the second distances $f0_{AB}$ and $f0_{CD}$ have a smaller absolute value than the first distance F, and wherein $f0_{AB}$ and $F0_{CD}$ are equal or different to one another.

**5.** The method any of claims 1-3, wherein the targets A, B, C and D are disposed along a substantially straight line.

**6.** The method of claim 5, wherein the target B is disposed between the target A and the target C and the target C is disposed between the target B and the target D.

**7.** The method of any of claims 1-3, wherein the targets A, B, C and D are disposed in a two dimensional configuration.

**8.** The method of claim 7, wherein the targets A and B are disposed along a first axis, the targets C and D are disposed along a second axis, and the first axis and the second axis are substantially parallel.

**9.** The method of any of claims 1-8, the method further comprising:

producing an additional target E, the additional target E including a portion of the first (204a-c) and second (202a-c) structures with an offset Y there between;
illuminating the additional target E with electromagnetic radiation to obtain spectra $S_E$; and
wherein the determining any overlay error is further based on the spectrum $S_E$.

**10.** The method of any of claims 1-9, wherein obtaining the spectra $S_A$, $S_B$, $S_C$, and $S_D$ comprises acquiring radiation from the targets A, B, C, and D using an optical apparatus.

**11.** The method of claim 10, wherein the optical apparatus is an imaging reflectometer.

**12.** The method of claim 10, wherein the optical apparatus is an imaging spectroscopic reflectometer.

**13.** The method of claim 10, wherein the optical apparatus is a polarized spectroscopic imaging reflectometer, wherein each spectra $S_A$, $S_B$, $S_C$, and $S_D$ is in the form of a polarization component of reflected or scattered light.

**14.** The method of claim 10, wherein the optical apparatus is a scanning reflectometer system.

**15.** The method of claim 10, wherein the optical apparatus is a system with two or more reflectometers capable of parallel data acquisition.

**16.** The method of claim 10, wherein the optical apparatus is a system with two or more spectroscopic reflectometers capable of parallel data acquisition.

**17.** The method of claim 10, wherein the optical apparatus is a system with two or more polarized spectroscopic reflectometers capable of parallel data acquisition.

**18.** The method of claim 10, wherein the optical apparatus is a system with two or more polarized spectroscopic reflectometers capable of serial data acquisition without moving the wafer stage or moving any optical elements or the reflectometer stage.

**19.** The method of claim 10, wherein the optical apparatus is an imaging spectrometer.

**20.** The method of claim 10, wherein the optical apparatus is an imaging system with a wavelength filter (520, 542).

**21.** The method of claim 20, wherein the optical apparatus is an imaging system with a long-pass wavelength filter.

**22.** The method of claim 20, wherein the optical apparatus is an imaging system with a short-pass wavelength filter.

**23.** The method of claim 10, wherein the optical apparatus is an interferometric imaging system.

**24.** The method of claim 10, wherein the optical apparatus is an imaging ellipsometer.

**25.** The method of claim 10, wherein the optical apparatus is an imaging spectroscopic ellipsometer.

**26.** The method of claim 10, wherein the optical apparatus is a scanning ellipsometer system.

**27.** The method of claim 10, wherein the optical apparatus is a system with a plurality of ellipsometers capable of parallel data acquisition.

**28.** The method of claim 10, wherein the optical apparatus is a system with a plurality of ellipsometers capable of serial data acquisition without moving the wafer stage or moving any optical elements or the ellipsometer stage.

**29.** The method of claim 10, wherein the optical apparatus is a Michelson interferometer.

**30.** The method of claim 10, wherein the optical apparatus is a Mach-Zehnder interferometer.

**31.** The method of claim 10, wherein the optical apparatus is a Sagnac interferometer.

**32.** The method of claim 10, wherein the optical apparatus is a system comprising a spectroscopic normal incidence reflectometer and an oblique incidence spectroscopic ellipsometer.

**33.** The method of claim 10, wherein the optical apparatus is a system comprising a spectroscopic normal incidence polarized reflectometer and an oblique incidence spectroscopic ellipsometer.

**34.** The method of claim 10, wherein the optical apparatus is a system comprising a spectroscopic normal incidence polarized differential reflectometer and an oblique incidence spectroscopic ellipsometer.

**35.** The method of claim 10, wherein the optical apparatus is a system comprising a spectroscopic near-normal incidence polarized differential reflectometer and an oblique incidence spectroscopic ellipsometer.

**36.** The method of claim 10, wherein the optical apparatus is a system comprising a spectroscopic normal incidence reflectometer and a spectroscopic oblique incidence polarized differential reflectometer.

**37.** The method of claim 10, wherein the optical apparatus is a system comprising a spectroscopic normal incidence polarized reflectometer and a spectroscopic oblique incidence polarized differential reflectometer.

**38.** The method of claim 10, wherein the optical apparatus is a system comprising a spectroscopic normal incidence polarized differential reflectometer and a spectroscopic oblique incidence polarized differential reflectometer.

**39.** The method of claim 10, wherein the optical apparatus is a system comprising a spectroscopic near-normal incidence polarized differential reflectometer and a spectroscopic oblique incidence polarized differential reflectometer.

**40.** The method of any of claims 1-10, wherein at least one of the spectra $S_A$, $S_B$, $S_C$, and $S_D$ comprises electromagnetic radiation that is unpolarized or selectively polarized or selectively analyzed.

41. The method of any of claims 1-10, wherein at least one of the spectra $S_A$, $S_B$, $S_C$, and $S_D$ comprises electromagnetic radiation that is unpolarized reflected light, polarized light with the electric field substantially parallel to a symmetry axis of at least one set of structures of at least one of the targets A, B, C or D, polarized light with the electric field substantially perpendicular to a symmetry axis of at least one set of structures of at least one of the targets A, B, C or D, polarized light with the electric field at an angle with respect to a symmetry axis of at least one set of structures of at least one of the targets A, B, C or D, right-hand circularly polarized radiation, or left-hand circularly polarized radiation.

42. The method of claim 3, wherein the properties P1 and P2 of the difference spectra D1 and D2 each are selected from a group consisting of light noise, stability, drift, spectral characteristics, and light level.

43. The method of any of claims 1-42, wherein the illuminating the targets A, B, C and D with electromagnetic radiation takes place substantially at different times such that the corresponding spectra $S_A$, $S_B$, $S_C$, and $S_D$ are obtained at substantially different times.

44. The method of any of claims 1-42, wherein the illuminating the targets A, B, C and D with electromagnetic radiation takes place substantially simultaneously such that the corresponding spectra $S_A$, $S_B$, $S_C$, and $S_D$ are produced substantially simultaneously.

45. The method of any of claims 1-42, wherein the illuminating the targets A, B, C and D with electromagnetic radiation takes place substantially simultaneously for at least two of the targets A, B, C and D.

46. The method of claim 3, wherein determining the properties P1 and P2 comprises obtaining or processing one or more of radiation characteristics of the difference spectra D1 and D2, respectively, selected from a group consisting of intensity, spectral intensity of diffracted radiation, R(lambda) of different radiation, spectral intensity of transverse electric field polarization R(Te, lambda), spectral intensity of transverse magnetic field polarization R(Tm, lambda), spectral intensity of S-polarization reflectivity Rs (lambda), spectral intensity of P-polarization, reflectivity Rp(lambda), optical phase, wavelength, diffraction angle, spectroscopic ellipsometry parameters, alpha, beta, cos(delta), and tan(psi).

47. The method of claim 19, wherein an illumination and imaging NA's of the spectroscopic imaging system are chosen to optimize the performance of the instrument on scattering structures by ensuring that only the zero'th diffraction order is collected.

48. The method of claim 47, wherein the spectroscopic imaging system is an imaging spectroscopic ellipsometer.

49. The method of any of claims 1-10, wherein obtaining the spectra $S_A$, $S_B$, $S_C$, and $S_D$ comprises acquiring an image from the targets A, B, C, and D using an imaging apparatus having a wavelength filter, and wherein the spectra $S_A$, $S_B$, $S_C$, and $S_D$ are an averaged or summed one or more intensity value(s) of one or more pixels of the corresponding target image, the method further comprising selecting a wavelength using the wavelength filter such that contrast between the $S_A$, $S_B$, $S_C$, and $S_D$ is maximized.

50. The method of claim 49, further comprising analyzing the images of the targets to detect defects in the sample.

51. The method of any of claims 1-9, wherein obtaining the spectra $S_A$, $S_B$, $S_C$, and $S_D$ comprises acquiring radiation from the targets A, B, C, and D using an optical apparatus, wherein the radiation is acquired at simultaneous, multiple angles of illumination.

52. The method of claim 19, further comprising focusing the optical tool only for illuminating a one of the targets A, B, C, and D and not refocusing the optical tool for illuminating the other three of the targets A, B, C, and D.

53. The method of any of claims 1-52, wherein at least one of the targets A, B, C, and D includes an imaging overlay metrology type target, and the method further comprises measuring a second overlay error on the imaging overlay metrology type target.

54. The method of claim 53, wherein the obtained spectra $S_A$, $S_B$, $S_C$, and $S_D$ are images and are also used to perform the overlay error measurement of the imaging overlay metrology type target.

**55.** The method of claim 53, wherein the first overlay is determined simultaneously with measurement of the second overlay error.

**56.** A system for determining overlay between a plurality of first structures (204a-c) in a first layer of a sample and a plurality of second structures (202a-c) in a second layer of the sample, comprising:

a scatterometry module;
a processor; and

a target arrangement comprising:

a plurality of targets A, B, C and D that each include a portion of the first and second structures (202a-c);
wherein the portion of the second structure of target A has a predetermined offset Xa with respect to the portion of the first structure of target A;
wherein the portion of the second structure of target B has a predetermined offset Xb with respect to the portion of the first structure of target B;
wherein the portion of the second structure of target C has a predetermined offset Xc with respect to the portion of the first structure of target C;
wherein the portion of the second structure of target D has a predetermined offset Xd with respect to the portion of the first structure of target D;
wherein each of the offsets Xa, Xb, Xc and Xd is different from zero, Xa is in the opposite direction and differs from Xb, and Xc is in the opposite direction and differs from Xd;
wherein the scatterometry module is adapted to illuminate the plurality of targets A, B, C and D with electromagnetic radiation to obtain spectra $S_A$, $S_B$, $S_C$, and $S_D$ from targets A, B, C, and D, respectively; and
wherein the processor is adapted to determine any overlay error between the first structures (204a-c) and the second structures (202a-c) using only the obtained spectra $S_A$, $S_B$, $S_C$, and $S_D$ and the predetermined offsets Xa, Xb, Xc and Xd in a linear approximation technique.

**57.** The system of claim 56, wherein the processor is further adapted to:

determine a difference spectrum D1 from the spectra $S_A$ and $S_B$;
determine a difference spectrum D2 from the spectra $S_C$ and $S_D$; and
determine any overlay error by performing a linear approximation technique based on the difference spectra D1 and D2.

**58.** The system as recited in claim 57, wherein the linear approximation technique is based on a property P1 of the difference spectrum D1 and a property P2 of the difference spectrum D2.

**59.** The system of any claims 56-58, wherein the targets A, B, C and D are disposed along a substantially straight line.

**60.** The system of claim 59, wherein the target B is disposed between the target A and the target C and the target C is disposed between the target B and the target D.

**61.** The system of any claims 56-58, wherein the targets A, B, C and D are disposed in a two dimensional configuration.

**62.** The system of claim 61, wherein the targets A and B are disposed along a first axis, the targets C and D are disposed along a second axis, and the first axis and the second axis are substantially parallel.

**63.** The system of any claims 56-62, wherein the processor is further adapted to:

produce an additional target E, the additional target E including a portion of the first and second structures (202a-c) with an offset Y there between;
illuminate the additional target E with electromagnetic radiation to obtain spectra $S_E$; and
wherein the determining any overlay error is further based on the spectrum $S_E$.

**64.** The system of any claims 56-63, wherein the scatterometry module is an optical apparatus.

**65.** The system of claim 64, wherein the optical apparatus is an imaging reflectometer.

**66.** The system of claim 64, wherein the optical apparatus is an imaging spectroscopic reflectometer.

**67.** The system of claim 64, wherein the optical apparatus is a polarized spectroscopic imaging reflectometer, wherein each spectra $S_A$, $S_B$, $S_C$, and $S_D$ is in the form of a polarization component of reflected or scattered light.

**68.** The system of claim 64, wherein the optical apparatus is a scanning reflectometer system.

**69.** The method of claim 64, wherein the optical apparatus is a system with two or more reflectometers capable of parallel data acquisition.

**70.** The system of claim 64, wherein the optical apparatus is a system with two or more spectroscopic reflectometers capable of parallel data acquisition.

**71.** The system of claim 64, wherein the optical apparatus is a system with two or more polarized spectroscopic reflectometers capable of parallel data acquisition.

**72.** The system of claim 64, wherein the optical apparatus is a system with two or more polarized spectroscopic reflectometers capable of serial data acquisition without moving the wafer stage or moving any optical elements or the reflectometer stage.

**73.** The system of claim 64, wherein the optical apparatus is an imaging spectrometer.

**74.** The system of claim 64, wherein the optical apparatus is an imaging system with a wavelength filter (520, 542).

**75.** The system of claim 74, wherein the optical apparatus is an imaging system with a long-pass wavelength filter.

**76.** The system of claim 74, wherein the optical apparatus is an imaging system with a short-pass wavelength filter.

**77.** The system of claim 64, wherein the optical apparatus is an interferometric imaging system.

**78.** The system of claim 64, wherein the optical apparatus is an imaging ellipsometer.

**79.** The system of claim 64, wherein the optical apparatus is an imaging spectroscopic ellipsometer.

**80.** The system of claim 64, wherein the optical apparatus is a scanning ellipsometer system.

**81.** The system of claim 64, wherein the optical apparatus is a system with a plurality of ellipsometers capable of parallel data acquisition.

**82.** The system of claim 64, wherein the optical apparatus is a system with a plurality of ellipsometers capable of serial data acquisition without moving the wafer stage or moving any optical elements or the ellipsometer stage.

**83.** The system of claim 64, wherein the optical apparatus is a Michelson interferometer.

**84.** The system of claim 64, wherein the optical apparatus is a Mach-Zehnder interferometer.

**85.** The system of claim 64, wherein the optical apparatus is a Sagnac interferometer.

**86.** The system of claim 64, wherein the optical apparatus is a system comprising a spectroscopic normal incidence reflectometer and an oblique incidence spectroscopic ellipsometer.

**87.** The system of claim 64, wherein the optical apparatus is a system comprising a spectroscopic normal incidence polarized reflectometer and an oblique incidence spectroscopic ellipsometer.

**88.** The system of claim 64, wherein the optical apparatus is a system comprising a spectroscopic normal incidence polarized differential reflectometer and an oblique incidence spectroscopic ellipsometer.

**89.** The system of claim 64, wherein the optical apparatus is a system comprising a spectroscopic near-normal incidence polarized differential reflectometer and an oblique incidence spectroscopic ellipsometer.

90. The system of claim 64, wherein the optical apparatus is a system comprising a spectroscopic normal incidence reflectometer and a spectroscopic oblique incidence polarized differential reflectometer.

91. The system of claim 64, wherein the optical apparatus is a system comprising a spectroscopic normal incidence polarized reflectometer and a spectroscopic oblique incidence polarized differential reflectometer.

92. The system of claim 64, wherein the optical apparatus is a system comprising a spectroscopic normal incidence polarized differential reflectometer and a spectroscopic oblique incidence polarized differential reflectometer.

93. The system of claim 64, wherein the optical apparatus is a system comprising a spectroscopic near-normal incidence polarized differential reflectometer and a spectroscopic oblique incidence polarized differential reflectometer.

94. The system of any claims 56-64, wherein at least one of the spectra $S_A$, $S_B$, $S_C$, and $S_D$ comprises electromagnetic radiation that is unpolarized or selectively polarized or selectively analyzed.

95. The system of any claims 56-64, wherein at least one of the spectra $S_A$, $S_B$, $S_C$, and $S_D$ comprises electromagnetic radiation that is unpolarized reflected light, polarized light with the electric field substantially parallel to a symmetry axis of at least one set of structures of at least one of the targets A, B, C or D, polarized light with the electric field substantially perpendicular to a symmetry axis of at least one set of structures of at least one of the targets A, B, C or D, polarized light with the electric field at an angle with respect to a symmetry axis of at least one set of structures of at least one of the targets A, B, C or D, right-hand circularly polarized radiation, or left-hand circularly polarized radiation.

96. The system of claim 58, wherein the properties P1 and P2 of the difference spectra D1 and D2 each are selected from a group consisting of light noise, stability, drift, spectral characteristics, and light level.

97. The system of any claims 56-96, wherein the scatterometry module is further adapted to illuminate the targets A, B, C and D with electromagnetic radiation substantially at different times such that the corresponding spectra $S_A$, $S_B$, $S_C$, and $S_D$ are obtained at substantially different times.

98. The system of any claims 56-96, wherein the scatterometry module is further adapted to illuminate the targets A, B, C and D with electromagnetic radiation substantially simultaneously such that the corresponding spectra $S_A$, $S_B$, $S_C$, and $S_D$ are produced substantially simultaneously.

99. The system of any claims 56-96 wherein the scatterometry module is further adapted to illuminate the targets A, B, C and D with electromagnetic radiation substantially simultaneously for at least two of the targets A, B, C and D.

100. The system of claim 58, wherein the processor is further adapted to determine the properties P1 and P2 by obtaining or processing one or more of radiation characteristics of the difference spectra D1 and D2, respectively, selected from a group consisting of intensity, spectral intensity of diffracted radiation, R(lambda) of different radiation, spectral intensity of transverse electric field polarization R(Te, lambda), spectral intensity of transverse magnetic field polarization R(Tm, lambda), spectral intensity of S-polarization reflectivity Rs (lambda), spectral intensity of P-polarization, reflectivity Rp(lambda), optical phase, wavelength, diffraction angle, spectroscopic ellipsometry parameters, alpha, beta, cos(delta), and tan(psi).

101. The system of claim 73, wherein an illumination and imaging NA's of the spectroscopic imaging system are chosen to optimize the performance of the instrument on scattering structures by ensuring that only the zero'th diffraction order is collected.

102. The system of claim 101, wherein the spectroscopic imaging system is an imaging spectroscopic ellipsometer.

103. The system of any claims 56-64, wherein the scatterometry module is further adapted to illuminate a plurality of targets A, B, C and D with electromagnetic radiation to obtain spectra $S_A$, $S_B$, $S_C$, and $S_D$ from targets A, B, C, and D, respectively, by (i) acquiring an image from the targets A, B, C, and D using an imaging apparatus having a wavelength filter, and wherein the spectra $S_A$, $S_B$, $S_C$, and $S_D$ are an averaged or summed one or more intensity value(s) of one or more pixels of the corresponding target image and (ii) selecting a wavelength using the wavelength filter such that contrast between the $S_A$, $S_B$, $S_C$, and $S_D$ is maximized.

104. The system of claim 103, wherein the processor is further adapted to analyze the images of the targets to detect defects in the sample.

105. The system of any claims 56-63, wherein the scatterometry module is an optical apparatus, wherein the radiation is acquired at simultaneous, multiple angles of illumination.

106. The system of claim 73, wherein the processor is further adapted to focus the optical tool only for illuminating a one of the targets A, B, C, and D and not refocusing the optical tool for illuminating the other three of the targets A, B, C, and D.

107. The system of any claims 56-106, wherein at least one of the targets A, B, C, and D includes an imaging overlay metrology type target, and the processor is further adapted to determine a second overlay error based on the imaging overlay metrology type target.

108. The system of claim 107, wherein the obtained spectra $S_A$, $S_B$, $S_C$, and $S_D$ are images and the processor is further adapted to determine the second overlay error using obtained spectra $S_A$, $S_B$, $S_C$, and $S_D$.

109. The system of claim 107, wherein the processor is further adapted to determine the first overlay simultaneously with determination of the second overlay error.

110. The system of claim 107, wherein the scatterometry module is a +/-1 st order diffraction scatterometer.

111. The system of claim 56 further comprising:

> an imaging overlay measurement type target E from which a second overlay error may be determined using imaging overlay metrology.

## Patentansprüche

1. Verfahren zum Erkennen von Overlay zwischen einer Vielzahl von ersten Strukturen (204a-c) in einer ersten Schicht einer Probe und einer Vielzahl von zweiten Strukturen (202a-c) in einer zweiten Schicht der Probe, wobei das Verfahren Folgendes umfasst:

> Bereitstellen einer Vielzahl von Zielen A, B, C und D, die jeweils einen Teil der ersten (204a-c) und zweiten (202a-c) Strukturen beinhaltet,
> wobei der Teil der zweiten Struktur von Ziel A einen zuvor festgelegten Versatz Xa in Bezug auf den Teil der ersten Struktur von Ziel A aufweist,
> wobei der Teil der zweiten Struktur von Ziel B einen zuvor festgelegten Versatz Xb in Bezug auf den Teil der ersten Struktur von Ziel B aufweist,
> wobei der Teil der zweiten Struktur von Ziel C einen zuvor festgelegten Versatz Xc in Bezug auf den Teil der ersten Struktur von Ziel C aufweist,
> wobei der Teil der zweiten Struktur von Ziel D einen zuvor festgelegten Versatz Xd in Bezug auf den Teil der ersten Struktur von Ziel D aufweist,
> wobei sich jeder der zuvor festgelegten Versatze Xa, Xb, Xc und Xd von Null unterscheidet, Xa in der gegenüberliegenden Richtung ist und sich von Xb unterscheidet, und Xc in der gegenüberliegenden Richtung ist und sich von Xd unterscheidet;
> Beleuchten der Ziele A, B, C und D mit elektromagnetischer Strahlung, um jeweilige Spektren $S_A$, $S_B$, Sc und $S_D$ von den Zielen A, B, C und D zu erhalten; und
> Erkennen eines Overlay-Fehlers zwischen den ersten Strukturen (204a-c) und den zweiten Strukturen (202a-c) lediglich durch Verwendung der erhaltenen Spektren $S_A$, $S_B$, Sc und $S_D$ und der zuvor festgelegten Versatze Xa, Xb, Xc und Xd in einer Technik der linearen Approximation.

2. Verfahren nach Anspruch 1, wobei das Erkennen eines Overlay-Fehlers Folgendes umfasst:

> Erkennen eines Differenzspektrums D1 aus den Spektren $S_A$ und $S_B$;

Erkennen eines Differenzspektrums D2 aus den Spektren Sc und $S_D$;
Erkennen eines Overlay-Fehlers durch Durchführen einer Technik der linearen Approximation basierend auf den Differenzspektren D1 und D2.

3. Verfahren nach Anspruch 2, wobei die Technik der linearen Approximation auf einer Eigenschaft P1 des Differenzspektrums D1 und einer Eigenschaft P2 des Differenzspektrums D2 basiert.

4. Verfahren nach einem der Ansprüche 1-3, wobei jedes der Ziele A, B, C und D eine Gitterstruktur Ga1 mit periodischen Strukturen mit einer Periode Ta1, die zumindest teilweise in der ersten Schicht angeordnet ist, und eine Gitterstruktur Ga2 mit periodischen Strukturen mit einer Periode Ta2, die zumindest teilweise in der zweiten Schicht angeordnet ist, umfasst, wobei die erste Periode Ta1 und die zweite Periode Ta2 im Wesentlichen identisch sind, und wobei (i) der zuvor festgelegte Versatz Xa die Strukturen mit der Periode Ta1 des Gitters Ga1 in Bezug auf die Strukturen mit der Periode Ta2 der Gitterstruktur Ga2 um eine Summe eines positiven ersten Abstands, +F, und zweiten positiven Abstands $f0_{AB}$ versetzt, (ii) der Versatz Xb gestaltet ist, um die Strukturen mit der Periode Ta1 des Gitters Ga1 in Bezug auf die Strukturen mit der Periode Ta2 der Gitterstruktur Ga2 um eine Summe eines negativen ersten Abstands, -F, und eines zweiten positiven Abstands $f0_{AB}$ zu versetzen, (iii) der Versatz Xc gestaltet ist, um die Strukturen mit der Periode Ta1 des Gitters Ga1 in Bezug auf die Strukturen mit der Periode Ta2 der Gitterstruktur Ga2 um eine Summe des positiven ersten Abstands, +F, und eines negativen zweiten Abstands, $-F0_{CD}$, zu versetzen, und (iv) der Versatz Xd gestaltet ist, um die Strukturen mit der Periode Ta1 des Gitters Ga1 in Bezug auf die Strukturen mit der Periode Ta2 der Gitterstruktur Ga2 um eine Summe des negativen ersten Abstands, -F, und des zweiten negativen Abstands, $-F0_{CD}$, zu versetzen, wobei die zweiten Abstände $f0_{AB}$ und $f0_{CD}$ einen kleineren absoluten Wert aufweisen als der erste Abstand F, und wobei $f0_{AB}$ und $f0_{CD}$ gleich sind oder sich voneinander unterscheiden.

5. Verfahren nach einem der Ansprüche 1-3, wobei die Ziele A, B, C und D entlang einer im Wesentlichen geraden Linie angeordnet sind.

6. Verfahren nach Anspruch 5, wobei das Ziel B zwischen dem Ziel A und dem Ziel C angeordnet ist und das Ziel C zwischen dem Ziel B und dem Ziel D angeordnet ist.

7. Verfahren nach einem der Ansprüche 1-3, wobei die Ziele A, B, C und D in einer zweidimensionalen Konfiguration angeordnet sind.

8. Verfahren nach Anspruch 7, wobei die Ziele A und B entlang einer ersten Achse angeordnet sind, die Ziele C und D entlang einer zweiten Achse angeordnet sind, und die erste Achse und die zweite Achse im Wesentlichen parallel sind.

9. Verfahren nach einem der Ansprüche 1-8, wobei das Verfahren weiter Folgendes umfasst:

Produzieren eines zusätzlichen Ziels E, wobei das zusätzliche Ziel E einen Teil der ersten (204a-c) und zweiten (202a-c) Strukturen mit einem Versatz Y dazwischen enthält;
Beleuchten des zusätzlichen Ziels E mit elektromagnetischer Strahlung, um Spektren $S_E$ zu erhalten; und wobei das Erkennen eines Overlay-Fehlers weiter auf dem Spektrum $S_E$ basiert.

10. Verfahren nach einem der Ansprüche 1-9, wobei das Erhalten der Spektren $S_A$, $S_B$, Sc und $S_D$ das Erfassen von Strahlung von den Zielen A, B, C und D unter Verwendung einer optischen Vorrichtung umfasst.

11. Verfahren nach Anspruch 10, wobei die optische Vorrichtung ein Bildgebungsreflektometer ist.

12. Verfahren nach Anspruch 10, wobei die optische Vorrichtung ein spektroskopisches Bildgebungsreflektometer ist.

13. Verfahren nach Anspruch 10, wobei die optische Vorrichtung ein polarisiertes spektroskopisches Bildgebungsreflektometer ist, wobei jedes Spektrum $S_A$, $S_B$, Sc und $S_D$ in der Form einer Polarisierungskomponente an reflektiertem oder verstreutem Licht ist.

14. Verfahren nach Anspruch 10, wobei die optische Vorrichtung ein Scanreflektometersystem ist.

15. Verfahren nach Anspruch 10, wobei die optische Vorrichtung ein System mit zwei oder mehreren Reflektometern ist, die zu paralleler Datenerfassung in der Lage sind.

16. Verfahren nach Anspruch 10, wobei die optische Vorrichtung ein System mit zwei oder mehreren spektroskopischen Reflektometern ist, die zu paralleler Datenerfassung in der Lage sind.

17. Verfahren nach Anspruch 10, wobei die optische Vorrichtung ein System mit zwei oder mehreren polarisierten spektroskopischen Reflektometern ist, die zu paralleler Datenerfassung in der Lage sind.

18. Verfahren nach Anspruch 10, wobei die optische Vorrichtung ein System mit zwei oder mehreren polarisierten spektroskopischen Reflektometern ist, die zu serieller Datenerfassung in der Lage sind, ohne die Waferstufe zu bewegen oder optische Elemente oder die Reflektometerstufe zu bewegen.

19. Verfahren nach Anspruch 10, wobei die optische Vorrichtung ein Bildgebungsspektrometer ist.

20. Verfahren nach Anspruch 10, wobei die optische Vorrichtung ein Bildgebungssystem mit einem Wellenlängenfilter (520, 542) ist.

21. Verfahren nach Anspruch 20, wobei die optische Vorrichtung ein Bildgebungssystem mit einem Langpasswellenlängenfilter ist.

22. Verfahren nach Anspruch 20, wobei die optische Vorrichtung ein Bildgebungssystem mit einem Kurzpasswellenlängenfilter ist.

23. Verfahren nach Anspruch 10, wobei die optische Vorrichtung ein interferometrisches Bildgebungssystem ist.

24. Verfahren nach Anspruch 10, wobei die optische Vorrichtung ein Bildgebungsellipsometer ist.

25. Verfahren nach Anspruch 10, wobei die optische Vorrichtung ein spektroskopisches Bildgebungsellipsometer ist.

26. Verfahren nach Anspruch 10, wobei die optische Vorrichtung ein Scanellipsometersystem ist.

27. Verfahren nach Anspruch 10, wobei die optische Vorrichtung ein System mit einer Vielzahl von Ellipsometern ist, die zu paralleler Datenerfassung in der Lage ist.

28. Verfahren nach Anspruch 10, wobei die optische Vorrichtung ein System mit einer Vielzahl von Ellipsometern ist, die zu serieller Datenerfassung in der Lage ist, ohne die Waferstufe zu bewegen oder optische Elemente oder die Ellipsometerstufe zu bewegen.

29. Verfahren nach Anspruch 10, wobei die optische Vorrichtung ein Michelson-Interferometer ist.

30. Verfahren nach Anspruch 10, wobei die optische Vorrichtung ein Mach-Zehnder-Interferometer ist.

31. Verfahren nach Anspruch 10, wobei die optische Vorrichtung ein Sagnac-Interferometer ist.

32. Verfahren nach Anspruch 10, wobei die optische Vorrichtung ein System ist, das ein spektroskopisches Reflektometer mit senkrechtem Einfall und ein spektroskopisches Ellipsometer mit schrägem Einfall umfasst.

33. Verfahren nach Anspruch 10, wobei die optische Vorrichtung ein System ist, das ein spektroskopisches polarisiertes Reflektometer mit senkrechtem Einfall und ein spektroskopisches Ellipsometer mit schrägem Einfall umfasst.

34. Verfahren nach Anspruch 10, wobei die optische Vorrichtung ein System ist, das ein spektroskopisches polarisiertes Differentialreflektometer mit senkrechtem Einfall und ein spektroskopisches Ellipsometer mit schrägem Einfall umfasst.

35. Verfahren nach Anspruch 10, wobei die optische Vorrichtung ein System ist, das ein spektroskopisches polarisiertes Differentialreflektometer mit nahezu senkrechtem Einfall und ein spektroskopisches Ellipsometer mit schrägem Einfall umfasst.

**36.** Verfahren nach Anspruch 10, wobei die optische Vorrichtung ein System ist, das ein spektroskopisches Reflektometer mit senkrechtem Einfall und ein spektroskopisches polarisiertes Differentialellipsometer mit schrägem Einfall umfasst.

**37.** Verfahren nach Anspruch 10, wobei die optische Vorrichtung ein System ist, das ein spektroskopisches polarisiertes Reflektometer mit senkrechtem Einfall und ein spektroskopisches polarisiertes Differentialreflektometer mit schrägem Einfall umfasst.

**38.** Verfahren nach Anspruch 10, wobei die optische Vorrichtung ein System ist, das ein spektroskopisches polarisiertes Differentialreflektometer mit senkrechtem Einfall und ein spektroskopisches polarisiertes Differentialreflektometer mit schrägem Einfall umfasst.

**39.** Verfahren nach Anspruch 10, wobei die optische Vorrichtung ein System ist, das ein spektroskopisches polarisiertes Differentialreflektometer mit nahezu senkrechtem Einfall und ein spektroskopisches polarisiertes Differentialreflektometer mit schrägem Einfall umfasst.

**40.** Verfahren nach einem der Ansprüche 1-10, wobei mindestens eines der Spektren $S_A$, $S_B$, Sc und $S_D$ elektromagnetische Strahlung umfasst, die unpolarisiert oder selektiv polarisiert oder selektiv analysiert ist.

**41.** Verfahren nach einem der Ansprüche 1-10, wobei mindestens eines der Spektren $S_A$, $S_B$, Sc und $S_D$ elektromagnetische Strahlung umfasst, die unpolarisiertes reflektiertes Licht, polarisiertes Licht, wobei das elektrische Feld im Wesentlichen parallel zu einer Symmetrieachse von mindestens einem Satz an Strukturen von mindestens einem der Ziele A, B, C oder D ist, polarisiertes Licht, wobei das elektrische Feld im Wesentlichen senkrecht zu einer Symmetrieachse von mindestens einem Satz an Strukturen von mindestens einem der Ziele A, B, C oder D ist, polarisiertes Licht, wobei das elektrische Feld in einem Winkel in Bezug auf eine Symmetrieachse von mindestens einem Satz an Strukturen von mindestens einem der Ziele A, B, C oder D ist, rechts zirkularpolarisierte Strahlung oder links zirkularpolarisierte Strahlung ist.

**42.** Verfahren nach Anspruch 3, wobei die Eigenschaften P1 und P2 der Differenzspektren D1 und D2 jeweils aus einer Gruppe ausgewählt sind, die aus Lichtrauschen, Stabilität, Abdrift, spektralen Eigenschaften und Lichtstärke besteht.

**43.** Verfahren nach einem der Ansprüche 1-42, wobei das Beleuchten der Ziele A, B, C und D mit elektromagnetischer Strahlung im Wesentlichen zu unterschiedlichen Zeiten stattfindet, sodass die entsprechenden Spektren $S_A$, $S_B$, Sc und $S_D$ zu im Wesentlichen unterschiedlichen Zeiten erhalten werden.

**44.** Verfahren nach einem der Ansprüche 1-42, wobei das Beleuchten der Ziele A, B, C und D mit elektromagnetischer Strahlung im Wesentlichen simultan stattfindet, sodass die entsprechenden Spektren $S_A$, $S_B$, Sc und $S_D$ im Wesentlichen simultan produziert werden.

**45.** Verfahren nach einem der Ansprüche 1-42, wobei das Beleuchten der Ziele A, B, C und D mit elektromagnetischer Strahlung für mindestens zwei der Ziele A, B, C und D im Wesentlichen simultan stattfindet.

**46.** Verfahren nach Anspruch 3, wobei das Erkennen der Eigenschaften P1 und P2 den Erhalt oder die Verarbeitung von einer oder mehreren Strahlungseigenschaften der jeweiligen Differenzspektren D1 und D2 umfasst, ausgewählt aus einer Gruppe, die aus Intensität, spektraler Intensität der abgelenkten Strahlung, R(lambda) der unterschiedlichen Strahlung, der spektralen Intensität der transversalen elektrischen Feldpolarisierung R(Te, lambda), der spektralen Intensität der transversalen Magnetfeldpolarisierung R(Tm, lambda), der spektralen Intensität der S-Polarisierungsreflektivität Rs (lambda), der spektralen Intensität der P-Polarisierung, Reflektivität Rp(lambda), optischer Phase, Wellenlänge, Beugungswinkel, spektroskopischen Ellipsometrieparametern, alpha, beta, cos(delta) und tan(psi) besteht.

**47.** Verfahren nach Anspruch 19, wobei Beleuchtungs- und Bildgebungs-NAs des spektroskopischen Bildgebungssystems ausgewählt sind, um die Leistung des Instruments auf Streustrukturen zu optimieren, indem sichergestellt wird, dass nur die nullte Beugungsordnung erfasst wird.

**48.** Verfahren nach Anspruch 47, wobei das spektroskopische Bildgebungssystem ein spektroskopisches Bildgebungsellipsometer ist.

**49.** Verfahren nach einem der Ansprüche 1-10, wobei der Erhalt der Spektren $S_A$, $S_B$, Sc und $S_D$ den Erwerb eines Bildes von den Zielen A, B, C und D durch Verwenden einer Bildgebungsvorrichtung mit einem Wellenlängenfilter umfasst, und wobei die Spektren $S_A$, $S_B$, Sc und $S_D$ ein oder mehrere gemittelte oder summierte Intensitätswert(e) von einem oder mehreren Pixeln des entsprechenden Zielbildes sind, wobei das Verfahren weiter das Auswählen einer Wellenlänge durch Verwenden des Wellenlängenfilters umfasst, sodass der Kontrast zwischen $S_A$, $S_B$, $S_C$ und $S_D$ maximiert wird.

**50.** Verfahren nach Anspruch 49, weiter umfassend das Analysieren der Bilder der Ziele, um Fehler in der Probe zu erkennen.

**51.** Verfahren nach einem der Ansprüche 1-9, wobei das Erhalten der Spektren $S_A$, $S_B$, Sc und $S_D$ die Erfassung von Strahlung von den Zielen A, B, C und D durch Verwenden einer optischen Vorrichtung umfasst, wobei die Strahlung an simultanen, mehreren Beleuchtungswinkeln erfasst wird.

**52.** Verfahren nach Anspruch 19, weiter umfassend das Fokussieren des optischen Werkzeugs, um nur eines der Ziele A, B, C und D zu beleuchten und das Nicht-Refokussieren des optischen Werkzeugs, um die anderen drei von den Zielen A, B, C und D zu beleuchten.

**53.** Verfahren nach einem der Ansprüche 1-52, wobei mindestens eines der Ziele A, B, C und D ein Bildgebungs-Overlay-Metrologietypziel beinhaltet, und wobei das Verfahren weiter das Messen eines zweiten Overlay-Fehlers auf dem Bildgebungs-Overlay-Metrologietypziel umfasst.

**54.** Verfahren nach Anspruch 53, wobei die erhaltenen Spektren $S_A$, $S_B$, Sc und $S_D$ Bilder sind und auch verwendet werden, um die Overlay-Fehlermessung des Bildgebungs-Overlay-Metrologietypziels durchzuführen.

**55.** Verfahren nach Anspruch 53, wobei der erste Overlay simultan mit der Messung des zweiten Overlay-Fehlers erkannt wird.

**56.** System zum Erkennen von Overlay zwischen einer Vielzahl von ersten Strukturen (204a-c) in einer ersten Schicht einer Probe und einer Vielzahl von zweiten Strukturen (202a-c) in einer zweiten Schicht der Probe, umfassend:

ein Scatterometriemodul;
einen Prozessor; und
eine Zielanordnung, umfassend:

eine Vielzahl von Zielen A, B, C und D, die jeweils einen Teil der ersten und zweiten (202a-c) Strukturen (202a-c) beinhaltet,
wobei der Teil der zweiten Struktur von Ziel A einen zuvor festgelegten Versatz Xa in Bezug auf den Teil der ersten Struktur von Ziel A aufweist;
wobei der Teil der zweiten Struktur von Ziel B einen zuvor festgelegten Versatz Xb in Bezug auf den Teil der ersten Struktur von Ziel B aufweist;
wobei der Teil der zweiten Struktur von Ziel C einen zuvor festgelegten Versatz Xc in Bezug auf den Teil der ersten Struktur von Ziel C aufweist;
wobei der Teil der zweiten Struktur von Ziel D einen zuvor festgelegten Versatz Xd in Bezug auf den Teil der ersten Struktur von Ziel D aufweist;
wobei sich jeder der Versatze Xa, Xb, Xc und Xd von Null unterscheidet, Xa in der gegenüberliegenden Richtung ist und sich von Xb unterscheidet, und Xc in der gegenüberliegenden Richtung ist und sich von Xd unterscheidet;
wobei das Scatterometriemodul angepasst ist, um die Vielzahl der Ziele A, B, C und D mit elektromagnetischer Strahlung zu beleuchten, um jeweilige Spektren $S_A$, $S_B$, Sc und $S_D$ von den Zielen A, B, C und D zu erhalten; und
wobei der Prozessor angepasst ist, um einen Overlay-Fehler zwischen den ersten Strukturen (204a-c) und den zweiten Strukturen (202a-c) lediglich durch Verwendung der erhaltenen Spektren $S_A$, $S_B$, Sc und $S_D$ und der zuvor festgelegten Versatze Xa, Xb, Xc und Xd in einer Technik der linearen Approximation zu erkennen.

**57.** System nach Anspruch 56, wobei der Prozessor weiter angepasst ist, um:

ein Differenzspektrum D1 aus den Spektren $S_A$ und $S_B$ zu erkennen;
ein Differenzspektrum D2 aus den Spektren Sc und $S_D$ zu erkennen; und
einen Overlay-Fehler durch Durchführen einer Technik der linearen Approximation basierend auf den Differenzspektren D1 und D2 zu erkennen.

58. System nach Anspruch 57, wobei die Technik der linearen Approximation auf einer Eigenschaft P1 des Differenzspektrums D1 und einer Eigenschaft P2 des Differenzspektrums D2 basiert.

59. System nach einem der Ansprüche 56-58, wobei die Ziele A, B, C und D entlang einer im Wesentlichen geraden Linie angeordnet sind.

60. System nach Anspruch 59, wobei das Ziel B zwischen dem Ziel A und dem Ziel C angeordnet ist und das Ziel C zwischen dem Ziel B und dem Ziel D angeordnet ist.

61. System nach einem der Ansprüche 56-58, wobei die Ziele A, B, C und D in einer zweidimensionalen Konfiguration angeordnet sind.

62. System nach Anspruch 61, wobei die Ziele A und B entlang einer ersten Achse angeordnet sind, die Ziele C und D entlang einer zweiten Achse angeordnet sind, und die erste Achse und die zweite Achse im Wesentlichen parallel sind.

63. System nach einem der Ansprüche 56-62, wobei der Prozessor weiter angepasst ist, um:

ein zusätzliches Ziel E zu produzieren, wobei das zusätzliche Ziel E einen Teil der ersten und zweiten Strukturen (202a-c) mit einem Versatz Y dazwischen enthält;
das zusätzliche Ziel E mit elektromagnetischer Strahlung zu beleuchten, um Spektren $S_E$ zu erhalten; und
wobei das Erkennen eines Overlay-Fehlers weiter auf dem Spektrum $S_E$ basiert.

64. System nach einem der Ansprüche 56-63, wobei das Scatterometriemodul eine optische Vorrichtung ist.

65. System nach Anspruch 64, wobei die optische Vorrichtung ein Bildgebungsreflektometer ist.

66. System nach Anspruch 64, wobei die optische Vorrichtung ein spektroskopisches Bildgebungsreflektometer ist.

67. System nach Anspruch 64, wobei die optische Vorrichtung ein polarisiertes spektroskopisches Bildgebungsreflektometer ist, wobei jedes Spektrum $S_A$, $S_B$, Sc und $S_D$ in der Form einer Polarisierungskomponente an reflektiertem oder verstreutem Licht ist.

68. System nach Anspruch 64, wobei die optische Vorrichtung ein Scanreflektometersystem ist.

69. System nach Anspruch 64, wobei die optische Vorrichtung ein System mit zwei oder mehreren Reflektometern ist, die zu paralleler Datenerfassung in der Lage sind.

70. System nach Anspruch 64, wobei die optische Vorrichtung ein System mit zwei oder mehreren spektroskopischen Reflektometern ist, die zu paralleler Datenerfassung in der Lage sind.

71. System nach Anspruch 64, wobei die optische Vorrichtung ein System mit zwei oder mehreren polarisierten spektroskopischen Reflektometern ist, die zu paralleler Datenerfassung in der Lage sind.

72. System nach Anspruch 64, wobei die optische Vorrichtung ein System mit zwei oder mehreren polarisierten spektroskopischen Reflektometern ist, die zu serieller Datenerfassung in der Lage sind, ohne die Waferstufe zu bewegen oder optische Elemente oder die Reflektometerstufe zu bewegen.

73. System nach Anspruch 64, wobei die optische Vorrichtung ein Bildgebungsspektrometer ist.

74. System nach Anspruch 64, wobei die optische Vorrichtung ein Bildgebungssystem mit einem Wellenlängenfilter (520, 542) ist.

75. System nach Anspruch 74, wobei die optische Vorrichtung ein Bildgebungssystem mit einem Langpasswellenlängenfilter ist.

76. System nach Anspruch 74, wobei die optische Vorrichtung ein Bildgebungssystem mit einem Kurzpasswellenlängenfilter ist.

77. System nach Anspruch 64, wobei die optische Vorrichtung ein interferometrisches Bildgebungssystem ist.

78. System nach Anspruch 64, wobei die optische Vorrichtung ein Bildgebungsellipsometer ist.

79. System nach Anspruch 64, wobei die optische Vorrichtung ein spektroskopisches Bildgebungsellipsometer ist.

80. System nach Anspruch 64, wobei die optische Vorrichtung ein Scanellipsometersystem ist.

81. System nach Anspruch 64, wobei die optische Vorrichtung ein System mit einer Vielzahl von Ellipsometern ist, die zu paralleler Datenerfassung in der Lage ist.

82. System nach Anspruch 64, wobei die optische Vorrichtung ein System mit einer Vielzahl von Ellipsometern ist, die zu serieller Datenerfassung in der Lage ist, ohne die Waferstufe zu bewegen oder optische Elemente oder die Ellipsometerstufe zu bewegen.

83. System nach Anspruch 64, wobei die optische Vorrichtung ein Michelson-Interferometer ist.

84. System nach Anspruch 64, wobei die optische Vorrichtung ein Mach-Zehnder-Interferometer ist.

85. System nach Anspruch 64, wobei die optische Vorrichtung ein Sagnac-Interferometer ist.

86. System nach Anspruch 64, wobei die optische Vorrichtung ein System ist, das ein spektroskopisches Reflektometer mit senkrechtem Einfall und ein spektroskopisches Ellipsometer mit schrägem Einfall umfasst.

87. System nach Anspruch 64, wobei die optische Vorrichtung ein System ist, das ein spektroskopisches polarisiertes Reflektometer mit senkrechtem Einfall und ein spektroskopisches Ellipsometer mit schrägem Einfall umfasst.

88. System nach Anspruch 64, wobei die optische Vorrichtung ein System ist, das ein spektroskopisches polarisiertes Differentialreflektometer mit senkrechtem Einfall und ein spektroskopisches Ellipsometer mit schrägem Einfall umfasst.

89. System nach Anspruch 64, wobei die optische Vorrichtung ein System ist, das ein spektroskopisches polarisiertes Differentialreflektometer mit nahezu senkrechtem Einfall und ein spektroskopisches Ellipsometer mit schrägem Einfall umfasst.

90. System nach Anspruch 64, wobei die optische Vorrichtung ein System ist, das ein spektroskopisches Reflektometer mit senkrechtem Einfall und ein spektroskopisches polarisiertes Differentialellipsometer mit schrägem Einfall umfasst.

91. System nach Anspruch 64, wobei die optische Vorrichtung ein System ist, das ein spektroskopisches polarisiertes Reflektometer mit senkrechtem Einfall und ein spektroskopisches polarisiertes Differentialreflektometer mit schrägem Einfall umfasst.

92. System nach Anspruch 64, wobei die optische Vorrichtung ein System ist, das ein spektroskopisches polarisiertes Differentialreflektometer mit senkrechtem Einfall und ein spektroskopisches polarisiertes Differentialreflektometer mit schrägem Einfall umfasst.

93. System nach Anspruch 64, wobei die optische Vorrichtung ein System ist, das ein spektroskopisches polarisiertes Differentialreflektometer mit nahezu senkrechtem Einfall und ein spektroskopisches polarisiertes Differentialreflektometer mit schrägem Einfall umfasst.

94. System nach einem der Ansprüche 56-64, wobei mindestens eines der Spektren $S_A$, $S_B$, $S_C$ und $S_D$ elektromagne-

tische Strahlung umfasst, die unpolarisiert oder selektiv polarisiert oder selektiv analysiert ist.

**95.** System nach einem der Ansprüche 56-64, wobei mindestens eines der Spektren $S_A$, $S_B$, Sc und $S_D$ elektromagnetische Strahlung umfasst, die unpolarisiertes reflektiertes Licht, polarisiertes Licht, wobei das elektrische Feld im Wesentlichen parallel zu einer Symmetrieachse von mindestens einem Satz an Strukturen von mindestens einem der Ziele A, B, C oder D ist, polarisiertes Licht, wobei das elektrische Feld im Wesentlichen senkrecht zu einer Symmetrieachse von mindestens einem Satz an Strukturen von mindestens einem der Ziele A, B, C oder D ist, polarisiertes Licht, wobei das elektrische Feld in einem Winkel in Bezug auf eine Symmetrieachse von mindestens einem Satz an Strukturen von mindestens einem der Ziele A, B, C oder D ist, rechts zirkularpolarisierte Strahlung oder links zirkularpolarisierte Strahlung ist.

**96.** System nach Anspruch 58, wobei die Eigenschaften P1 und P2 der Differenzspektren D1 und D2 jeweils aus einer Gruppe ausgewählt sind, die aus Lichtrauschen, Stabilität, Abdrift, spektralen Eigenschaften und Lichtstärke besteht.

**97.** System nach einem der Ansprüche 56-96, wobei das Scatterometriemodul weiter angepasst ist, um die Ziele A, B, C und D im Wesentlichen zu unterschiedlichen Zeiten mit elektromagnetischer Strahlung zu beleuchten, sodass die entsprechenden Spektren $S_A$, $S_B$, Sc und $S_D$ zu im Wesentlichen unterschiedlichen Zeiten erhalten werden.

**98.** System nach einem der Ansprüche 56-96, wobei das Scatterometriemodul weiter angepasst ist, um die Ziele A, B, C und D im Wesentlichen simultan mit elektromagnetischer Strahlung zu beleuchten, sodass die entsprechenden Spektren $S_A$, $S_B$, Sc und $S_D$ im Wesentlichen simultan produziert werden.

**99.** System nach einem der Ansprüche 56-96, wobei das Scatterometriemodul weiter angepasst ist, um die Ziele A, B, C und D für mindestens zwei der Ziele A, B, C und D im Wesentlichen simultan mit elektromagnetischer Strahlung zu beleuchten.

**100.** System nach Anspruch 58, wobei der Prozessor weiter angepasst ist, um die Eigenschaften P1 und P2 durch den Erhalt oder die Verarbeitung von einem oder mehreren Strahlungseigenschaften der jeweiligen Differenzspektren D1 und D2 zu erkennen, ausgewählt aus einer Gruppe, die aus Intensität, spektraler Intensität der abgelenkten Strahlung, R(lambda) der unterschiedlichen Strahlung, der spektralen Intensität der transversalen elektrischen Feldpolarisierung R(Te, lambda), der spektralen Intensität der transversalen Magnetfeldpolarisierung R(Tm, lambda), der spektralen Intensität der S-Polarisierungsreflektivität Rs (lambda), der spektralen Intensität der P-Polarisierung, Reflektivität Rp(lambda), optischer Phase, Wellenlänge, Beugungswinkel, spektroskopischen Ellipsometrieparametern, alpha, beta, cos(delta) und tan(psi) besteht.

**101.** System nach Anspruch 73, wobei Beleuchtungs- und Bildgebungs-NAs des spektroskopischen Bildgebungssystems ausgewählt sind, um die Leistung des Instruments auf Streustrukturen zu optimieren, indem sichergestellt wird, dass nur die nullte Beugungsordnung erfasst wird.

**102.** System nach Anspruch 101, wobei das spektroskopische Bildgebungssystem ein spektroskopisches Bildgebungsellipsometer ist.

**103.** System nach einem der Ansprüche 56-64, wobei das Scatterometriemodul weiter angepasst ist, um eine Vielzahl von Zielen A, B, C und D mit elektromagnetischer Strahlung zu beleuchten, um jeweils Spektren $S_A$, $S_B$, Sc und $S_D$ von den Zielen A, B, C und D zu erhalten, indem (i) durch Verwendung einer Bildgebungsvorrichtung mit einem Wellenlängenfilter ein Bild von den Zielen A, B, C und D erhalten wird, und wobei die Spektren $S_A$, $S_B$, Sc und $S_D$ ein oder mehrere gemittelte oder summierte Intensitätswert(e) von einem oder mehreren Pixeln des entsprechenden Zielbildes sind, und (ii) durch Verwendung des Wellenlängenfilters eine Wellenlänge ausgewählt wird, sodass der Kontrast zwischen $S_A$, $S_B$, Sc und $S_D$ maximiert wird.

**104.** System nach Anspruch 103, wobei der Prozessor weiter angepasst ist, um die Bilder der Ziele zu analysieren, um Fehler in der Probe zu erkennen.

**105.** System nach einem der Ansprüche 56-63, wobei das Scatterometriemodul eine optische Vorrichtung ist, wobei die Strahlung an simultanen, mehreren Beleuchtungswinkeln erfasst wird.

**106.** System nach Anspruch 73, wobei der Prozessor weiter angepasst ist, um das optische Werkzeug nur zum Beleuchten eines der Ziele A, B, C und D zu fokussieren und um das optische Werkzeug nicht zum Beleuchtender anderen drei von den Zielen A, B, C und D zu refokussieren.

107. System nach einem der Ansprüche 56-106, wobei mindestens eines der Ziele A, B, C und D ein Bildgebungs-Overlay-Metrologietypziel beinhaltet, und wobei der Prozessor weiter angepasst ist, um einen zweiten Overlay-Fehler basierend auf dem Bildgebungs-Overlay-Metrologietypziel zu erkennen.

108. System nach Anspruch 107, wobei die erhaltenen Spektren $S_A$, $S_B$, Sc und $S_D$ Bilder sind und der Prozessor weiter angepasst ist, um den zweiten Overlay-Fehler durch Verwendung der erhaltenen Spektren $S_A$, $S_B$, Sc und $S_D$ zu erkennen.

109. System nach Anspruch 107, wobei der Prozessor weiter angepasst ist, um den ersten Overlay simultan mit der Erkennung des zweiten Overlay-Fehlers zu erkennen.

110. System nach Anspruch 107, wobei das Scatterometriemodul ein Beugungsscatterometer +/-1. Ordnung ist.

111. System nach Anspruch 56, weiter umfassend:

ein Bildgebungs-Overlay-Messtypziel E, aus dem ein zweiter Overlay-Fehler durch Verwendung von Bildgebungs-Overlay-Metrologie erkannt werden kann.

**Revendications**

1. Procédé pour déterminer la superposition entre une pluralité de premières structures (204a-c) dans une première couche d'un échantillon et une pluralité de secondes structures (202a-c) dans une seconde couche de l'échantillon, le procédé comprenant :

la fourniture d'une pluralité de cibles A, B, C et D qui incluent chacune une portion des premières (204a-c) et secondes (202a-c) structures,
dans lequel la portion de la seconde structure de la cible A a un décalage prédéterminé Xa par rapport à la portion de la première structure de la cible A,
dans lequel la portion de la seconde structure de la cible B a un décalage prédéterminé Xb par rapport à la portion de la première structure de la cible B,
dans lequel la portion de la seconde structure de la cible C a un décalage prédéterminé Xc par rapport à la portion de la première structure de la cible C,
dans lequel la portion de la seconde structure de la cible D a un décalage prédéterminé Xd par rapport à la portion de la première structure de la cible D,
dans lequel chacun des décalages prédéterminés Xa, Xb, Xc et Xd est différent de zéro, Xa est dans la direction opposée et diffère de Xb, et Xc est dans la direction opposée et diffère de Xd ;
l'éclairage des cibles A, B, C et D avec un rayonnement électromagnétique pour obtenir des spectres $S_A$, $S_B$, $S_C$ et $S_D$ à partir des cibles A, B, C et D, respectivement ; et
la détermination de toute erreur de superposition entre les premières structures (204a-c) et les secondes structures (202a-c) en utilisant uniquement les spectres obtenus $S_A$, $S_B$, $S_C$ et $S_D$ et les décalages prédéterminés Xa, Xb, Xc et Xd dans une technique d'approximation linéaire.

2. Procédé selon la revendication 1, dans lequel la détermination de toute erreur de superposition comprend :

la détermination d'un spectre de différence D1 à partir des spectres $S_A$ et $S_B$ ;
la détermination d'un spectre de différence D2 à partir des spectres $S_C$ et $S_D$ ;
la détermination de toute erreur de superposition en appliquant une technique d'approximation linéaire basée sur les spectres de différence D1 et D2.

3. Procédé selon la revendication 2, dans lequel la technique d'approximation linéaire est basée sur une propriété P1 du spectre de différence D1 et une propriété P2 du spectre de différence D2.

4. Procédé selon l'une quelconque des revendications 1 à 3, dans lequel chacune des cibles A, B, C et D comprend une structure de réseau Ga1 ayant des structures périodiques avec une période Ta1 disposée au moins partiellement à l'intérieur de la première couche et une structure de réseau Ga2 ayant des structures périodiques avec une période Ta2 disposée au moins partiellement à l'intérieur de la seconde couche, dans lequel la première période Ta1 et la seconde période Ta2 sont sensiblement identiques, et dans lequel (i) le décalage prédéterminé Xa décale les structures avec la période Ta1 du réseau Ga1 par rapport aux structures avec la période Ta2 de la structure de réseau Ga2 d'une somme d'une première distance positive, +F, et d'une seconde distance positive f0$_{AB}$, (ii) le décalage Xb est conçu pour décaler les structures avec la période Ta1 du réseau Ga1 par rapport aux structures avec la période Ta2 de la structure de réseau Ga2 d'une somme d'une première distance négative, +F, et d'une seconde distance positive f0$_{AB}$, (iii) le décalage Xc est conçu pour décaler les structures avec la période Ta1 du réseau Ga1 par rapport aux structures avec la période Ta2 de la structure de réseau Ga2 d'une somme de la première distance positive, +F, et d'une seconde distance négative, - f0$_{CD}$, et (iv) le décalage Xd est conçu pour décaler les structures avec la période Ta1 du réseau Ga1 par rapport aux structures avec la période Ta2 de la structure de réseau Ga2 d'une somme de la première distance négative, -F, et de la seconde distance négative, -f0$_{CD}$, dans lequel les secondes distances F0$_{AB}$ et f0$_{CD}$ présentent une valeur absolue inférieure à la première distance F, et dans lequel F0$_{AB}$ et f0$_{CD}$ sont égaux ou différents l'un de l'autre.

**5.** Procédé selon les revendications 1 à 3, dans lequel les cibles A, B, C et D sont disposées le long d'une ligne sensiblement droite.

**6.** Procédé selon la revendication 5, dans lequel la cible B est disposée entre la cible A et la cible C, et la cible C est disposée entre la cible B et la cible D.

**7.** Procédé selon l'une quelconque des revendications 1 à 3, dans lequel les cibles A, B, C et D sont disposées dans une configuration bidimensionnelle.

**8.** Procédé selon la revendication 7, dans lequel les cibles A et B sont disposées le long d'un premier axe, les cibles C et D sont disposées le long d'un second axe, et le premier axe et le second axe sont sensiblement parallèles.

**9.** Procédé selon l'une quelconque des revendications 1 à 8, le procédé comprenant en outre :

la production d'une cible supplémentaire E, la cible supplémentaire E incluant une portion des premières (204a-c) et secondes (202a-c) structures avec un décalage Y entre celles-ci ;
l'éclairage de la cible supplémentaire E avec un rayonnement électromagnétique pour obtenir des spectres SE ; et
dans lequel la détermination de toute erreur de superposition est basée en outre sur le spectre SE.

**10.** Procédé selon l'une quelconque des revendications 1 à 9, dans lequel l'obtention des spectres S$_A$, S$_B$, S$_C$ et S$_D$ comprend l'acquisition d'un rayonnement à partir des cibles A, B, C et D à l'aide d'un appareil optique.

**11.** Procédé selon la revendication 10, dans lequel l'appareil optique est un réflectomètre d'imagerie.

**12.** Procédé selon la revendication 10, dans lequel l'appareil optique est un réflectomètre spectroscopique d'imagerie.

**13.** Procédé selon la revendication 10, dans lequel l'appareil optique est un réflectomètre d'imagerie spectroscopique polarisé, dans lequel chaque spectre S$_A$, S$_B$, S$_C$ et S$_D$ est sous la forme d'une composante de polarisation de lumière réfléchie ou diffusée.

**14.** Procédé selon la revendication 10, dans lequel l'appareil optique est un système de réflectomètre à balayage.

**15.** Procédé selon la revendication 10, dans lequel l'appareil optique est un système à deux réflectomètres ou plus capables d'une acquisition de données parallèle.

**16.** Procédé selon la revendication 10, dans lequel l'appareil optique est un système à deux réflectomètres spectroscopiques ou plus capables d'une acquisition de données parallèle.

**17.** Procédé selon la revendication 10, dans lequel l'appareil optique est un système à deux réflectomètres spectroscopiques polarisés ou plus capables d'une acquisition de données parallèle.

**18.** Procédé selon la revendication 10, dans lequel l'appareil optique est un système à deux réflectomètres spectroscopiques polarisés ou plus capables d'une acquisition de données en série sans déplacer l'étage de tranche ou déplacer tous les éléments optiques ou l'étage du réflectomètre.

**19.** Procédé selon la revendication 10, dans lequel l'appareil optique est un spectromètre d'imagerie.

**20.** Procédé selon la revendication 10, dans lequel l'appareil optique est un système d'imagerie avec un filtre de longueur d'onde (520, 542).

**21.** Procédé selon la revendication 20, dans lequel l'appareil optique est un système d'imagerie avec un filtre de longueur d'onde passe-haut.

**22.** Procédé selon la revendication 20, dans lequel l'appareil optique est un système d'imagerie avec un filtre de longueur d'onde passe-bas.

**23.** Procédé selon la revendication 10, dans lequel l'appareil optique est un système d'imagerie interférométrique.

**24.** Procédé selon la revendication 10, dans lequel l'appareil optique est un ellipsomètre d'imagerie.

**25.** Procédé selon la revendication 10, dans lequel l'appareil optique est un ellipsomètre spectroscopique d'imagerie.

**26.** Procédé selon la revendication 10, dans lequel l'appareil optique est un système d'ellipsomètre à balayage.

**27.** Procédé selon la revendication 10, dans lequel l'appareil optique est un système avec une pluralité d'ellipsomètres capables d'une acquisition de données parallèle.

**28.** Procédé selon la revendication 10, dans lequel l'appareil optique est un système avec une pluralité d'ellipsomètres capables d'une acquisition de données en sériesans déplacer l'étage de tranche ou déplacer tous éléments optiques ou l'étage d'ellipsomètre.

**29.** Procédé selon la revendication 10, dans lequel l'appareil optique est un interféromètre de Michelson.

**30.** Procédé selon la revendication 10, dans lequel l'appareil optique est un interféromètre de Mach-Zehnder.

**31.** Procédé selon la revendication 10, dans lequel l'appareil optique est un interféromètre de Sagnac.

**32.** Procédé selon la revendication 10, dans lequel l'appareil optique est un système comprenant un réflectomètre spectroscopique à incidence normale et un ellipsomètre spectroscopique à incidence oblique.

**33.** Procédé selon la revendication 10, dans lequel l'appareil optique est un système comprenant un réflectomètre spectroscopique polarisé à incidence normale et un ellipsomètre spectroscopique à incidence oblique.

**34.** Procédé selon la revendication 10, dans lequel l'appareil optique est un système comprenant un réflectomètre spectroscopique différentiel polarisé à incidence normale et un ellipsomètre spectroscopique à incidence oblique.

**35.** Procédé selon la revendication 10, dans lequel l'appareil optique est un système comprenant un réflectomètre spectroscopique différentiel polarisé à incidence proche de la normale et un ellipsomètre spectroscopique à incidence oblique.

**36.** Procédé selon la revendication 10, dans lequel l'appareil optique est un système comprenant un réflectomètre spectroscopique à incidence normale et un réflectomètre spectroscopique différentiel polarisé à incidence oblique.

**37.** Procédé selon la revendication 10, dans lequel l'appareil optique est un système comprenant un réflectomètre polarisé spectroscopique à incidence normale et un réflectomètre spectroscopique différentiel polarisé à incidence oblique.

**38.** Procédé selon la revendication 10, dans lequel l'appareil optique est un système comprenant un réflectomètre spectroscopique différentiel polarisé à incidence normale et un réflectomètre spectroscopique différentiel polarisé à incidence oblique.

**39.** Procédé selon la revendication 10, dans lequel l'appareil optique est un système comprenant un réflectomètre spectroscopique différentiel polarisé à incidence proche de la normale et un réflectomètre spectroscopique différentiel polarisé à incidence oblique.

**40.** Procédé selon l'une quelconque des revendications 1 à 10, dans lequel au moins l'un des spectres $S_A$, $S_B$, $S_C$ et $S_D$ comprend un rayonnement électromagnétique qui est non polarisé ou polarisé sélectivement ou analysé sélectivement.

**41.** Procédé selon l'une quelconque des revendications 1 à 10, dans lequel au moins l'un des spectres $S_A$, $S_B$, $S_C$ et $S_D$ comprend un rayonnement électromagnétique qui est de la lumière réfléchie non polarisée, de la lumière polarisée avec le champ électrique sensiblement parallèle à un axe de symétrie d'au moins un ensemble de structures d'au moins une des cibles A, B, C ou D, de la lumière polarisée avec le champ électrique sensiblement perpendiculaire à un axe de symétrie d'au moins un ensemble de structures d'au moins une des cibles A, B, C ou D, de la lumière polarisée avec le champ électrique à un angle par rapport à un axe de symétrie d'au moins un ensemble de structures d'au moins une des cibles A, B, C ou D, un rayonnement à polarisation circulaire droite, ou un rayonnement à polarisation circulaire gauche.

**42.** Procédé selon la revendication 3, dans lequel les propriétés P1 et P2 des spectres de différence D1 et D2 sont sélectionnées chacune à partir d'un groupe comprenant le bruit lumineux, la stabilité, la dérive, les caractéristiques spectrales et l'intensité lumineuse.

**43.** Procédé selon l'une quelconque des revendications 1 à 42, dans lequel l'éclairage des cibles A, B, C et D avec un rayonnement électromagnétique a lieu sensiblement à des instants différents de sorte que les spectres correspondants $S_A$, $S_B$, $S_C$ et $S_D$ sont obtenus à des instants sensiblement différents.

**44.** Procédé selon l'une quelconque des revendications 1 à 42, dans lequel l'éclairage des cibles A, B, C et D avec un rayonnement électromagnétique a lieu sensiblement simultanément de sorte que les spectres correspondants $S_A$, $S_B$, $S_C$ et $S_D$ sont produits sensiblement simultanément.

**45.** Procédé selon l'une quelconque des revendications 1 à 42, dans lequel l'éclairage des cibles A, B, C et D avec un rayonnement électromagnétique a lieu sensiblement simultanément pour au moins deux des cibles A, B, C et D.

**46.** Procédé selon la revendication 3, dans lequel la détermination des propriétés P1 et P2 comprend l'obtention ou le traitement d'une ou de plusieurs caractéristiques de rayonnement des spectres de différence D1 et D2, respectivement, sélectionnées parmi un groupe comprenant l'intensité, l'intensité spectrale de rayonnement diffracté R(lambda) de rayonnements différents, l'intensité spectrale de polarisation transversale de champ électrique R(Te, lambda), l'intensité spectrale de polarisation transversale de champ magnétique R(Tm, lambda), l'intensité spectrale de réflectivité en polarisation S Rs (lambda), l'intensité spectrale de réflectivité en polarisation P Rp(lambda), la phase optique, la longueur d'onde, l'angle de diffraction, les paramètres d'ellipsométrie spectroscopique, alpha, bêta, cos(delta), et tg(psi).

**47.** Procédé selon la revendication 19, dans lequel un éclairage et des ouvertures numériques d'imagerie du système d'imagerie spectroscopique sont choisis pour optimiser la performance de l'instrument sur les structures de diffusion en faisant en sorte que seul l'ordre de diffraction zéro soit recueilli.

**48.** Procédé selon la revendication 47, dans lequel le système d'imagerie spectroscopique est un ellipsomètre spectroscopique d'imagerie.

**49.** Procédé selon l'une quelconque des revendications 1 à 10, dans lequel l'obtention des spectres $S_A$, $S_B$, $S_C$ et $S_D$ comprend l'acquisition d'une image à partir des cibles A, B, C et D à l'aide d'un appareil d'imagerie ayant un filtre de longueur d'onde, et dans lequel les spectres $S_A$, $S_B$, $S_C$ et $S_D$ sont une ou plusieurs valeur (s) d'intensité moyennée(s) ou additionnée(s) d'un ou de plusieurs pixel(s) de l'image cible correspondante, le procédé comprenant en outre la sélection d'une longueur d'onde à l'aide du filtre de longueur d'onde de telle sorte que le contraste entre les $S_A$, $S_B$, $S_C$ et $S_D$ est porté au maximum.

**50.** Procédé selon la revendication 49, comprenant en outre l'analyse des images des cibles afin de détecter des défauts dans l'échantillon.

**51.** Procédé selon l'une quelconque des revendications 1 à 9, dans lequel l'obtention des spectres $S_A$, $S_B$, $S_C$ et $S_D$ comprend l'acquisition d'un rayonnement à partir des cibles A, B, C et D à l'aide d'un appareil optique, dans lequel le rayonnement est acquis à des angles d'éclairage multiples simultanés.

**52.** Procédé selon la revendication 19, comprenant en outre la focalisation de l'outil optique uniquement pour éclairer une parmi les cibles A, B, C et D et la non refocalisation de l'outil optique pour éclairer les trois autres parmi les cibles A, B, C et D.

**53.** Procédé selon l'une quelconque des revendications 1 à 52, dans lequel au moins une des cibles A, B, C et D comprend une cible de type métrologie de superposition par imagerie, et le procédé comprend en outre la mesure d'une seconde erreur de superposition sur la cible de type métrologie de superposition par imagerie.

**54.** Procédé selon la revendication 53, dans lequel les spectres obtenus $S_A$, $S_B$, $S_C$ et $S_D$ sont des images et sont également utilisés pour réaliser la mesure de l'erreur de superposition de la cible de type métrologie de superposition par imagerie.

**55.** Procédé selon la revendication 53, dans lequel la première superposition est déterminée simultanément à la mesure de la seconde erreur de superposition.

**56.** Système pour déterminer la superposition entre une pluralité de premières structures (204a-c) dans une première couche d'un échantillon et une pluralité de secondes structures (202a-c) dans une seconde couche de l'échantillon, comprenant :

    un module de diffusiométrie ;
    un processeur ; et
    un arrangement de cibles comprenant :

        une pluralité de cibles A, B, C et D qui comprennent chacune une portion des premières et secondes structures (202a-c) ;
        dans lequel la portion de la seconde structure de la cible A a un décalage prédéterminé Xa par rapport à la portion de la première structure de la cible A ;
        dans lequel la portion de la seconde structure de la cible B a un décalage prédéterminé Xb par rapport à la portion de la première structure de la cible B ;
        dans lequel la portion de la seconde structure de la cible C a un décalage prédéterminé Xc par rapport à la portion de la première structure de la cible C ;
        dans lequel la portion de la seconde structure de la cible D a un décalage prédéterminé Xd par rapport à la portion de la première structure de la cible D ;
        dans lequel chacun des décalages Xa, Xb, Xc et Xd est différent de zéro, Xa est dans la direction opposée et diffère de Xb, et Xc est dans la direction opposée et diffère de Xd ;
        dans lequel le module de diffusiométrie est adapté pour éclairer la pluralité de cibles A, B, C et D avec un rayonnement électromagnétique pour obtenir des spectres $S_A$, $S_B$, $S_C$ et $S_D$ à partir des cibles A, B, C et D, respectivement ; et
        dans lequel le processeur est adapté pour déterminer toute erreur de superposition entre les premières structures (204a-c) et les secondes structures (202a-c) en utilisant uniquement les spectres obtenus $S_A$, $S_B$, $S_C$ et $S_D$ et les décalages prédéterminés Xa, Xb, Xc et Xd dans une technique d'approximation linéaire.

**57.** Système selon la revendication 56, dans lequel le processeur est adapté en outre pour :

    déterminer un spectre de différence D1 à partir des spectres $S_A$ et $S_B$ ;
    déterminer un spectre de différence D2 à partir des spectres $S_C$ et $S_D$ ; et
    déterminer toute erreur de superposition en appliquant une technique d'approximation linéaire basée sur les spectres de différence D1 et D2.

**58.** Système selon la revendication 57, dans lequel la technique d'approximation linéaire est basée sur une propriété P1 du spectre de différence D1 et une propriété P2 du spectre de différence D2.

**59.** Système selon l'une quelconque des revendications 56 à 58, dans lequel les cibles A, B, C et D sont disposées le long d'une ligne sensiblement droite.

**60.** Système selon la revendication 59, dans lequel la cible B est disposée entre la cible A et la cible C, et la cible C est disposée entre la cible B et la cible D.

**61.** Système selon l'une quelconque des revendications 56 à 58, dans lequel les cibles A, B, C et D sont disposées dans une configuration bidimensionnelle.

**62.** Système selon la revendication 61, dans lequel les cibles A et B sont disposées le long d'un premier axe, les cibles C et D sont disposées le long d'un second axe, et le premier axe et le second axe sont sensiblement parallèles.

**63.** Système selon l'une quelconque des revendications 56 à 62, dans lequel le processeur est adapté en outre pour :

produire une cible supplémentaire E, la cible supplémentaire E incluant une portion des premières et secondes structures (202a-c) avec un décalage Y entre celles-ci ;
éclairer la cible supplémentaire E avec un rayonnement électromagnétique pour obtenir des spectres $S_E$ ; et
dans lequel la détermination de toute erreur de superposition est basée en outre sur le spectre $S_E$.

**64.** Système selon l'une quelconque des revendications 56 à 63, dans lequel le module de diffusiométrie est un appareil optique.

**65.** Système selon la revendication 64, dans lequel l'appareil optique est un réflectomètre d'imagerie.

**66.** Système selon la revendication 64, dans lequel l'appareil optique est un réflectomètre spectroscopique d'imagerie.

**67.** Système selon la revendication 64, dans lequel l'appareil optique est un réflectomètre d'imagerie spectroscopique polarisé, dans lequel chaque spectre $S_A$, $S_B$, $S_C$ et $S_D$ est sous la forme d'une composante de polarisation de lumière réfléchie ou diffusée.

**68.** Système selon la revendication 64, dans lequel l'appareil optique est un système de réflectomètre à balayage.

**69.** Procédé selon la revendication 64, dans lequel l'appareil optique est un système à deux réflectomètres ou plus capables d'une acquisition de données parallèle.

**70.** Système selon la revendication 64, dans lequel l'appareil optique est un système à deux réflectomètres spectroscopiques ou plus capables d'une acquisition de données parallèle.

**71.** Système selon la revendication 64, dans lequel l'appareil optique est un système à deux réflectomètres spectroscopiques polarisés ou plus capables d'une acquisition de données parallèle.

**72.** Système selon la revendication 64, dans lequel l'appareil optique est un système à deux réflectomètres spectroscopiques polarisés ou plus capables d'une acquisition de données en série sans déplacer l'étage de tranche ou déplacer tous les éléments optiques ou l'étage du réflectomètre.

**73.** Système selon la revendication 64, dans lequel l'appareil optique est un spectromètre d'imagerie.

**74.** Système selon la revendication 64, dans lequel l'appareil optique est un système d'imagerie avec un filtre de longueur d'onde (520, 542).

**75.** Système selon la revendication 74, dans lequel l'appareil optique est un système d'imagerie avec un filtre de longueur d'onde passe-haut.

**76.** Système selon la revendication 74, dans lequel l'appareil optique est un système d'imagerie avec un filtre de longueur d'onde passe-bas.

**77.** Système selon la revendication 64, dans lequel l'appareil optique est un système d'imagerie interférométrique.

**78.** Système selon la revendication 64, dans lequel l'appareil optique est un ellipsomètre d'imagerie.

**79.** Système selon la revendication 64, dans lequel l'appareil optique est un ellipsomètre d'imagerie spectroscopique.

80. Système selon la revendication 64, dans lequel l'appareil optique est un système d'ellipsomètre à balayage.

81. Système selon la revendication 64, dans lequel l'appareil optique est un système avec une pluralité d'ellipsomètres capables d'une acquisition de données parallèle.

82. Système selon la revendication 64, dans lequel l'appareil optique est un système avec une pluralité d'ellipsomètres capables d'une acquisition de données en série sans déplacer l'étage de tranche ou déplacer tousles éléments optiques ou l'étage d'ellipsomètre.

83. Système selon la revendication 64, dans lequel l'appareil optique est un interféromètre de Michelson.

84. Système selon la revendication 64, dans lequel l'appareil optique est un interféromètre de Mach-Zehnder.

85. Système selon la revendication 64, dans lequel l'appareil optique est un interféromètre de Sagnac.

86. Système selon la revendication 64, dans lequel l'appareil optique est un système comprenant un réflectomètre spectroscopique à incidence normale et un ellipsomètre spectroscopique à incidence oblique.

87. Système selon la revendication 64, dans lequel l'appareil optique est un système comprenant un réflectomètre spectroscopique polarisé à incidence normale et un ellipsomètre spectroscopique à incidence oblique.

88. Système selon la revendication 64, dans lequel l'appareil optique est un système comprenant un réflectomètre spectroscopique différentiel polarisé à incidence normale et un ellipsomètre spectroscopique à incidence oblique.

89. Système selon la revendication 64, dans lequel l'appareil optique est un système comprenant un réflectomètre spectroscopique différentiel polarisé à incidence proche de la normale et un ellipsomètre spectroscopique à incidence oblique.

90. Système selon la revendication 64, dans lequel l'appareil optique est un système comprenant un réflectomètre spectroscopique à incidence normale et un réflectomètre spectroscopique différentiel polarisé à incidence oblique.

91. Système selon la revendication 64, dans lequel l'appareil optique est un système comprenant un réflectomètre spectroscopique polarisé à incidence normale et un réflectomètre spectroscopique différentiel polarisé à incidence oblique.

92. Système selon la revendication 64, dans lequel l'appareil optique est un système comprenant un réflectomètre spectroscopique différentiel polarisé à incidence normale et un réflectomètre spectroscopique différentiel polarisé à incidence oblique.

93. Système selon la revendication 64, dans lequel l'appareil optique est un système comprenant un réflectomètre spectroscopique différentiel polarisé à incidence proche de la normale et un réflectomètre spectroscopique différentiel polarisé à incidence oblique.

94. Système selon l'une quelconque des revendications 56 à 64, dans lequel au moins l'un des spectres $S_A$, $S_B$, $S_C$ et $S_D$ comprend un rayonnement électromagnétique qui est non polarisé ou polarisé sélectivement ou analysé sélectivement.

95. Système selon l'une quelconque des revendications 56 à 64, dans lequel au moins l'un des spectres $S_A$, $S_B$, $S_C$ et $S_D$ comprend un rayonnement électromagnétique qui est de la lumière réfléchie non polarisée, de la lumière polarisée avec le champ électrique sensiblement parallèle à un axe de symétrie d'au moins un ensemble de structures d'au moins une des cibles A, B, C ou D, de la lumière polarisée avec le champ électrique sensiblement perpendiculaire à un axe de symétrie d'au moins un ensemble de structures d'au moins une des cibles A, B, C ou D, de la lumière polarisée avec le champ électrique à un certain angle par rapport à un axe de symétrie d'au moins un ensemble de structures d'au moins une des cibles A, B, C ou D, un rayonnement à polarisation circulaire droite, ou un rayonnement à polarisation circulaire gauche.

96. Système selon la revendication 58, dans lequel les propriétés P1 et P2 des spectres de différence D1 et D2 sont sélectionnées chacune à partir d'un groupe comprenant le bruit lumineux, la stabilité, la dérive, les caractéristiques spectrales et l'intensité lumineuse.

**97.** Système selon l'une quelconque des revendications 56 à 96, dans lequel le module de diffusiométrie est adapté en outre pour éclairer les cibles A, B, C et D avec un rayonnement électromagnétique sensiblement à des instants différents de sorte que les spectres correspondants $S_A$, $S_B$, $S_C$ et $S_D$ sont obtenus à des instants sensiblement différents.

**98.** Système selon l'une quelconque des revendications 56 à 96, dans lequel le module de diffusiométrie est adapté en outre pour éclairer les cibles A, B, C et D avec un rayonnement électromagnétique sensiblement simultanément de sorte que les spectres correspondants $S_A$, $S_B$, $S_C$ et $S_D$ sont produits sensiblement simultanément.

**99.** Système selon l'une quelconque des revendications 56 à 96 dans lequel le module de diffusiométrie est adapté en outre pour éclairer les cibles A, B, C et D avec un rayonnement électromagnétique sensiblement simultanément pour au moins deux des cibles A, B, C et D.

**100.** Système selon la revendication 58, dans lequel le processeur est adapté en outre pour déterminer les propriétés P1 et P2 par l'obtention ou le traitement d'une ou de plusieurs caractéristiques de rayonnement des spectres de différence D1 et D2, respectivement, sélectionnées parmi un groupe comprenant l'intensité, l'intensité spectrale de rayonnement diffracté R(lambda) de rayonnements différents, l'intensité spectrale de polarisation transversale de champ électrique R(Te, lambda), l'intensité spectrale de polarisation transversale de champ magnétique R(Tm, lambda), l'intensité spectrale de réflectivité en polarisation S Rs (lambda), l'intensité spectrale de réflectivité en polarisation P Rp(lambda), la phase optique, la longueur d'onde, l'angle de diffraction, les paramètres d'ellipsométrie spectroscopique, alpha, bêta, cos(delta), et tg(psi).

**101.** Système selon la revendication 73, dans lequel un éclairage et des ouvertures numériques d'imagerie NA du système d'imagerie spectroscopique sont choisis pour optimiser la performance de l'instrument sur les structures de diffusion en faisant en sorte que seul l'ordre de diffraction zéro soit recueilli.

**102.** Système selon la revendication 101, dans lequel le système d'imagerie spectroscopique est un ellipsomètre spectroscopique d'imagerie.

**103.** Système selon l'une quelconque des revendications 56 à 64, dans lequel le module de diffusiométrie est adapté en outre pour éclairer une pluralité de cibles A, B, C et D avec un rayonnement électromagnétique pour obtenir des spectres $S_A$, $S_B$, $S_C$ et $S_D$ à partir des cibles A, B, C et D, respectivement, par (i) l'acquisition d'une image à partir des cibles A, B, C et D à l'aide d'un appareil d'imagerie ayant un filtre de longueur d'onde, et dans lequel les spectres $S_A$, $S_B$, $S_C$ et $S_D$ sont une ou plusieurs valeur(s) d'intensité moyennée(s) ou additionnée(s) d'un ou de plusieurs pixel(s) de l'image cible correspondante ; et (ii) la sélection d'une longueur d'onde à l'aide du filtre de longueur d'onde de telle sorte que le contraste entre les $S_A$, $S_B$, $S_C$ et $S_D$ est porté au maximum.

**104.** Système selon la revendication 103, dans lequel le processeur est adapté en outre pour analyser les images des cibles pour détecter des défauts dans l'échantillon.

**105.** Système selon l'une quelconque des revendications 56 à 63, dans lequel le module de diffusiométrie est un appareil optique, dans lequel le rayonnement est acquis à des angles d'éclairage multiples simultanés.

**106.** Système selon la revendication 73, dans lequel le processeur est adapté en outre pour focaliser l'outil optique uniquement pour éclairer une parmi les cibles A, B, C et D et ne pas refocaliser l'outil optique pour éclairer les trois autres parmi les cibles A, B, C et D.

**107.** Système selon l'une quelconque des revendications 56 à 106, dans lequel au moins une des cibles A, B, C et D comprend une cible de type métrologie de superposition par imagerie, et le processeur est adapté en outre pour déterminer une seconde erreur de superposition basée sur la cible de type métrologie de superposition par imagerie.

**108.** Système selon la revendication 107, dans lequel les spectres obtenus $S_A$, $S_B$, $S_C$ et $S_D$ sont des images et le processeur est adapté en outre pour déterminer la seconde erreur de superposition à l'aide de spectres obtenus $S_A$, $S_B$, $S_C$ et $S_D$.

**109.** Système selon la revendication 107, dans lequel le processeur est adapté en outre pour déterminer la première superposition simultanément à la détermination de la seconde erreur de superposition.

110. Système selon la revendication 107, dans lequel le module de diffusiométrie est un diffusiomètre de diffraction de +/-1er ordre.

111. Système selon la revendication 56, comprenant en outre :

une cible de type mesure de superposition par imagerie E à partir de laquelle une seconde erreur de superposition peut être déterminée à l'aide de la métrologie de superposition par imagerie.

Fig. 1

With Offsets F and no Overlay Error

Fig. 2(a)

Fig. 2(b)

With Offsets F+ *f0* and no Overlay Error

Fig. 2(c)

Fig. 2(d)

With Offsets F+ *f0* and Overlay Error E

Fig. 2(e)

Fig. 2(f)

EP 1 570 232 B1

300

CALCULATE OVERLAY ERROR E BASED ON FUNCTION
308

$E = f_0(P1+P2)/(P1-P2)$

P1

OBTAIN PROPERTY P1 OF THE DIFFERENCE SPECTRA D1
306a

P2

OBTAIN PROPERTY P2 OF THE DIFFERENCE SPECTRA D2
306b

D1

SUBTRACT SPECTRA $(S_A - S_B)$
304a

D2

SUBTRACT SPECTRA $(S_C - S_D)$
304b

$S_A$

$S_B$

$S_C$

$S_D$

302d

MEASURE TARGET A +F+f0
302a

MEASURE TARGET B -F+f0
302b

MEASURE TARGET C +F-f0
302c

MEASURE TARGET D -F-f0

Fig. 3(a)

1) +F+$f_0$ & -F+ $f_0$.
   Difference in
   spectra gives D1
   or property P1

2) +F- $f_0$ & -F- $f_0$.
   Difference in
   spectra gives D1
   or property P1

For 0 OVL $D_1$= -$D_2$

For OVL=E:

P

Example "Real" function

Change in P $_1$ due
to E OVL

$P_1$

Linear
approximation

- $f_0$ - $f_0$+E

0

$f_0$   $f_0$+E

OVL

E OVL

$P_2$

Change in P $_2$ due
to E OVL

$$\frac{P_1}{+f_0 + E} = \frac{P_2}{-f_0 + E} \Rightarrow E = f_0 \frac{P_1 + P_2}{P_1 - P_2}$$

Fig. 3(b)

Camera

412

410

402

403

409

404

405

Processor/
Memory

406

414

408

Fig. 4

400

EP 1 570 232 B1

Fig. 5(a)

EP 1 570 232 B1

FIG. 5(b)

EP 1 570 232 B1

Fig. 5(c)

EP 1 570 232 B1

Fig. 5(d)

FIG. 5(e)

FIG. 6

EP 1 570 232 B1

FIG. 7

EP 1 570 232 B1

FIG._ 8

EP 1 570 232 B1

Fig. 9(a)

Fig. 9(b)

EP 1 570 232 B1

Incidence Line

Field of View:

Y-Axis (Wavelenghts dispersed for each point on the incidence line)

Y-Axis (Wavelenghts dispersed for each point on the incidence line)

FIG. 10

Fig. 11a

Fig. 11b

Fig. 11c

Fig. 12

Fig. 13(a)

Fig. 13(b)

Fig. 13(c)

Fig. 13(d)

1400

1402

RECEIVE WAFERS

1404

MEASURE CRITICAL DIMENSION OF WAFER

1406

MEASURE OVERLAY OF WAFER

1408

RELEASE WAFER

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0225723 A2
- US 09833084 B
- US 09849622 B
- WO 60498524 A
- US 5166752 A, Spanier
- US 6590 A
- US 656 A
- US 4999 A
- US 014 A
- US 5835214 A
- US 5856871 A
- US 6142629 A
- US 44949603 P
- US 6462818 B
- US 6023338 A
- US 09894987 B
- US 6486954 B
- US 6590656 B, Xu
- US 6633831 B

**Non-patent literature cited in the description**

- *IBM Technical Disclosure Bulletin,* March 1990, vol. 32 (10), 170-174